(19) Europäisches Patentamt
European Patent Office
Office européen des brevets

(11) EP 3 971 757 A1

(12) EUROPEAN PATENT APPLICATION

(43) Date of publication:
**23.03.2022 Bulletin 2022/12**

(21) Application number: **21197503.2**

(22) Date of filing: **17.09.2021**

(51) International Patent Classification (IPC):
***G06F 30/13*** *(2020.01)* ***G06F 30/27*** *(2020.01)*
***G06Q 30/02*** *(2012.01)* ***G06Q 50/16*** *(2012.01)*

(52) Cooperative Patent Classification (CPC):
**G06F 30/13; G06F 30/27; G06Q 30/0201; G06Q 50/16**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **22.09.2020 US 202063081744 P**

(71) Applicant: **Zillow, Inc.**
**Seattle, WA 98101 (US)**

(72) Inventors:
- **YIN, YU**
**Jamaica Plain, 02130 (US)**
- **Li, Yujie**
**Kirkland, 98033 (US)**
- **Hutchcroft, Will**
**Seattle, 98122 (US)**
- **Kang, Sing**
**Redmond, 98052 (US)**
- **Moulon, Pierre**
**Seattle, 98116 (US)**
- **Boyadzhiev, Ivaylo**
**Seattle, 98117 (US)**

(74) Representative: **Loveless, Ian Mark**
**Reddie & Grose LLP**
**The White Chapel Building**
**10 Whitechapel High Street**
**London E1 8QS (GB)**

# (54) AUTOMATED IDENTIFICATION AND USE OF BUILDING FLOOR PLAN INFORMATION

(57) Techniques are described for using computing devices to perform automated operations for identifying building floor plans that have attributes satisfying target criteria and for subsequently using the identified floor plans in further automated manners. In at least some situations, the identification of such building floor plans is based on generating and using adjacency graphs generated for the floor plans that represent inter-connections between rooms and other attributes of the buildings, and in some cases is further based on generating and using embedding vectors that concisely represent the information of the adjacency graphs. Information about such identified building floor plans may be used in various automated manners, including for controlling navigation of devices (e.g., autonomous vehicles), for display on client devices in corresponding graphical user interfaces, for further analysis to identify shared and/or aggregate characteristics, etc.

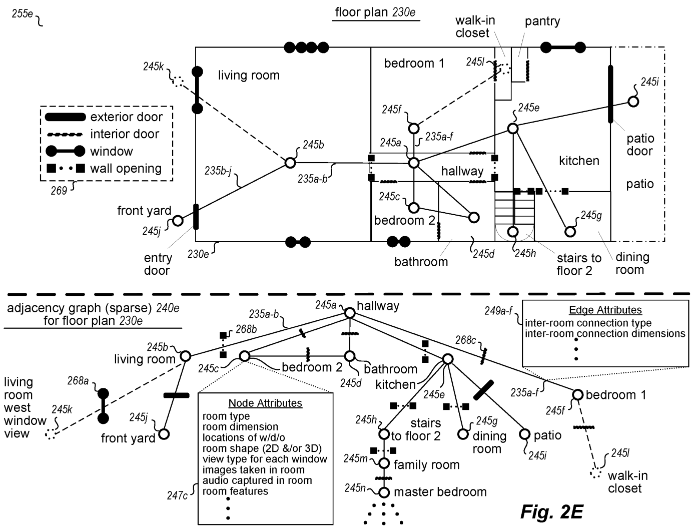

Fig. 2E

Printed by Jouve, 75001 PARIS (FR)

EP 3 971 757 A1

## Description

TECHNICAL FIELD

The following disclosure relates generally to techniques for automatically determining attributes of buildings and their floor plans and for automatically identifying building floor plans that have attributes satisfying target criteria and for subsequently using the identified floor plans in one or more automated manners, such as to automatically determine one or more buildings with floor plans having similarities to those of one or more other indicated buildings based at least in part on attributes of rooms of the buildings, and/or to automatically determine one or more buildings with floor plans having attributes based at least in part on adjacency criteria for inter-connected rooms or based at least in part on other specified attributes related to room interiors and views.

BACKGROUND

In various fields and circumstances, such as architectural analysis, property inspection, real estate acquisition and development, general contracting, improvement cost estimation, etc., it may be desirable to know the interior of a house, office, or other building without having to physically travel to and enter the building. However, it can be difficult to effectively capture, represent and use such building interior information, including to identify buildings that satisfy criteria of interest, and including to display visual information captured within building interiors to users at remote locations (e.g., to enable a user to fully understand the layout and other details of the interior, including to control the display in a user-selected manner). In addition, while a floor plan of a building may provide some information about layout and other details of a building interior, such use of floor plans has some drawbacks, including that floor plans can be difficult to construct and maintain, to accurately scale and populate with information about room interiors, to visualize and otherwise use, etc.

BRIEF DESCRIPTION OF THE DRAWINGS

Figures 1A-1B are diagrams depicting an exemplary building interior environment and computing system(s) for use in embodiments of the present disclosure, including to generate and present information representing an interior of the building, and/or to determine and further use information about attribute-based assessments of buildings' floor plans.

Figures 2A-2K illustrate examples of automatically identifying building floor plans that have attributes satisfying target criteria and subsequently using the identified floor plans in one or more automated manners.

Figure 3 is a block diagram illustrating a computing system suitable for executing an embodiment of a system that performs at least some of the techniques described in the present disclosure.

Figure 4 illustrates an example embodiment of a flow diagram for an Image Capture and Analysis (ICA) system routine in accordance with an embodiment of the present disclosure.

Figures 5A-5B illustrate an example embodiment of a flow diagram for a Mapping Information Generation Manager (MIGM) system routine in accordance with an embodiment of the present disclosure.

Figures 6A-6B illustrate an example embodiment of a flow diagram for a Floor Plan Similarity Determination Manager (FPSDM) system routine in accordance with an embodiment of the present disclosure.

Figure 7 illustrates an example embodiment of a flow diagram for a Building Map Viewer system routine in accordance with an embodiment of the present disclosure.

DETAILED DESCRIPTION

The present disclosure describes techniques for using computing devices to perform automated operations related to identifying building floor plans that have attributes satisfying target criteria and to subsequently using the identified floor plans in one or more further automated manners, and/or related to determining attributes of buildings and their floor plans from acquired information about those buildings. In at least some embodiments, such identification of building floor plans is based at least in part on generating and using adjacency graphs generated for and associated with the floor plans, to represent inter-connections between rooms of the buildings and other attributes of the buildings, and in some cases is further based on generating and using embedding vectors that concisely represent the information of the adjacency graphs - such a floor plan may, in at least some embodiments, be for an as-built multi-room building (e.g., a house, office building, etc.) that is generated from or otherwise associated with panorama images or other images (e.g., rectilinear perspective images) acquired at one or more acquisition locations in an interior of the building (e.g.,

without having or using information from any depth sensors or other distance-measuring devices about distances from an image's acquisition location to walls or other objects in the surrounding building). In addition, in at least some embodiments, such determining of attributes of buildings and their floor plans may include generating at least a partial initial adjacency graph for a particular building's floor plan, and using that initial adjacency graph (and/or a corresponding embedding vector) to predict additional information regarding rooms of the building, such as to provide the initial adjacency graph (or a corresponding embedding vector) as input to one or more trained machine learning models (*e.g.*, one or more trained neural networks) to predict types of the rooms from various information acquired about the building and/or to predict types of inter-room connections in the building from various information acquired about the building, and with such predicted information used to update the initial adjacency graph and/or the corresponding embedding vector and/or an underlying floor plan. Information in a building floor plan may be used in various manners (*e.g.*, to identify the floor map as matching one or more specified criteria), and information about a building floor plan that is identified as having attributes satisfying target criteria may be further used in various manners in various embodiments, such as for controlling navigation of mobile devices (*e.g.*, autonomous vehicles), for display or other presentation on one or more client devices in corresponding GUIs (graphical user interfaces), etc. Additional details are included below regarding the automated identification and use of building floor plans that have attributes satisfying target criteria, and some or all of the techniques described herein may, in at least some embodiments, be performed via automated operations of a Floor Plan Similarity Determination Manager ("FPSDM") system, as discussed further below.

As noted above, automated operations of an FPSDM system may include generating and later using an adjacency graph for a floor plan in at least some embodiments, while otherwise generating adjacency information in other formats for the floor plan in other embodiments. Such a floor plan of a building may include a 2D (two-dimensional) representation of various information about the building (e.g., the rooms, doorways between rooms and other inter-room connections, exterior doorways, windows, etc.), and may be further associated with various types of supplemental or otherwise additional information (e.g., data for a plurality of attributes) about the building (including in some situations a 3D, or three-dimensional, model of the building and/or a 2.5D, or two-and-a-half dimensional, model of the building; images captured in rooms of the building, including panoramic images, etc.), as discussed in greater detail below. Such an adjacency graph may store or otherwise include some or all such attribute data for the building, such as with at least some such attribute data stored in or otherwise associated with nodes of the adjacency graph that represent some or all rooms of the floor plan (e.g., with each node containing information about attributes of the room represented by the node), and/or with at least some such attribute data stored in or otherwise associated with edges between nodes that represent connections between adjacent rooms via doors or other inter-room openings, or in some situations further represent adjacent rooms that share at least a portion of at least one wall and optionally a full wall without any direct inter-room opening between those two rooms (e.g., with each edge containing information about connectivity status between the rooms represented by the nodes that the edge inter-connects, such as whether an inter-room opening exists between the two rooms, and/or a type of inter-room opening or other type of adjacency between the two rooms such as without any direct inter-room wall opening). In other embodiments and situations, groups of two or more adjacent rooms may be represented, including in some embodiments and situations to have groups of three or more adjacent rooms rather than pairs of two adjacent rooms. In some embodiments and situations, the adjacency graph may further represent at least some information external to the building, such as exterior areas adjacent to doors or other openings between the building and the exterior and/or other structures on the same property as the building (e.g., a garage, shed, pool house, separate guest quarters, mother-in-law unit, pool, patio, deck, sidewalk, garden, yard, etc.) - such exterior areas and/or other structures may be represented in various manners in the adjacency graph, such as via separate nodes for each such exterior area or other structure, or instead as attribute information associated with corresponding nodes or edges or instead with the adjacency graph as a whole (for the building as a whole). The adjacency graph may further have associated attribute information for the corresponding rooms and inter-room connections in at least some embodiments, such as to represent within the adjacency graph some or all of the information available on a floor plan and otherwise associated with the floor plan (or in some embodiments and situations, information in and associated with a 3D model of the building) - for example, if there are images associated with the floor plan, corresponding visual attributes may be included within the adjacency graph. In embodiments with adjacency information in a form other than an adjacency graph, some or all of the above-indicated types of information may be stored in or otherwise associated with the adjacency information, including information about rooms, about adjacencies between rooms, about connectivity status between adjacent rooms, about attributes of the building, etc. Additional details are included below regarding the generation and use of adjacency graphs, including with respect to the examples of Figures 2D-2K and their associated description.

As is also noted above, automated operations of an FPSDM system may further include generating and later using an embedding vector to concisely represent an adjacency graph for a floor plan of a building in at least some embodiments, such as to summarize the semantic meaning and spatial relationships of the floor plan in a manner that enables reconstruction of the floor plan from the embedding vector. Such an embedding vector may be generated in various manners in various embodiments, such as via the use of representation learning, and in at least some such embodiments may be encoded in a format that is not easily discernible to a human reader. Non-exclusive examples of techniques for generating such embedding vectors are included in the following documents, which are incorporated herein by reference in their entirety: "Symmetric Graph Convolution Autoencoder For Unsupervised Graph Representation Learning" by Jiwoong Park et al., 2019 International Conference On Computer Vision, August 7, 2019; "Inductive Representation Learning On Large Graphs" by William L Hamilton et al., 31st Conference On Neural Information Processing Systems 2017, June 7, 2017; and "Variational Graph Auto-Encoders" by Thomas N. Kipf et al., 30th Conference On Neural Information Processing Systems 2017 (Bayesian Deep Learning Workshop), November 21, 2016. Additional details are included below regarding the generation and use of embedding vectors, including with respect to the examples of Figures 2D-2K and their associated description.

In addition, as noted above, a floor plan may have various information that is associated with individual rooms and/or with inter-room connections and/or with a corresponding building as a whole, and the corresponding adjacency graph and/or embedding vector for such a floor plan may include some or all such associated information (*e.g.*, represented as attributes of nodes for rooms in an adjacency graph and/or attributes of edges for inter-room connections in an adjacency graph and/or represented as attributes of the adjacency graph as a whole, and with corresponding information encoded in the associated embedding vector). Such associated information may include a variety of types of information, including information about one or more of the following non-exclusive examples: room types, room dimensions, locations of windows and doors and other inter-room openings in a room, room shape, a view type for each exterior window, information about and/or copies of images taken in a room, information about and/or copies of audio or other data captured in a room, information of various types about features of one or more rooms (*e.g.*, as automatically identified from analysis of images, as supplied by operator users of the FPSDM system and/or by end-users viewing information about the floor plan and/or by operator users of ICA and/or MIGM systems as part of capturing information about a building and generating a floor plan for the building, etc.), types of inter-room connections, dimensions of inter-room connections, etc. Furthermore, in at least some embodiments, one or more additional subjective attributes may be determined for and associated with the floor plan, such as via analysis of the floor plan information (*e.g.*, an adjacency graph for the floor plan) by one or more trained classification neural networks (*e.g.*, to identify floor plan characteristics such as an open floor plan; a typical/normal versus atypical/odd/unusual floor plan; a standard versus nonstandard floor plan; a floor plan that is accessibility friendly, such as by being accessible with respect to one or more characteristics such as disability and/or advanced age; etc.) - in at least some such embodiments, the one or more classification neural networks are part of the FPSDM system and are trained via supervised learning using labeled data that identifies floor plans having each of the possible characteristics, while in other embodiments such classification neural networks may instead use unsupervised clustering. Additional details are included below regarding determination and use of attribute information for floor plans, including with respect to the examples of Figures 2D-2K and their associated description.

After an adjacency graph (or other adjacency information) and optionally an embedding vector is generated for a floor plan of a building, that generated information may be used by the FPSDM system as specified criteria to automatically determine one or more other similar floor plans of other buildings in various manners in various embodiments.

For example, in some embodiments, an initial floor plan is identified, and the corresponding embedding vector for the initial floor plan is generated and compared to generated embedding vectors for other candidate floor plans in order to determine a difference between the initial floor plan's embedding vector and the embedding vectors of some or all of the candidate floor plans, with smaller differences corresponding to higher degrees of similarity. Differences between two such embedding vectors may be determined in various manners in various embodiments, including, as non-exclusive examples, by using one or more of the following distance metrics: Euclidean distance, cosine distance, graph edit distance, a custom distance measure specified by a user, etc.; and/or otherwise determining similarity without use of such a distance metrics. In at least some embodiments, multiple such initial floor plans may be identified and used in the described manner to determine a combined distance between a group of embedding vectors for the multiple initial floor plans and the embedding vectors for each of multiple other candidate floor plans, such as by determining individual distances for each of the initial floor plans to a given other candidate floor plan and by combining the multiple individual determined distances in one or more manners (e.g., a mean or other average, a cumulative total, etc.) to generate the combined distance for the group of embedding vectors of the multiple initial floor plans to that given other candidate floor plan. Additional details are included below regarding comparing embedding vectors for floor plans to determine similarities of the floor plans, including with respect to the examples of Figures 2D-2K and their associated description.

In addition, in some embodiments, an initial floor plan is identified, and corresponding adjacency information (optionally in the form of an adjacency graph, but alternatively able to be stored in a database or other data structure or other format) for the initial floor plan is generated and compared to generated and/or provided adjacency information (*e.g.*, in the form of an adjacency graph, or otherwise in the same format as the adjacency information for the initial floor plan) for multiple other candidate floor plans in order to determine differences (*e.g.*, using distance measures or other measures of similarities) between the initial floor plan's adjacency information and the adjacency information of some or all of the candidate floor plans. Such a determination of the similarity between two such groups of adjacency information may be performed, as non-exclusive examples, in at least some such embodiments by supplying two adjacency graphs to a trained similarity neural network and receiving an indication of a degree of similarity as an output (*e.g.*, a binary yes or no, a value from a range or enumerated list of similarity degrees, etc.), by directly comparing two adjacency graphs (*e.g.*, using graph edit distance and/or isomorphism, belief propagation, the eigenvalue method and/or other feature extraction, iterative methods, subgraph matching using indexing, approximate constrained subgraph matching, mining coherent dense subgraphs, tensor analysis, graph scope, subgraph matching via convex relaxation, etc.), by directly comparing two groups of adjacency information in a format other than adjacency graphs, etc. - in at least some such embodiments, the one or more such similarity neural networks are part of the FPSDM system and are trained using unlabeled or labeled data to identify similar floor plans, such as via supervised learning using labeled data or instead via unsupervised clustering using unlabeled data. In at least some embodiments, multiple such initial floor plans may be identified and used in the described manner to determine a combined degree of similarity between two or more groups of adjacency information for the multiple initial floor plans and additional groups of adjacency information for each of multiple other candidate floor plans, such as by determining individual similarity degrees for each of the initial floor plans to a given other candidate floor plan and by combining the multiple individual determined similarity degrees in one or more manners (*e.g.*, a mean or other average, a cumulative total, etc.) to generate the combined similarity degree for the group of adjacency graphs of the multiple initial floor plans to that given other candidate floor plan. Additional details are included below regarding comparing adjacency graphs or other adjacency information generated for floor plans to determine similarities of the floor plans and/or of the associated buildings more generally, including with respect to the examples of Figures 2D-2K and their associated description.

Furthermore, in some embodiments, one or more explicitly specified criteria other than one or more initial floor plans are received (whether in addition to or instead of receiving one or more initial floor plans), and the corresponding adjacency graph and/or embedding vector for each of multiple candidate floor plans are compared to the specified criteria in order to determine which of the candidate floor plans satisfy the specified criteria (*e.g.*, are a match above a defined similarity threshold). The specified criteria may be of various types in various embodiments and situations, such as one or more of the following non-exclusive examples: search terms corresponding to specific attributes of rooms and/or inter-room connections and/or buildings as a whole (whether objective attributes that can be independently verified and/or replicated, and/or subjective attributes that are determined via use of corresponding classification neural networks); information identifying adjacency information between two or more rooms or other areas; information about views available from windows or other exterior openings of the building; information about directions of windows or other structural elements of the building (*e.g.*, such as to determine natural lighting information available via those windows or other structural elements, optionally at specified days and/or seasons and/or times); etc. Non-exclusive illustrative examples of such specified criteria include the following: a bathroom adjacent to bedroom (i.e., without an intervening hall or other room); a deck adjacent to a family room (optionally with a specified type of connection between them, such as French doors); 2 bedrooms facing south; a kitchen with a tilecovered island and a northward-facing view; a master bedroom with a view of the ocean or more generally of water; any combination of such specified criteria; etc. Additional details are included below regarding the specification and use of criteria to identify matching or otherwise similar floor plans, including via use of adjacency graphs and/or embedding vectors for the floor plans, including with respect to the examples of Figures 2D-2K and their associated description.

As noted above, automated operations of an FPSDM system may, in at least some embodiments, further include using one or more target floor plans that are identified as being sufficiently similar (*e.g.*, above a defined similarity threshold) to specified criteria *(e.g.,* one or more indicated initial floor plans for comparison, specified attributes or other adjacency information, etc.) in one or more further automated manners.

For example, in some embodiments, multiple target floor plans are identified that are similar to specified criteria, and are used for further automated analysis to determine characteristics of that group of target floor plans. Non-exclusive illustrative examples of such determined characteristics for the group of target floor plans may include one or more of the following: common or shared attributes of the target floor plans that are different from the specified criteria *(e.g.,* that are shared by all or a specified minimum amount of the target floor plans); aggregated characteristics of the target floor plans *(e.g.,* from all or a specified minimum amount of the target floor plans), such as an average or cumulative total assessed value of the buildings represented by the multiple target floor plans; etc. Information from the further automated analysis may then be used in further automated operations *(e.g.,* by the FPSDM system, by another system, etc.) in various manners in various embodiments. Additional details are included below regarding the use of multiple identified target floor plans for further automated analysis, including with respect to the examples of Figures 2D-2K and their associated description.

In addition, in some embodiments, one or more target floor plans are identified that are similar to specified criteria associated with a particular end-user *(e.g.,* based on one or more initial target floor plans that are selected by the end-user and/or are identified as previously being of interest to the end-user, based on one or more search criteria specified by the end-user, etc.), and are used in further automated activities to personalize interactions with the end-user. Such further automated personalized interactions may be of various types in various embodiments. Additional details are included below regarding the use of one or more identified target floor plans for further automated end-user personalization, including with respect to the examples of Figures 2D-2K and their associated description.

Furthermore, in some embodiments, one or more target floor plans are identified that are similar to specific criteria associated with a particular end-user (e.g., based on one or more initial target floor plans that are selected by the end-user and/or are identified as previously being of interest to the end-user, based on one or more search criteria specified by the end-user, etc.), and are used in further automated activities to display or otherwise present information to the end-user about the target floor plan(s) and/or additional information associated with those floor plans. Such further automated presentation activities may be of various types in various embodiments. Additional details are included below regarding use of identified target floor plans for further end-user presentation, including regarding examples of Figures 2D-2K and their associated description.

The described techniques related to automated identification of building floor plans that have attributes satisfying target criteria may further include additional operations in some embodiments. For example, in at least some embodiments, machine learning techniques may be used to learn the attributes and/or other characteristics of adjacency graphs to encode in corresponding embedding vectors that are generated, such as the attributes and/or other characteristics that best enable subsequent automated identification of building floor plans having attributes satisfying target criteria *(e.g.,* number of bedrooms; number of bathrooms; connectivity between rooms; size and/or dimensions of each room; number of windows/doors in each room; types of views available from exterior windows, such as water, mountain, a back yard or other exterior area of the property, etc.; location of windows/doors in each room; etc.). Additional details are included below regarding various automated operations that may be performed by the FPSDM system in at least some embodiments.

In at least some embodiments and situations, some or all of the images acquired for a building and associated with the building's floor plan may be panorama images that are each acquired at one of multiple acquisition locations in or around the building, such as to generate a panorama image at each such acquisition location from one or more of a video at that acquisition location *(e.g.,* a 360° video taken from a smartphone or other mobile device held by a user turning at that acquisition location), or multiple images acquired in multiple directions from the acquisition location *(e.g.,* from a smartphone or other mobile device held by a user turning at that acquisition location), or a simultaneous capture of all the image information *(e.g.,* using one or more fisheye lenses), etc. It will be appreciated that such a panorama image may in some situations be represented in a spherical coordinate system and provide up to 360° coverage around horizontal and/or vertical axes, such that a user viewing a starting panorama image may move the viewing direction within the starting panorama image to different orientations to cause different images (or "views") to be rendered within the starting panorama image (including, if the panorama image is represented in a spherical coordinate system, to convert the image being rendered into a planar coordinate system). Furthermore, acquisition metadata regarding the capture of such panorama images may be obtained and used in various manners, such as data acquired from IMU (inertial measurement unit) sensors or other sensors of a mobile device as it is carried by a user or otherwise moved between acquisition locations. Additional details are included below related to the acquisition and usage of panorama images or other images for a building.

As noted above, automated operations of an FPSDM system may, in at least some embodiments, further include analyzing acquired information about a building to determine further attributes of the building and its rooms. For example, as noted above, images acquired in and around the building may be analyzed to determine various types of features of one or more rooms, including with respect to doors and other non-door openings between rooms. In addition, in at least some embodiments, such determining of attributes of buildings and their floor plans may include generating at least a partial floor plan for a particular building and/or at least a partial initial adjacency graph for the building, and using that initial adjacency graph and/or a corresponding embedding vector to predict additional information regarding rooms of the building. For example, such determining of attributes of buildings and their floor plans may include providing an initial (optionally partial) adjacency graph and/or a corresponding embedding vector as input to one or more trained machine learning models (e.g., one or more trained neural networks) that predict types of the rooms from various information acquired about the building, such as based on information about room shape, size, other adjacent rooms or otherwise a position within the building, features identified (e.g., from image analysis) within the room, etc. In addition, such determining of attributes of buildings and their floor plans may include providing an initial (optionally partial) adjacency graph and/or a corresponding embedding vector as input to one or more trained machine learning models *(e.g.,* one or more trained neural networks), whether the same or different machine learning models used for room type prediction, that predict types of inter-room connections or other adjacencies in the building from various information acquired about the building, such as based on types of rooms, other attributes of one or more rooms, position within the building, features identified *(e.g.,* from image analysis) about the inter-room connection or other adjacency, etc. Such predicted room type information and/or inter-room connection/ adjacency type information may be used in various manners in various embodiments, including to update the initial adjacency graph data structure and/or the corresponding embedding vector data structure and/or an underlying floor plan data structure, and with the updated data structure(s) and their information able to be used in various manners (*e.g.*, to identify a building and/or its floor map as matching one or more specified criteria, for display or other presentation to one or more end users, etc. Additional details are included below regarding analyzing acquired information about a building to determine further attributes of the building and its rooms, including predicting room types and/or inter-room connection/adjacency types, such as with respect to the examples of Figures 2D-2K and their associated description.

The described techniques provide various benefits in various embodiments, including to allow floor plans of multi-room buildings and other structures to be identified and used more efficiently and rapidly and in manners not previously available, including to identify building floor plans that match specified criteria to be automatically identified (*e.g.*, based on one or more of similarity to one or more other floor plans; of adjacency information about which rooms are inter-connected and related inter-room relationship information; of information about room interiors and views that are determined at least in part on supplemental information, such as from analysis of one or more images captured at the building; of subjective attributes regarding a floor plan's characteristics, etc.). Such automated techniques allow such identification of matching floor plans to be determined more quickly than previously existing techniques, and in at least some embodiments with greater accuracy, including by using information acquired from the actual building environment (rather than from plans on how the building should theoretically be constructed), as well as enabling the capture of changes to structural elements and/or visual appearance elements that occur after a building is initially constructed. Such described techniques further provide benefits in allowing improved automated navigation of a building by mobile devices *(e.g.,* semi-autonomous or fully-autonomous vehicles), based at least in part on the identification of building floor plans that match specified criteria, including to significantly reduce computing power and time used to attempt to otherwise learn a building's layout. In addition, in some embodiments the described techniques may be used to provide an improved GUI in which a user may more accurately and quickly identify building floor plan(s) matching specified criteria, and obtain information about such building(s) *(e.g.,* for use in navigating an interior of the one or more buildings), including in response to search requests, as part of providing personalized information to the user, as part of providing value estimates and/or other information about a building to a user *(e.g.,* after analysis of information about one or more target building floor plans that are similar to one or more initial floor plans or that otherwise match specified criteria), etc. Various other benefits are also provided by the described techniques, some of which are further described elsewhere herein.

As noted above, automated operations of an FPSDM system may include identifying building floor plans that have attributes satisfying target criteria and subsequently using the identified floor plans in one or more further automated manners. In at least some embodiments, such an FPSDM system may operate in conjunction with one or more separate ICA (Image Capture and Analysis) systems and/or with one or more separate MIGM (Mapping Information and Generation Manager) systems, such as to obtain and use floor plan and other associated information for buildings from the ICA and/or MIGM systems, while in other embodiments such an FPSDM system may incorporate some or all functionality of such ICA and/or MIGM systems as part of the FPSDM system. In yet other embodiments, the FPSDM system may operate without using some or all functionality of the ICA and/or MIGM systems, such as if the FPSDM system obtains information about building floor plans and associated information from other sources *(e.g.,* from manual creation or provision of such building floor plans and/or associated information by one or more users).

With respect to functionality of such an ICA system, it may perform automated operations in at least some embodiments to acquire images *(e.g.,* panorama images) at various acquisition locations associated with a building *(e.g.,* in the interior of multiple rooms of the building), and optionally further acquire metadata related to the image acquisition process and/or to movement of a capture device between acquisition locations - in at least some embodiments, such acquisition and subsequent use of acquired information may occur without having or using information from depth sensors or other distance-measuring devices about distances from images' acquisition locations to walls or other objects in a surrounding building or other structure. For example, in at least some such embodiments, such techniques may include using one or more mobile devices (*e.g.*, a camera having one or more fisheye lenses and mounted on a rotatable tripod or otherwise having an automated rotation mechanism; a camera having one or more fisheye lenses sufficient to capture 360 degrees horizontally without rotation; a smart phone held and moved by a user, such as to rotate the user's body and held smart phone in a 360° circle around a vertical axis; a camera held by or mounted on a user or the user's clothing; a camera mounted on an aerial and/or ground-based drone or other robotic device; etc.) to capture visual data from a sequence of multiple acquisition locations within multiple rooms of a house (or other building). Additional details are included elsewhere herein regarding operations of device(s) implementing an ICA system, such as to perform such automated operations, and in some cases to further interact with one or more ICA system operator user(s) in one or more manners to provide further functionality.

With respect to functionality of such an MIGM system, it may perform automated operations in at least some embodiments to analyze multiple 360° panorama images (and optionally other images) that have been acquired for a building interior (and optionally an exterior of the building), and determine room shapes and locations of passages connecting rooms for some or all of those panorama images, as well as to determine wall elements and other elements of some or all rooms of the building in at least some embodiments and situations. The types of connecting passages between two or more rooms may include one or more of doorway openings and other inter-room non-doorway wall openings, windows, stairways, non-room hallways, etc., and the automated analysis of the images may identify such elements based at least in part on identifying the outlines of the passages, identifying different content within the passages than outside them *(e.g.,* different colors or shading), etc. The automated operations may further include using the determined information to generate a floor plan for the building and to optionally generate other mapping information for the building, such as by using the inter-room passage information and other information to determine relative positions of the associated room shapes to each other, and to optionally add distance scaling information and/or various other types of information to the generated floor plan. In addition, the MIGM system may in at least some embodiments perform further automated operations to determine and associate additional information with a building floor plan and/or specific rooms or locations within the floor plan, such as to analyze images and/or other environmental information *(e.g.,* audio) captured within the building interior to determine particular attributes *(e.g.,* a color and/or material type and/or other characteristics of particular elements, such as a floor, wall, ceiling, countertop, furniture, fixtures, appliances, etc.; the presence and/or absence of particular elements, such as an island in the kitchen; etc.), or to otherwise determine relevant attributes *(e.g.,* directions that building elements face, such as windows; views from particular windows or other locations; etc.). Additional details are included below regarding operations of computing device(s) implementing an MIGM system, such as to perform such automated operations and in some cases to further interact with one or more MIGM system operator user(s) in one or more manners to provide further functionality.

For illustrative purposes, some embodiments are described below in which specific types of information are acquired, used and/or presented in specific ways for specific types of structures and by using specific types of devices - however, it will be understood that the described techniques may be used in other manners in other embodiments, and that the invention is thus not limited to the exemplary details provided. As one non-exclusive example, while specific types of data structures *(e.g.,* floor plans, adjacency graphs, embedding vectors, etc.) are generated and used in specific manners in some embodiments, it will be appreciated that other types of information to describe floor plans and other associated information may be similarly generated and used in other embodiments, including for buildings (or other structures or layouts) separate from houses, and that floor plans identified as matching specified criteria may be used in other manners in other embodiments. In addition, the term "building" refers herein to any partially or fully enclosed structure, typically but not necessarily encompassing one or more rooms that visually or otherwise divide the interior space of the structure - non-limiting examples of such buildings include houses, apartment buildings or individual apartments therein, condominiums, office buildings, commercial buildings or other wholesale and retail structures *(e.g.,* shopping malls, department stores, warehouses, etc.), supplemental structures on a property with another main building *(e.g.,* a detached garage or shed on a property with a house), etc. The term "acquire" or "capture" as used herein with reference to a building interior, acquisition location, or other location (unless context clearly indicates otherwise) may refer to any recording, storage, or logging of media, sensor data, and/or other information related to spatial characteristics and/or visual characteristics and/or otherwise perceivable characteristics of the building interior or subsets thereof, such as by a recording device or by another device that receives information from the recording device. As used herein, the term "panorama image" may refer to a visual representation that is based on, includes or is separable into multiple discrete component images originating from a substantially similar physical location in different directions and that depicts a larger field of view than any of the discrete component images depict individually, including images with a sufficiently wide-angle view from a physical location to include angles beyond that perceivable from a person’s gaze in a single direction. The term "sequence" of acquisition locations, as used herein, refers generally to two or more acquisition locations that are each visited at least once in a corresponding order, whether or not other non-acquisition locations are visited between them, and whether or not the visits to the acquisition locations occur during a single continuous period of time or at multiple different times, or by a single user and/or device or by multiple different users and/or devices. In addition, various details are provided in drawings and text for exemplary purposes, but are not intended to limit the scope of the invention. For example, sizes and relative positions of elements in the drawings are not necessarily drawn to scale, with some details omitted and/or provided with greater prominence *(e.g.,* via size and positioning) to enhance legibility and/or clarity. Furthermore, identical reference numbers may be used in the drawings to identify the same or similar elements or acts.

Figure 1A is an example block diagram of various computing devices and systems that may participate in the described techniques in some embodiments. In particular, information 165 that is generated from data captured in a building interior *(e.g.,* one or more linked panorama images, other perspective images, audio, etc.) is illustrated in Figure 1A, such as to have been generated by an Interior Capture and Analysis ("ICA") system 160 executing in this example on one or more server computing systems 180, such as with respect to one or more buildings or other structures - Figure 1B shows one example of such linked panorama images for a particular house 198 and Figures 2A-2D show examples of acquiring images used to generate a panorama image, as discussed further below, and additional details related to the automated operation of the ICA system are included elsewhere herein, including with respect to Figure 4. An MIGM (Mapping Information Generation Manager) system 160 is further executing on one or more server computing systems 180 in Figure 1A (whether the same or different server computing systems on which the ICA system executes) to generate and provide building floor plans 155 and/or other mapping-related information based on use of the captured building interior information 165 *(e.g.,* linked panorama images) and optionally associated metadata *(e.g.,* metadata about the acquisition and linking of those panorama images) - Figure 2D shows one example of such a floor plan, as discussed further below, and additional details related to the automated operation of the MIGM system are included elsewhere herein, including with respect to Figures 5A-5B.

One or more users (not shown) of one or more client computing devices 175 may further interact over one or more computer networks 170 with an FPSDM (Floor Plan Similarity Determination Manager) system 140 (and optionally the ICA system 160 and/or MIGM system 160), such as to assist in identifying building floor plans having attributes satisfying target criteria and in subsequently using the identified floor plans in one or more further automated manners - such interactions by the user(s) may include, for example, specifying target criteria to use in searching for corresponding floor plans or otherwise providing information about target criteria of interest to the users, or obtaining and optionally interacting with one or more particular identified floor plans and/or with additional associated information *(e.g.,* to change between a floor plan view and a view of a particular image at an acquisition location within or near the floor plan; to change the horizontal and/or vertical viewing direction from which a corresponding view of a panorama image is displayed, such as to determine a portion of a panorama image to which a current user viewing direction is directed, etc.). In addition, a floor plan (or portion of it) may be linked to or otherwise associated with one or more other types of information, including for a multi-story or otherwise multi-level building's floor plan to have associated subfloor plans for different stories or levels that are interlinked (e.g., via connecting stairway passages), for a two-dimensional ("2D") floor plan of a building to be linked to or otherwise associated with a three-dimensional ("3D") rendering of the building, etc. Also, while not illustrated in Figure 1A, in some embodiments the client computing devices 175 (or other devices, not shown), may receive and use information about identified floor plans and/or other mapping-related information in additional manners, such as to control or assist automated navigation activities by those devices *(e.g.,* autonomous vehicles or other devices), whether instead of or in addition to displaying identified information.

Figure 1A further illustrates the FPSDM system 140 that is executing on one or more server computing systems 180 to identify building floor plans having attributes satisfying target criteria and to provide information about such identified building floor plans to initiate subsequent use of the identified floor plans in one or more further automated manners. In the illustrated embodiment, the FPSDM system 140 stores information 142 about floor plans *(e.g.,* to include some or all of the floor plans 155 and/or other floor plans) and information associated with those floor plans *(e.g.,* images and other data captured in the interiors of the buildings to which the floor plans correspond, such as with information about the locations on the floor plans at which such data is captured), and uses that information 142 to generate related adjacency graphs and embedding vectors 145 for further use in identifying building floor plans 142 that have attributes satisfying target criteria - such target criteria may in some embodiments and situations be supplied by or otherwise associated with particular users *(e.g.,* attributes specified by users, floor plans indicated by those users, floor plans previously identified as being of interest to the users, etc.), and corresponding information 143 about various users may further be stored and used in the identifying of the building floor plans that have attributes satisfying target criteria and the subsequent use of the identified floor plans in one or more further automated manners. In addition, the FPSDM system 140 in the illustrated embodiment may further include one or more trained machine learning models 144 *(e.g.,* one or more trained neural networks) and use the trained machine learning model(s) in various manners, including in some embodiments to take a building's adjacency graph and/or corresponding embedding vector as input and predict information about types of rooms and/or about types of inter-room connections or other adjacencies, to determine a degree of similarity between two buildings' floor plans *(e.g.,* by comparing adjacency graphs to represent those building floor plans), etc. Furthermore, in at least some embodiments and situations, one or more users of FPSDM client computing devices 105 may further interact over the network(s) 170 with the FPSDM system 140, such as to assist with some of the automated operations of the FPSDM system for identifying building floor plans having attributes satisfying target criteria and for subsequent use of the identified floor plans in one or more further automated manners. Additional details related to the automated operation of the FPSDM system are included elsewhere herein, including with respect to Figures 2D-2K and Figures 6A-6B.

In some embodiments, the ICA system 160 and/or MIGM system 160 and/or FPSDM system 140 may execute on the same server computing system(s), such as if multiple or all of those systems are operated by a single entity or are otherwise executed in coordination with each other *(e.g.,* with some or all functionality of those systems integrated together into a larger system), while in other embodiments the FPSDM system may instead obtain floor plan information and/or additional associated information from one or more external sources and optionally store them locally with information 142 for further analysis and use by the FPSDM system. In addition, in the depicted computing environment of Figure 1A, the network 170 may be one or more publicly accessible linked networks, possibly operated by various distinct parties, such as the Internet. In other implementations, the network 170 may have other forms. For example, the network 170 may instead be a private network, such as a corporate or university network that is wholly or partially inaccessible to nonprivileged users. In still other implementations, the network 170 may include both private and public networks, with one or more of the private networks having access to and/or from one or more of the public networks. Furthermore, the network 170 may include various types of wired and/or wireless networks in various situations. In addition, the client computing devices 175 and server computing systems 180 may include various hardware components and stored information, as discussed in greater detail below with respect to Figure 3.

In the example of Figure 1A, ICA system 160 may perform automated operations involved in generating multiple panorama images *(e.g.,* each a 360 degree panorama around a vertical axis) at multiple associated acquisition locations *(e.g.,* in multiple rooms or other locations within a building or other structure and optionally around some or all of the exterior of the building or other structure), such as for use in generating and providing a representation of an interior of the building or other structure. The techniques may further include analyzing information to determine relative positions/directions between each of two or more acquisition locations, creating inter-panorama positional/directional links in the panoramas to each of one or more other panoramas based on such determined positions/directions, and then providing information to display or otherwise present multiple linked panorama images for the various acquisition locations within the house. Additional details related to embodiments of a system providing at least some such functionality of an ICA system are included in co-pending U.S. Non-Provisional Patent Application No. 16/693,286, filed November 23, 2019 and entitled "Connecting And Using Building Data Acquired From Mobile Devices" (which includes disclosure of an example BICA system that is generally directed to obtaining and using panorama images from within one or more buildings or other structures); in U.S. Non-Provisional Patent Application No. 16/236,187, filed December 28, 2018 and entitled "Automated Control Of Image Acquisition Via Use Of Acquisition Device Sensors" (which includes disclosure of an example ICA system that is generally directed to obtaining and using panorama images from within one or more buildings or other structures); and in U.S. Non-Provisional Patent Application No. 16/190,162, filed November 14, 2018 and entitled "Automated Mapping Information Generation From Inter-Connected Images"; each of which is incorporated herein by reference in its entirety.

Figure 1B depicts a block diagram of an exemplary building interior environment in which linked panorama images have been generated and are ready for use to generate and provide a corresponding building floor plan, as well as for use in presenting the linked panorama images to users. In particular, Figure 1B includes a building 198 with an interior that was captured at least in part via multiple panorama images, such as by a user (not shown) carrying a mobile device 185 with image acquisition capabilities through the building interior to a sequence of multiple acquisition locations 210. An embodiment of the ICA system *(e.g.,* ICA system 160 on server computing system(s) 180; a copy of some or all of the ICA system executing on the user's mobile device, such as ICA application software system 154 executing in memory 152 on device 185; etc.) may automatically perform or assist in the capturing of the data representing the building interior, as well as further analyze the captured data to generate linked panorama images providing a visual representation of the building interior. While the mobile device of the user may include various hardware components, such as one or more cameras or other imaging systems 135, one or more sensors 148 *(e.g.,* a gyroscope 148a, an accelerometer 148b, a compass 148c, etc., such as part of one or more IMUs, or inertial measurement units, of the mobile device; an altimeter; light detector; etc.), a GPS receiver, one or more hardware processors 132, memory 152, a display 149, a microphone, etc., the mobile device may not in at least some embodiments have access to or use equipment to measure the depth of objects in the building relative to a location of the mobile device, such that relationships between different panorama images and their acquisition locations may be determined in part or in whole based on matching elements in different images and/or by using information from other of the listed hardware components, but without using any data from any such depth sensors. In addition, while directional indicator 109 is provided for reference of the viewer, the mobile device and/or ICA system may not use such absolute directional information in at least some embodiments, such as to instead determine relative directions and distances between panorama images 210 without regard to actual geographical positions or directions.

In operation, a user associated with the mobile device arrives at a first acquisition location 210A within a first room of the building interior (in this example, an entryway from an external door 190-1 to the living room), and captures a view of a portion of the building interior that is visible from that acquisition location 210A *(e.g.,* some or all of the first room, and optionally small portions of one or more other adjacent or nearby rooms, such as through doors, halls, stairs or other connecting passages from the first room) as the mobile device is rotated around a vertical axis at the first acquisition location *(e.g.,* with the user turning his or her body in a circle while holding the mobile device stationary relative to the user's body). The actions of the user and/or the mobile device may be controlled or facilitated via use of one or more programs executing on the mobile device, such as ICA application system 154, optional browser 162, control system 147, etc., and the view capture may be performed by recording a video and/or taking a succession of one or more images, including to capture visual information depicting a number of objects or other elements *(e.g.,* structural details) that may be visible in images *(e.g.,* video frames) captured from the acquisition location. In the example of Figure 1B, such objects or other elements include various elements that are structurally part of the walls (or "wall elements"), such as the doorways 190 and 197 and their doors *(e.g.,* with swinging and/or sliding doors), windows 196, inter-wall borders *(e.g.,* corners or edges) 195 (including corner 195-1 in the northwest corner of the building 198, and corner 195-2 in the northeast corner of the first room) - in addition, such objects or other elements in the example of Figure 1B may further include other elements within rooms, such as furniture 191-193 (e.g., a couch 191; chairs 192; tables 193; etc.), pictures or paintings or televisions or other objects 194 (such as 194-1 and 194-2) hung on walls, light fixtures, etc. The user may also optionally provide a textual or auditory identifier to be associated with an acquisition location, such as "entry" for acquisition location 210A or "living room" for acquisition location 210B, while in other embodiments the ICA system may automatically generate such identifiers (e.g., by automatically analyzing video and/or other recorded information for a building to perform a corresponding automated determination, such as by using machine learning) or the identifiers may not be used.

After the first acquisition location 210A has been adequately captured (*e.g.*, by a full rotation of the mobile device), the user may proceed to a next acquisition location (such as acquisition location 210B), optionally recording movement data during movement between the acquisition locations, such as video and/or other data from the hardware components *(e.g.,* from one or more IMUs, from the camera, etc.). At the next acquisition location, the user may similarly use the mobile device to capture one or more images from that acquisition location. This process may repeat from some or all rooms of the building and optionally external to the building, as illustrated for acquisition locations 210C-210J. The acquired video and/or other images for each acquisition location are further analyzed to generate a panorama image for each of acquisition locations 210A-210J, including in some embodiments to match objects and other elements in different images. In addition to generating such panorama images, further analysis may be performed in order to 'link' at least some of the panoramas together (with some corresponding lines 215 between them being shown for the sake of illustration), such as to determine relative positional information between pairs of acquisition locations that are visible to each other, to store corresponding inter-panorama links *(e.g.,* links 215-AB, 215-BC and 215-AC between acquisition locations A and B, B and C, and A and C, respectively), and in some embodiments and situations to further link at least some acquisition locations that are not visible to each other (e.g., a link 215-BE, not shown, between acquisition locations 210B and 210E).

Additional details related to embodiments of generating and using linking information between panorama images, including using travel path information and/or elements or other features visible in multiple images, are included in co-pending U.S. Non-Provisional Patent Application No. 16/693,286, filed November 23, 2019 and entitled "Connecting And Using Building Data Acquired From Mobile Devices" (which includes disclosure of an example BICA system that is generally directed to obtaining and using linking information to interconnect multiple panorama images captured within one or more buildings or other structures), which is incorporated herein by reference in its entirety.

Various details are provided with respect to Figures 1A-1B, but it will be appreciated that the provided details are non-exclusive examples included for illustrative purposes, and other embodiments may be performed in other manners without some or all such details.

Figures 2A-2K illustrate examples of automatically identifying building floor plans that have attributes satisfying target criteria and subsequently using the identified floor plans in one or more automated manners, such as for the building 198 discussed in Figure 1B.

In particular, Figure 2A illustrates an example image 250a, such as a nonpanorama perspective image taken in a northeasterly direction from acquisition location 210B in the living room of house 198 of Figure 1B (or a northeasterly facing subset view of a 360-degree panorama image taken from that acquisition location and formatted in a rectilinear manner) - the directional indicator 109a is further displayed in this example to illustrate the northeasterly direction in which the image is taken. In the illustrated example, the displayed image includes built-in elements *(e.g.,* light fixture 130a), furniture *(e.g.,* chair 192-1), two windows 196-1, and a picture 194-1 hanging on the north wall of the living room. No inter-room passages into or out of the living room *(e.g.,* doors or other wall openings) are visible in this image. However, multiple room borders are visible in the image 250a, including horizontal borders between a visible portion of the north wall of the living room and the living room's ceiling and floor, horizontal borders between a visible portion of the east wall of the living room and the living room's ceiling and floor, and the inter-wall vertical border 195-2 between the north and east walls.

Figure 2B continues the example of Figure 2A, and illustrates an additional perspective image 250b taken in a northwesterly direction from acquisition location 210B in the living room of house 198 of Figure 1B - the directional indicator 109b is further displayed to illustrate the northwesterly direction in which the image is taken. In this example image, a small portion of one of the windows 196-1 continues to be visible, along with a portion of window 196-2 and a new lighting fixture 130b. In addition, horizontal and vertical room borders are visible in image 250b in a manner similar to that of Figure 2A.

Figure 2C continues the examples of Figures 2A-2B, and illustrates a third perspective image 250c taken in a southwesterly direction in the living room of house 198 of Figure 1B, such as from acquisition location 210B - the directional indicator 109c is further displayed to illustrate the southwesterly direction in which the image is taken. In this example image, a portion of window 196-2 continues to be visible, as is a couch 191 and visual horizontal and vertical room borders in a manner similar to that of Figures 2A and 2B. This example image further illustrates an inter-room passage for the living room, which in this example is a door 190-1 to enter and leave the living room (which Figure 1B identifies as a door to the exterior of the house). It will be appreciated that a variety of other perspective images may be taken from acquisition location 210B and/or other acquisition locations and displayed in a similar manner.

Figure 2D continues the examples of Figures 2A-2C, and illustrates a panorama image 255d that is acquired separately from the images captured at the acquisition locations 210 of Figure 1B for use in generating a floor plan for the building 198 (additional details related to an example display of a floor plan for the building 198 are discussed below with respect to Figure 2D and elsewhere herein) - instead, panorama image 255d is acquired in this example at a time after the generation of the floor plan for building 198, and for use in associating the panorama image 255d with a position on a floor plan for the building 198 that corresponds to the acquisition location of the panorama image 255d. In this example, the panorama image 255d is a 180° panorama image taken from an acquisition location in the northwest quadrant of the living room, and includes 180° of horizontal coverage around a vertical axis (*e.g.*, a half circle showing approximately the northern quarter of the living room), and with the x and y axes of the image's visual contents being aligned with corresponding horizontal and vertical information in the room (*e.g.*, the border between two walls, the border between a wall and the floor, the bottoms and/or tops of windows and doors, etc.). In this example, the image capture begins with a camera orientation in a western direction, corresponding to a relative starting horizontal direction of 0° for the panorama image 255d, and continues in a half circle, with a relative 90° horizontal direction for this panorama image then corresponding to the northern direction, and a relative 180° horizontal direction for this panorama image corresponding to the eastern direction. If a full 360° panorama image had instead been captured from that same starting direction, it would include the same directional information as noted above for the 180° panorama image, and would further include a relative 270° horizontal direction for the 360° panorama image corresponding to the southern direction, and a relative 360° ending horizontal direction for the 360° panorama image being back to the western direction. Using such a panorama image 255d, various subsets of the panorama image may be displayed to an end-user (not shown) in a manner similar to that of perspective images 250a-250b of Figures 2A-2B, with an example subset 250d shown as part of the panorama image 255d - while not separately shown on panorama image 255d, a subset portion of it that is similar to the first perspective image 250a is available in a right portion of the panorama image 255d, while a left subset portion of the panorama image 255d contains visual data similar to that of the perspective image 250b. Since the panorama image 255d does not extend to a full 360° horizontal degrees in this example, a subset portion of it corresponding to perspective image 250c is not available, but if a 360° panorama image was instead acquired from acquisition location 265 (as discussed further below with respect to image angular descriptor 270), such a 360° panorama image would include a subset portion with visual information similar to that of perspective image 250c.

Figure 2D further illustrates one example 255d of a 2D floor plan for the house 198, such as may be presented to an end-user in a GUI, with the living room being the most westward room of the house (as reflected by directional indicator 209) - it will be appreciated that a 3D or 2.5D floor plan showing wall height information may be similarly generated and displayed in some embodiments, whether in addition to or instead of such a 2D floor plan. Various types of information are illustrated on the 2D floor plan 255d in this example. For example, such types of information may include one or more of the following: room labels added to some or all rooms *(e.g.,* "living room" for the living room); room dimensions added for some or all rooms; visual indications of features such as installed fixtures or appliances *(e.g.,* kitchen appliances, bathroom items, etc.) or other built-in elements *(e.g.,* a kitchen island) added for some or all rooms; visual indications added for some or all rooms of positions of additional types of associated and linked information *(e.g.,* of other panorama images and/or perspective images that an end-user may select for further display, of audio annotations and/or sound recordings that an end-user may select for further presentation, etc.); visual indications added for some or all rooms of structural features such as doors and windows; visual indications of visual appearance information *(e.g.,* color and/or material type and/or texture for installed items such as floor coverings or wall coverings or surface coverings); visual indications of views from particular windows or other building locations and/or of other information external to the building *(e.g.,* a type of an external space; items present in an external space; other associated buildings or structures, such as sheds, garages, pools, decks, patios, walkways, gardens, etc.); a key or legend 269 identifying visual indicators used for one or more types of information; etc. When displayed as part of a GUI, some or all such illustrated information may be user-selectable controls (or be associated with such controls) that allows an end-user to select and display some or all of the associated information (*e.g.*, to select the 360° panorama image indicator for acquisition location 210B to view some or all of that panorama image *(e.g.,* in a manner similar to that of Figures 2A-2D). In addition, in this example a user-selectable control 228 is added to indicate a current floor that is displayed for the floor plan, and to allow the end-user to select a different floor to be displayed - in some embodiments, a change in floors or other levels may also be made directly from the floor plan, such as via selection of a corresponding connecting passage in the illustrated floor plan *(e.g.,* the stairs to floor 2). It will be appreciated that a variety of other types of information may be added in some embodiments, that some of the illustrated types of information may not be provided in some embodiments, and that visual indications of and user selections of linked and associated information may be displayed and selected in other manners in other embodiments.

Additional details related to embodiments of a system providing at least some such functionality of an MIGM system or related system for generating floor plans and associated information and/or presenting floor plans and associated information are included in co-pending U.S. Non-Provisional Patent Application No. 16/190,162, filed November 14, 2018 and entitled "Automated Mapping Information Generation From Inter-Connected Images" (which includes disclosure of an example Floor Map Generation Manager, or FMGM, system that is generally directed to automated operations for generating and displaying a floor map or other floor plan of a building using images acquired in and around the building); in U.S. Non-Provisional Patent Application No. 16/681,787, filed November 12, 2019 and entitled "Presenting Integrated Building Information Using Three-Dimensional Building Models" (which includes disclosure of an example FMGM system that is generally directed to automated operations for displaying a floor map or other floor plan of a building and associated information); in U.S. Non-Provisional Patent Application No. 16/841,581, filed April 6, 2020 and entitled "Providing Simulated Lighting Information For Three-Dimensional Building Models" (which includes disclosure of an example FMGM system that is generally directed to automated operations for displaying a floor map or other floor plan of a building and associated information); in U.S. Provisional Patent Application No. 62/927,032, filed October 28, 2019 and entitled "Generating Floor Maps For Buildings From Automated Analysis Of Video Of The Buildings' Interiors" (which includes disclosure of an example Video-To-Floor Map, or FPSDM, system that is generally directed to automated operations for generating a floor map or other floor plan of a building using video data acquired in and around the building); in U.S. Non-Provisional Patent Application No. 16/807,135, filed March 2, 2020 and entitled "Automated Tools For Generating Mapping Information For Buildings" (which includes disclosure of an example MIGM system that is generally directed to automated operations for generating a floor map or other floor plan of a building using images acquired in and around the building); and in U.S. Non-Provisional Patent Application No. 17/013,323, filed September 4, 2020 and entitled "Automated Analysis Of Image Contents To Determine The Acquisition Location Of The Image" (which includes disclosure of an example MIGM system that is generally directed to automated operations for generating a floor map or other floor plan of a building using images acquired in and around the building, and an example ILMM system for determining the acquisition location of an image on a floor plan based at least in part on an analysis of the image's contents); each of which is incorporated herein by reference in its entirety.

Figure 2E continues the examples of Figures 2A-2D, and illustrates information 255e that includes a representation 230e of the floor plan 230d previously illustrated in Figure 2D, with the representation 230e lacking some of the details illustrated in floor plan 230d, but further including information to illustrate at least part of an adjacency graph that is generated by the FPSDM system (not shown) for the floor plan and that is overlaid on the view of the floor plan in this example for the sake of illustration. In this example, the adjacency graph includes various nodes 245 that represent at least some rooms of the house (such as node 245b for the living room, node 245a for the hallway, etc.), and edges 235 between various of the nodes (such as an edge 235b-j between nodes 245b and 245j, an edge 235a-b between nodes 245a and 245b, an edge 235a-f between nodes 245a and 245f, etc.) that represent connections between rooms, with the adjacency graph in this example being a sparse graph that includes inter-node edges only between nodes whose rooms are inter-connected via doors or other non-door openings (and do not include edges between nodes whose rooms are adjacent, such as that share at least one part of at least one wall, but are not connected to allow direct passage between those rooms). While at least some rooms of the house are represented with associated nodes in the adjacency graph, in at least some embodiments, some spaces within the house may not be treated as rooms for the purpose of the adjacency graph (i.e., may not have separate nodes in the adjacency graph), such as for closets, small areas such as a pantry or a cupboard, connecting areas such as stairs and/or hallways, etc. - in this example embodiment, the stairs have a corresponding node 245h and the walk-in closet may optionally have a node 2451, while the pantry does not have a node, although none or all or any combination of those spaces may have nodes in other embodiments. In addition, in this example embodiment, areas outside of the building that are adjacent to building entries/exits also have nodes to represent them, such as node 245j corresponding to the front yard (which is accessible from the building by the entry door), and node 245i corresponding to the patio (which is accessible by the patio door) - in other embodiments, such external areas may not be represented as nodes (and instead may be represented in some embodiments as attributes associated with adjacent exterior doors or other openings and/or with their rooms). Similarly, in this example embodiment, information about areas that are visible from windows or from other building locations may also be represented by nodes, such as optional node 245k corresponding to the view accessible from the western window in the living room, although in other embodiments such views may not be represented as nodes (and instead may be represented in some embodiments as attributes associated with the corresponding window or other building location and/or with their rooms). It will be noted that, while some edges are shown on floor plan representation 230e as passing through walls (such as edge 235a-f between the node 245a for the hallway and node 245f for bedroom 1), the actual connections between the rooms corresponding to the nodes that such an edge connects are based on a door or other non-door opening connection *(e.g.,* based on the interior door between the hallway and bedroom 1 that is illustrated near the northeast end of the hallway). In addition, while not illustrated in information 255e, the adjacency graph for the house may further continue in other areas of the house that are not shown, such as the second floor.

Figure 2E includes an additional illustration 240e of the adjacency graph for the floor plan 230e but without the corresponding floor plan being shown, and with additional details illustrated for the adjacency graph. In particular, in this example, the various nodes and edges of the adjacency graph from information 255e are shown, along with additional nodes 245m and 245n corresponding to rooms of the second floor (not shown), and with additional nodes and edges potentially being added to the adjacency graph for further rooms and inter-room connectivity information (or in other embodiments, non-connected adjacency information as well). In the example of adjacency graph 240e, visual indications of the type of inter-room connectivity information are shown for the benefit of the viewer, such as visual indications of wall opening 268b and interior door 268c (as well as, in this example, window 268a between the living room and the westward view from the living room over the front yard), although such information may instead be part of the attributes of the edge and not visually shown. For example, each edge 235 may include information 249 about attributes of the inter-room connectivity/adjacency represented by the edge, with example information 249a-f corresponding to edge 235a-f being shown, which in this example may include information for attributes such as one or more of the following: an inter-room connection type; inter-room connection dimensions (e.g., width; height and/or depth); etc. Similarly, each node 245 may include information 247 about attributes of the room represented by the node, with example information 247c corresponding to node 245c being shown, which in this example may include information for attributes such as one or more of the following: room type; room dimensions; locations in the room of windows and doors and other inter-room openings; information about a shape of the room (whether about a 2D shape and/or 3D shape); a type of view for each window, and optionally direction information that each window faces; optionally direction information for doors and other inter-room openings; information about other features of the room, such as from analysis of associated images and/or information supplied by end-users who view the floor plan and optionally its associated images *(e.g.,* visual appearance and types of materials used, such as colors and/or textures and/or types for carpets or other floor materials and for wall coverings and for ceilings; etc.; light fixtures or other built-in elements; furniture or other items within the room; etc.); information about and/or copies of images taken in the room (optionally with associated location information within the room for each of the images); information about and/or copies of audio or other data captured in the room (optionally with associated location information within the room for each of the audio clips or other pieces of data); etc.

Figure 2F continues the examples of Figures 2A-2E, and again illustrates the adjacency graph 240e shown in Figure 2E, but with some details of Figure 2E not shown in Figure 2F for the sake of brevity - for example, while attribute information for nodes and edges is not illustrated in Figure 2F, such information is still present in the adjacency graph 240e shown in Figure 2F. Figure 2F further illustrates the use of a representation learning graph encoder component 265 of the FPSDM system that takes the adjacency graph information as input, and that generates a resulting embedding vector 275e that represents the adjacency graph 240e for the floor plan 230e. As discussed in greater detail elsewhere herein, the embedding vector may be a concise representation of some or all of the information included in the adjacency graph 240e, such as for subsequent use in performing comparisons between floor plans of multiple buildings or for otherwise identifying floor plans matching specified criteria. In addition, the graph encoder 265 may use various specific algorithms to generate the embedding vector 275e, and in some embodiments the component 265 or an associated component (not shown) of the FPSDM system may automatically learn the types of information of the adjacency graph to include in the resulting embedding vectors, as discussed in greater detail elsewhere herein.

Figure 2G continues the examples of Figures 2A-2F, and again illustrates the embedding vector 275e shown in Figure 2F, along with information 275z about one or more other embedding vectors for other floor plans of other buildings. As discussed in greater detail elsewhere herein, the comparison of two floor plans of two buildings to determine their similarity may include using a component 266 of the FPSDM system to determine the distance between two embedding vectors for those two floor plans (or other measure of difference or similarity), such as to produce one or more best match floor plan embedding results 290. In this example, a database 268 (or other store) of floor plan embedding vectors may be available that stores a variety of previously generated embedding vectors 275a-275d and 275f-275x for a variety of corresponding floor plans of buildings, with the embedding vector 275e used in this example as an initial embedding vector that is compared to some or all of the embedding vectors in the database 268 (whether simultaneously or serially) in order to determine distances between that initial embedding vector and those other embedding vectors stored in the database. In addition, in at least some embodiments and situations, the determination of the one or more best match floor plan embedding results 290 may be based not only on the initial embedding vector 275e but also optionally on one or more other initial floor plan embedding vectors 275z, such as to similarly compare each of the one or more other initial floor plan embedding vectors 275z to some or all of the embedding vectors stored in the database 268 (whether simultaneously or serially) in order to determine distances between each of those other initial embedding vectors and those database embedding vectors, and with the best match embedding results 290 being based on the combination of the distance similarity information for the embedding vectors in the database to the initial embedding vectors that are used. In other embodiments, the determiner component 266 may instead receive as input one or more initial embedding vectors and multiple other embedding vectors to which the initial embedding vector(s) are compared, without the use of such a database of previously generated and stored embedding vectors. After the best match floor plan embedding results 290 have been generated, they may be further used in one or more automated manners in various embodiments, such as to provide the corresponding floor plans and their associated information for the best match embedding vectors to use in presentation to an end-user, to provide the corresponding floor plans and their associated information for use in providing further automated personalized interactions with an end-user based on one or more initial floor plans of interest to the end-user *(e.g.,* floor plan(s) selected by the end-user or previously identified to be of interest to the end-user, etc.), to provide the corresponding floor plans and their associated information for comparative analysis to each other *(e.g.,* to determine common characteristics, aggregate characteristics, etc.) and optionally to one or more initial floor plan embedding vectors, etc.

Figure 2H continues the examples of Figures 2A-2G, and illustrates a floor plan 230h similar to floor plan 230e of Figure 2E. The floor plan 230h lacks some details of floor plan 230e *(e.g.,* the optional nodes 245k and 245l of the adjacency graph), but with the floor plan 230h being fully connected to include edges 237 that represent inter-room non-connected adjacencies, as well as the previous edges 235 that represent inter-room connections. For example, bedroom 1 with node 245f previously had only a single edge 235a-f in floor plan 230e to represent the doorway between bedroom 1 and the hallway, with node 245f in floor plan 230h includes two additional adjacency type edges 237b-f and 237e-f to represent the adjacency of bedroom 1 to the living room and the kitchen, respectively. While connectivity edges 235 and non-connected adjacency edges 237 are illustrated separately in the adjacency graph shown in floor plan 230h, in other embodiments an initial version of such an adjacency graph may instead have only a single type of edge, such as if the types of inter-room connectivity/adjacencies are not initially known, with additional details discussed with respect to Figures 2J-2K.

Figure 2I continues the examples of Figures 2A-2H, and illustrates information 255i regarding how information in a building's fully connected adjacency graph (such as shown in Figure 2H, and in some cases with only a single type of edge, such as if the types of inter-room connectivity/adjacencies are not initially known) may be used to predict additional types of information regarding the building and its floor plan. In the example of Figure 2I, an initial adjacency graph 281a is provided as input to an FPSDM component 282 to generate a corresponding embedding vector 283 for the floor plan, such as in a manner similar to component 265 and embedding vector 275e of Figure 2F - in other embodiments, such a component 282 may not be used (e.g., if the adjacency graph is used directly for prediction without an intermediate embedding vector), and/or the output of the component 282 may be encoded in a different manner than an embedding vector as described elsewhere herein. In the example of Figure 2I, the generated embedding vector 283 is provided as input to one or more trained machine learning models *(e.g.,* one or more trained neural networks), which use information encoded in the embedding vector to predict additional attributes for the building and its rooms - such trained machine learning models may include at least one machine learning model 284 trained to identify inter-room door connections (and optionally non-door opening connections), at least one machine learning model 285 trained to identify inter-room non-connected adjacencies *(e.g.,* wall(s) between two adjacent rooms), and at least one machine learning model 286 trained to identify types of rooms.

The at least one machine learning model 286 then provides output 289 indicating predicted room types of some or all rooms in the building, with that information 289 stored and optionally used to generate an updated version 281b of the adjacency graph, and/or to otherwise update the information about the building (e.g., to update the building's floor plan, embedding vector(s), etc.). In addition, the at least one machine learning model 284 provides output 284o indicating predicted inter-room door connections (and optionally non-door opening connections) for at least some inter-room connections/adjacencies of the building, and the at least one machine learning model 285 provides output 285o indicating predicted inter-room non-connected adjacencies *(e.g.,* one or more walls between two adjacent rooms) for at least some inter-room connections/adjacencies of the building. The information 284o and 285o is then provided in this example embodiment to an FPSDM component 287 that aggregates the different inter-room connection/adjacency predictions from the trained machine learning models 284 and 285, which provides output 288 indicating predicted inter-room connection/adjacency types for some or all rooms in the building, with that information 288 stored and optionally used to generate an updated version 281b of the adjacency graph, and/or to otherwise update the information about the building *(e.g.,* to update the building's floor plan, embedding vector(s), etc.). Additional details are included below regarding additional examples for performing at least some of the automated operations discussed with respect to Figure 2I.

Figure 2J continues the examples of Figures 2A-2I, and illustrates a fully connected adjacency graph 240j corresponding to the floor plan 230h of Figure 2H, such as to illustrate operations of the at least one trained machine learning model 286 of Figure 2I that predicts room type information for nodes of the graph corresponding to rooms of the building. Three room nodes 245a for the hallway, 245c for bedroom 2 and 245d for the bathroom are illustrated in Figure 2J for the sake of illustration, such as with respect to the types of building information that may be used for the room type predictions - in addition, while the nodes 245 are shown with labels such as 'hallway', 'bedroom 1', etc. in this example, such information may not be known for the adjacency graph in at least some embodiments *(e.g.,* may be added after the room type predictions are completed). While any of the node attribute information 247 for any of the nodes 245 and/or edge attribute information 249 for any of the edges 235 and 237 may be used for the room type predictions, factors that may assist in identifying the room type for the node 245a as being of a 'hallway' type may include, for example, the shape and/or size of the room *(e.g.,* long and narrow), the large quantity of inter-room connections from the room, the location in the center of the building, the types of other inter-connected rooms *(e.g.,* bedrooms and bathrooms), etc. In addition, factors that may assist in identifying the room type for the node 245c as being of a 'bedroom' type may include, for example, the shape and/or size of the room *(e.g.,* rectangular and close to square), the types of other inter-connected rooms *(e.g.,* to a 'bathroom' type room and not to a room type such as a kitchen or living room), the location at the exterior of the building *(e.g.,* with a window), the existence of an attached closet (not shown), etc. Similarly, factors that may assist in identifying the room type for the node 245d as being of a 'bathroom' type may include, for example, the shape and/or size of the room *(e.g.,* rectangular and relatively small), the existence of built-in features *(e.g.,* a toilet, sink, shower, etc.), the types of other inter-connected rooms *(e.g.,* to a 'bedroom' type room and not to a room type such as a kitchen), etc. It will be appreciated that various other information may further be used in at least some embodiments, as discussed in greater detail elsewhere herein.

Figure 2K continues the examples of Figures 2A-2J, and illustrates a fully connected adjacency graph 240k corresponding to the floor plan 230h of Figure 2H, such as to illustrate operations of the trained machine learning models 284 and 285 and component 287 of Figure 2I that predict inter-room connection/adjacency type information for edges of the adjacency graph. Three edges for bedroom are illustrated in Figure 2K for the sake of illustration (edge 234a-c to the hallway, edge 235c-d to the bathroom, and edge 237b-c to the living room), such as with respect to the types of building information that may be used for the inter-room connection/adjacency type predictions - in addition, while the edges are separated into connection edges 235 and non-connection adjacency edges 237 in this example, such edge type information may not be known for the adjacency graph in at least some embodiments *(e.g.,* may be added after the inter-room connection/adjacency predictions are completed). While any of the node attribute information 247 for any of the nodes 245 and/or edge attribute information 249 for any of the edges 235 and 237 may be used for the inter-room connection/adjacency type predictions, factors that may assist in identifying the edge type for the edge 235a-c between bedroom 2 and the hallway as being of an inter-room connection type (and optionally of a 'door' sub-type within the inter-room connection type) may include, for example, the types of the rooms that the edge connects *(e.g.,* hallway and bedroom), shape, size and/or other visual features of the inter-room connection that are visible from one or both rooms *(e.g.,* from automated analysis of images taken in one or both rooms), an ability to see at least a portion of the adjacent room from an image taken in the other room, etc. Similarly, factors that may assist in identifying the edge type for the edge 235c-d between bedroom 2 and the bathroom as being of an inter-room connection type (and optionally of a 'door' sub-type within the inter-room connection type) may include, for example, the types of the rooms that the edge connects *(e.g.,* bedroom and bathroom), shape, size and/or other visual features of the inter-room connection that are visible from one or both rooms *(e.g.,* from automated analysis of images taken in one or both rooms), an ability to see at least a portion of the adjacent room from an image taken in the other room, etc. In addition, factors that may assist in identifying the edge type for the edge 237b-c between bedroom 2 and the living room as being of an inter-room non-connected adjacency type (and optionally of a 'wall' sub-type within the inter-room non-connected adjacency type) may include, for example, the types of the rooms that the edge connects *(e.g.,* bedroom and living room), shape, size and/or other visual features of the adjacent areas of the rooms that are visible from one or both rooms *(e.g.,* to show solid walls without any openings, such as from automated analysis of images taken in one or both rooms), an inability to see at least a portion of the adjacent room from an image taken in the other room, etc. It will be appreciated that various other information may further be used in at least some embodiments, as discussed in greater detail elsewhere herein.

In at least some embodiments, the prediction of room type information and inter-room connection/adjacency information includes various automated operations. For example, an adjacency graph may first be constructed for a building's floor plan, in which each node represents a room, and edges represent the connectivity or other adjacency of two rooms. Examples of node features that may be captured and used for the predictions including some or all of the following non-exclusive list: the number of doors, windows, and openings of the room; the room type; the perimeter of the room; the maximum length and width of room; the area of the room; the ratio between the room area and the room's bounding box area; chain code shape descriptors; shape descriptors to represent the centroid distance *(e.g.,* the distance from the shape center to bound point); an order in which one or more images *(e.g.,* panorama images) were captured in the room, relative to that of other rooms; features of the room extracted from analysis of one or more images *(e.g.,* panorama images) captured in the room; center coordinates of the room; etc.

In at least some embodiments, such as the example of Figure 2I, both inter-room connection type edges and inter-room non-connection adjacency type edges are predicted at the same time, although in the other embodiments they may instead be predicted at different times, predicted together at the same time, or only have one of the two types predicted. As one example embodiment, an incomplete adjacency graph is first generated, including in some cases by hiding random number of edges. The generated adjacency graph is then provided as input to an encoder component *(e.g.,* component 282 of Figure 2I), which produces an embedding for each node. The processing of the edge types may in some embodiments split into two branches, such as to predict inter-room connectivity type edges *(e.g.,* via doors) in a first branch, and to predict inter-room non-connected adjacency type edges *(e.g.,* walls) in a second branch, with the two types of predicted information aggregated together *(e.g.,* as illustrated with respect to elements 284, 284o, 285, 285o, 287 and 288 in Figure 2I).

For example, consider an example embodiment in which $G = (A,X)$ is an undirected graph with its adjacency matrix $A \in R^{N \times N}$ and node attributes $X = \{x_1, x_2, ... x_N\}$, $x_i \in R^F$, where N is the number of nodes in the graph and F is the number of features of each node. The goal of the model is to learn an encoding function $H = g(A,X)$ and three decoding functions $P_i = d_i(H)$ ($i \in \{1,2, 3\}$), where $H$ is the embedding from the encoder, and $P_i$ is the output of edge prediction. The encoder g transforms the initial features $X$ to new feature representations by aggregating information of the node neighborhoods, and then passes information to the next layers of one or more trained machine learning models

*(e.g.,* one or more graph neural networks, or GNNs). Then, the decoders *d* use the new representations to predict the probability of whether or not an edge exists between two nodes. The encoder may be, for example, a base Graph attention network (GAT), and the decoders may be, for example, fully connected layers to predict the connectivity score between pairs of nodes *(i,j)*. The two different types of edges are predicted in this example by combining the loss function of each task, with the binary cross entropy loss for each task being minimized, and the loss function of the proposed system expressed as follows:

$$l = l_{connectivity} + \alpha_1 l_{adjacency} + \alpha_2 l_{connectivity+adjacency} \quad (1)$$

where $l$ denotes the total loss, $l_{connectivity}$ is the loss for inter-room connectivity (which can be thought of as a special type of room adjacency in which the adjacent rooms are inter-connected, such as may be visually identified through a doorway or other opening between the rooms), $l_{adjacency}$ is the loss for adjacency of two rooms that are not inter-connected (such as two rooms that lack any visual information from either of the rooms into the other room), and $l_{connectivity+adjacency}$ is the loss for both inter-room connectivity between two rooms and adjacency of two rooms that are not inter-connected. The terms $\alpha_1$ and $\alpha_2$ are the importance weights associated with the $l_{adjacency}$ and $l_{connectivity+adjacency}$ terms, respectively.

In the example embodiment discussed above, the encoder is based on a graph attention network (GAT), which attempts to generate new feature representations that can help predict links. In this example, the input graph is first passed into several graph attention layers to capture structural information by aggregating the attributes of its neighbors. The graph attention layers will produce embeddings for each node $\hat{U} = g(A,X)$. Furthermore, the initial feature $X$ may itself contain some rooms properties (e.g., room shape), which also helps to improve the link prediction performance. Hence, a long skip connection is added by concatenating the initial features $X$ and the output of graph attention layers $\hat{U}$. The final output of the encoder would be $H = [X,g(A,X)]$. In addition, the decoders of the example embodiment output the probability that two nodes are connected by an edge. In the example of Figure 2I, decoders are used for predicting connectivities, non-connection adjacencies, and a combination of either connectivities or non-connection adjacencies. The two decoders $d_1$ and $d_2$ for predicting connectivity edges and non-connection adjacency edges have the same structure, with each containing two fully connected layers, giving predicted outputs for connectivity edges and non-connection adjacency edges of $P_1 = d_1(H)$, and $P_2 = d_2(H)$, respectively. Then the connectivity edge predictions and non-connection adjacency edge predictions are aggregated by a fully connected layer to predict a combination of either connectivities or non-connection adjacencies. $P_1$ and $P_2$ are concatenated and fed into another decoder $d_3$, which provided predicted outputs $P_3 = d_3([P_1,P_2])$ for edges that are a combination of either connectivities or non-connection adjacencies.

In these example embodiments, one or more machine learning models are trained to predict different types of connections (i.e., connectivity edges, non-connection adjacency edges, and a combination of either connectivity edges or non-connection adjacency edges) given building information *(e.g.,* determined room attributes). As one example, let $A$ be the adjacency matrix of the initial adjacency graph generated from initial edges of a floor plan that are a combination of either connectivity edges or non-connection adjacency edges - a subset of edges are then randomly removed to generate an incomplete adjacency matrix $A$. The removed edges are denoted $E_{pos}$ as positive edges, and the same amount of negative edges $E_{neg}$ are then randomly sampled, which means the two rooms are not connected. Each positive edge is composed of a node pair $(i,j)$ such that $A(i,j) = 1$, and each negative edge is composed of a node pair $(i,j)$ such that $A(i,j) = 0$. Positive and negative edges are sampled for all of connectivity edges, non-connection adjacency edges, and a combination of either connectivity edges or non-connection adjacency edges. Given the node attributes $X$ and the incomplete adjacency matrix $\overline{A}$, the one or more machine learning models are trained on all types of positive and negative edges, and optimized by minimizing the binary cross entropy loss between the prediction and the corresponding ground truth.

Various details have been provided with respect to Figures 2A-2K, but it will be appreciated that the provided details are non-exclusive examples included for illustrative purposes, and other embodiments may be performed in other manners without some or all such details.

As noted above, in some embodiments, the described techniques include using machine learning to learn the attributes and/or other characteristics of adjacency graphs to encode in corresponding embedding vectors that are generated, such as the attributes and/or other characteristics that best enable subsequent automated identification of building floor plans having attributes satisfying target criteria, and with the embedding vectors that are used in at least some embodiments to identify target building floor plans being encoded based on such learned attributes or other characteristics. In particular, in at least some such embodiments, graph representation learning is used to search for a mapping function that can map the nodes in a graph to d-dimensional vectors, such that in the learned space similar nodes in the graph have similar embeddings. Unlike traditional methods such as graph kernel methods (see, *for example,* "Graph Kernels" by S.V.N. Vishwanathan et al., Journal of Machine Learning Research, 11:1201-1242, 2010; and "A Survey On Graph Kernels", Nils M. Kriege et al., arXiv:1903.11835, 2019), graph neural networks remove the process of hand-engineered features and directly learn the high-level embeddings from the raw features of nodes or the (sub)graph.

Various techniques exist for extending and re-defining convolutions in the graph domain, which can be categorized into the spectral approach and the spatial approach. The spectral approach employs the spectral representation of a graph, and are specific to a particular graph structure, such that the models trained on one graph are not applicable to a graph with a different structure *(see, for example,* "Spectral Networks And Locally Connected Networks On Graphs", Joan Bruna et al., International Conference on Learning Representations 2014, 2014; "Convolutional Neural Networks On Graphs With Fast Localized Spectral Filtering", Michael Defferrard et al., Proceedings of Neural Information Processing Systems 2016, 2016, pp. 3844-3852; and "Semi-Supervised Classification With Graph Convolutional Networks", Thomas N. Kipf et al., International Conference on Learning Representations 2017, 2017). The convolution operation for the spectral approach is defined in the Fourier domain by computing the eigendecomposition of the graph Laplacian, and the filter may be approximated to reduce the expensive eigen-decomposition by Chebyshev expansion of graph Lapacian, generating local filters, with the filters optionally limited to work on neighbors one step away from the current node.

With respect to the spatial approach, it includes learning embeddings for a node by recursively aggregating information from its local neighbors. Various amounts of neighboring nodes and corresponding aggregation functions can be handled in various ways. For example, a fixed number of neighbors for each node may be sample, and different aggregation functions such as mean, max and long short term memory networks (LSTM) may be used (see, *for example,* "Inductive Representation Learning On Large Graphs", Will Hamilton et al., Proceedings of Neural Information Processing Systems 2017, 2017, pp. 1024-1034). Alternatively, each neighboring node may be considered to contribute differently to a central node, with the contribution factors being learnable via self-attention models (see, *for example,* "Graph Attention Networks", P. Velickovic et al., International Conference on Learning Representations 2018, 2018). Furthermore, each attention head captures feature correlation in a different representation subspace, and may be treated differently, such as by using a convolutional sub-network to weight the importance of each attention head (see, *for example,* "GaAN: Gated Attention Networks For Learning On Large And Spatiotemporal Graphs", Jiani Zhang et al., Proceedings of Uncertainty in Artificial Intelligence 2018, 2018).

In addition, in some embodiments, the creation of an adjacency graph and/or associated embedding vector for a building may be further based in part on partial information that is provided for the building *(e.g.,* by an operator user of the FPSDM system, by one or more end users, etc.). Such partial information may include, for example, one or more of the following: some or all room names for rooms of the building being provided, with the connections between the rooms to be automatically determined or otherwise established; some or all inter-room connections between rooms of the building being provided, with likely room names for the rooms to be automatically determined or otherwise established; some room names and inter-room connections being provided, with the other inter-room connections and/or likely room names to be automatically determined or otherwise established. In such embodiments, the automated techniques may include using partial information as part of completing or otherwise generating a building floor plan, with the floor plan subsequently used for creating a corresponding adjacency graph and/or embedding vector.

Figure 3 is a block diagram illustrating an embodiment of one or more server computing systems 300 executing an implementation of a FPSDM system 340, and one or more server computing systems 380 executing an implementation of a ICA system 388 and an MIGM system 389 - the server computing system(s) and FPSDM and/or ICA and/or MIGM systems may be implemented using a plurality of hardware components that form electronic circuits suitable for and configured to, when in combined operation, perform at least some of the techniques described herein. One or more computing systems and devices may also optionally be executing a Building Map Viewer system 345 (such as server computing system(s) 300 in this example) and/or optional other programs 335 and 383 (such as server computing system(s) 300 and 380, respectively, in this example). In the illustrated embodiment, each server computing system 300 includes one or more hardware central processing units ("CPUs") or other hardware processors 305, various input/output ("I/O") components 310, storage 320, and memory 330, with the illustrated I/O components including a display 311, a network connection 312, a computer-readable media drive 313, and other I/O devices 315 *(e.g.,* keyboards, mice or other pointing devices, microphones, speakers, GPS receivers, etc.). Each server computing system 380 may have similar components, although only one or more hardware processors 381, memory 387, storage 384 and I/O components 382 are illustrated in this example for the sake of brevity.

The server computing system(s) 300 and executing FPSDM system 340, server computing system(s) 380 and executing ICA and MIGM systems 388-389, and executing Building Map Viewer system 345, may communicate with each other and with other computing systems and devices in this illustrated embodiment, such as via one or more networks 399 *(e.g.,* the Internet, one or more cellular telephone networks, etc.), including to interact with user client computing devices 390 *(e.g.,* used to view floor maps, and optionally associated images and/or other related information, such as by executing a copy of the Building Map Viewer system, not shown), and/or mobile video acquisition devices 360 *(e.g.,* used to acquire video and optionally additional images and/or other information for buildings or other environments to be modeled), and/or optionally other navigable devices 395 that receive and use floor maps and optionally other generated information for navigation purposes *(e.g.,* for use by semi-autonomous or fully autonomous vehicles or other devices). In other embodiments, some of the described functionality may be combined in less computing systems, such as to combine the FPSDM system 340 and the Building Map Viewer System 345 in a single system or device, to combine the FPSDM system 340 and the video acquisition functionality of device(s) 360 in a single system or device, to combine the ICA and MIGM systems 388-389 and the video acquisition functionality of device(s) 360 in a single system or device, to combine the FPSDM system 340 and the ICA and MIGM systems 388-389 in a single system or device, to combine the FPSDM system 340 and the ICA and MIGM systems 388-389 and the video acquisition functionality of device(s) 360 in a single system or device, etc.

In the illustrated embodiment, an embodiment of the FPSDM system 340 executes in memory 330 of the server computing system(s) 300 in order to perform at least some of the described techniques, such as by using the processor(s) 305 to execute software instructions of the system 340 in a manner that configures the processor(s) 305 and computing system 300 to perform automated operations that implement those described techniques. The illustrated embodiment of the FPSDM system may include one or more components, not shown, to each perform portions of the functionality of the FPSDM system, and the memory may further optionally execute one or more other programs 335 - as one specific example, a copy of the ICA and/or MIGM systems may execute as one of the other programs 335 in at least some embodiments, such as instead of or in addition to the ICA and/or MIGM systems 388-389 on the server computing system(s) 380. The FPSDM system 340 may further, during its operation, store and/or retrieve various types of data on storage 320 *(e.g.,* in one or more databases or other data structures), such as various types of user information 322, floor plans and other associated information 324 *(e.g.,* generated and saved 2.5D and/or 3D models, building and room dimensions for use with associated floor plans, additional images and/or annotation information, etc.), generated floor plan adjacency graphs and/or associated embedding vectors 326, and/or various types of optional additional information 329 *(e.g.,* various analytical information related to presentation or other use of one or more building interiors or other environments).

In addition, an embodiment of the ICA and MIGM systems 388-389 execute in memory 387 of the server computing system(s) 380 in the illustrated embodiment in order to perform techniques related to generating linked panorama images and floor plans for buildings, such as by using the processor(s) 381 to execute software instructions of the systems 388 and/or 389 in a manner that configures the processor(s) 381 and computing system(s) 380 to perform automated operations that implement those techniques. The illustrated embodiment of the ICA and MIGM systems may include one or more components, not shown, to each perform portions of the functionality of the ICA and MIGM systems, respectively, and the memory may further optionally execute one or more other programs 383. The ICA and/or MIGM systems 388-389 may further, during operation, store and/or retrieve various types of data on storage 384 *(e.g.,* in one or more databases or other data structures), such as video and/or image information 386 acquired for one or more buildings *(e.g.,* 360° video or images for analysis to generate floor maps, to provide to users of client computing devices 390 for display, etc.), floor plans and/or other generated mapping information 387, other information 385 *(e.g.,* additional images and/or annotation information for use with associated floor plans, building and room dimensions for use with associated floor plans, various analytical information related to presentation or other use of one or more building interiors or other environments, etc.) - while not illustrated in Figure 3, the ICA and/or MIGM systems may further store and use additional types of information, such as about other types of building information to be analyzed and/or provided to the FPSDM system, about ICA and/or MIGM system operator users and/or end-users, etc.

Some or all of the user client computing devices 390 (*e.g*., mobile devices), mobile image acquisition devices 360, optional other navigable devices 395 and other computing systems (not shown) may similarly include some or all of the same types of components illustrated for server computing system 300. As one non-limiting example, the mobile image acquisition devices 360 are each shown to include one or more hardware CPU(s) 361, I/O components 362, storage 364, and memory 367, one or more imaging systems 365 and IMU hardware sensors 369 *(e.g.,* for use in acquisition of video and/or images, associated device movement data, etc.). In the illustrated example, one or both of a browser and one or more client applications 368 *(e.g.,* an application specific to the FPSDM system and/or to ICA system and/or to the MIGM system) are executing within memory 367, such as to participate in communication with the FPSDM system 340, ICA system 388, MIGM system 389 and/or other computing systems. While particular components are not illustrated for the other navigable devices 395 or other computing devices/systems 390, it will be appreciated that they may include similar and/or additional components.

It will also be appreciated that computing systems 300 and 380 and the other systems and devices included within Figure 3 are merely illustrative and are not intended to limit the scope of the present invention. The systems and/or devices may instead each include multiple interacting computing systems or devices, and may be connected to other devices that are not specifically illustrated, including via Bluetooth communication or other direct communication, through one or more networks such as the Internet, via the Web, or via one or more private networks *(e.g.,* mobile communication networks, etc.). More generally, a device or other computing system may comprise any combination of hardware that may interact and perform the described types of functionality, optionally when programmed or otherwise configured with particular software instructions and/or data structures, including without limitation desktop or other computers *(e.g.,*

tablets, slates, etc.), database servers, network storage devices and other network devices, smart phones and other cell phones, consumer electronics, wearable devices, digital music player devices, handheld gaming devices, PDAs, wireless phones, Internet appliances, and various other consumer products that include appropriate communication capabilities. In addition, the functionality provided by the illustrated FPSDM system 340 may in some embodiments be distributed in various components, some of the described functionality of the FPSDM system 340 may not be provided, and/or other additional functionality may be provided.

It will also be appreciated that, while various items are illustrated as being stored in memory or on storage while being used, these items or portions of them may be transferred between memory and other storage devices for purposes of memory management and data integrity. Alternatively, in other embodiments some or all of the software components and/or systems may execute in memory on another device and communicate with the illustrated computing systems via inter-computer communication. Thus, in some embodiments, some or all of the described techniques may be performed by hardware means that include one or more processors and/or memory and/or storage when configured by one or more software programs *(e.g.,* by the FPSDM system 340 executing on server computing systems 300, by the Building Map Viewer System 345 executing on server computing systems 300 or other computing systems/devices, etc.) and/or data structures, such as by execution of software instructions of the one or more software programs and/or by storage of such software instructions and/or data structures, and such as to perform algorithms as described in the flow charts and other disclosure herein. Furthermore, in some embodiments, some or all of the systems and/or components may be implemented or provided in other manners, such as by consisting of one or more means that are implemented partially or fully in firmware and/or hardware *(e.g.,* rather than as a means implemented in whole or in part by software instructions that configure a particular CPU or other processor), including, but not limited to, one or more application-specific integrated circuits (ASICs), standard integrated circuits, controllers *(e.g.,* by executing appropriate instructions, and including microcontrollers and/or embedded controllers), field-programmable gate arrays (FPGAs), complex programmable logic devices (CPLDs), etc. Some or all of the components, systems and data structures may also be stored *(e.g.,* as software instructions or structured data) on a non-transitory computer-readable storage mediums, such as a hard disk or flash drive or other non-volatile storage device, volatile or non-volatile memory *(e.g.,* RAM or flash RAM), a network storage device, or a portable media article *(e.g.,* a DVD disk, a CD disk, an optical disk, a flash memory device, etc.) to be read by an appropriate drive or via an appropriate connection. The systems, components and data structures may also in some embodiments be transmitted via generated data signals *(e.g.,* as part of a carrier wave or other analog or digital propagated signal) on a variety of computer-readable transmission mediums, including wireless-based and wired/cable-based mediums, and may take a variety of forms *(e.g.,* as part of a single or multiplexed analog signal, or as multiple discrete digital packets or frames). Such computer program products may also take other forms in other embodiments. Accordingly, embodiments of the present disclosure may be practiced with other computer system configurations.

Figure 4 illustrates an example flow diagram of an embodiment of an ICA System routine 400. The routine may be performed by, for example, the ICA System 160 of Figure 1A, the ICA System 388 of Figure 3, and/or an ICA system as otherwise described herein, such as to acquire 360° panorama images and/or other images or video at acquisition locations within buildings or other structures, such as for use in subsequent generation of related floor plans and/or other mapping information. While portions of the example routine 400 are discussed with respect to acquiring particular types of images at particular acquisition locations, it will be appreciated that this or a similar routine may be used to acquire video or other data *(e.g.,* audio), whether instead of or in addition to such images. In addition, while the illustrated embodiment acquires and uses information from the interior of a target building, it will be appreciated that other embodiments may perform similar techniques for other types of data, including for non-building structures and/or for information external to one or more target buildings of interest. Furthermore, some or all of the routine may be executed on a mobile device used by a user to acquire image information, and/or by a system remote from such a mobile device.

The illustrated embodiment of the routine begins at block 405, where instructions or information are received. At block 410, the routine determines whether the received instructions or information indicate to acquire data representing a building interior, and if not continues to block 490. Otherwise, the routine proceeds to block 412 to receive an indication *(e.g.,* from a user of a mobile image acquisition device) to begin the image acquisition process at a first acquisition location. After block 412, the routine proceeds to block 415 in order to perform acquisition location image acquisition activities in order to acquire a 360° panorama image for the acquisition location in the interior of the target building of interest, such as to provide horizontal coverage of at least 360° around a vertical axis. The routine may also optionally obtain annotation and/or other information from a user regarding the acquisition location and/or the surrounding environment, such as for later use in presentation of information regarding that acquisition location and/or surrounding environment.

After block 415 is completed, the routine continues to block 420 to determine if there are more acquisition locations at which to acquire images, such as based on corresponding information provided by the user of the mobile device. If so, the routine continues to block 422 to optionally initiate the capture of linking information (such as acceleration data) during movement of the mobile device along a travel path away from the current acquisition location and towards a next acquisition location within the building interior. As described elsewhere herein, the captured linking information may include additional sensor data *(e.g.,* from one or more IMU, or inertial measurement units, on the mobile device or otherwise carried by the user) and/or additional video information, recorded during such movement. Initiating the capture of such linking information may be performed in response to an explicit indication from a user of the mobile device or based on one or more automated analyses of information recorded from the mobile device. In addition, the routine may further optionally monitor the motion of the mobile device in some embodiments during movement to the next acquisition location, and provide one or more guidance cues to the user regarding the motion of the mobile device, quality of the sensor data and/or video information being captured, associated lighting/environmental conditions, advisability of capturing a next acquisition location, and any other suitable aspects of capturing the linking information. Similarly, the routine may optionally obtain annotation and/or other information from the user regarding the travel path, such as for later use in presentation of information regarding that travel path or a resulting inter-panorama connection link. In block 424, the routine determines that the mobile device has arrived at the next acquisition location *(e.g.,* based on an indication from the user, based on the forward movement of the user stopping for at least a predefined amount of time, etc.), for use as the new current acquisition location, and returns to block 415 in order to perform the acquisition location image acquisition activities for the new current acquisition location.

If it is instead determined in block 420 that there are not any more acquisition locations at which to acquire image information for the current building or other structure, the routine proceeds to block 425 to optionally analyze the acquisition location information for the building or other structure, such as to identify possible additional coverage (and/or other information) to acquire within the building interior. For example, the ICA system may provide one or more notifications to the user regarding the information acquired during capture of the multiple acquisition locations and optionally corresponding linking information, such as if it determines that one or more part of the recorded information are of insufficient or undesirable quality, or do not appear to provide complete coverage of the building *(e.g.,* for one or more further acquisition locations that at which image acquisition has not occurred), and if so the routine may return to block 422 to initiate additional corresponding data acquisition activities. After block 425, if the routine does not return to block 422, the routine continues instead to block 435 to optionally preprocess the acquired 360° panorama images before their subsequent use for generating related mapping information. In block 477, the images and any associated generated or obtained information is stored for later use. Figures 5A-5B illustrate one example of a routine for generating a floor plan representation of a building interior from such generated panorama information.

If it is instead determined in block 410 that the instructions or other information recited in block 405 are not to acquire images and other data representing a building interior, the routine continues instead to block 490 to perform any other indicated operations as appropriate, such as any housekeeping tasks, to configure parameters to be used in various operations of the system *(e.g.,* based at least in part on information specified by a user of the system, such as a user of a mobile device who captures one or more building interiors, an operator user of the ICA system, etc.), to obtain and store other information about users of the system, to respond to requests for generated and stored information, etc.

Following blocks 477 or 490, the routine proceeds to block 495 to determine whether to continue, such as until an explicit indication to terminate is received, or instead only if an explicit indication to continue is received. If it is determined to continue, the routine returns to block 405 to await additional instructions or information, and if not proceeds to step 499 and ends.

Figures 5A-5B illustrate an example embodiment of a flow diagram for a Mapping Information Generation Manager (MIGM) System routine 500. The routine may be performed by, for example, execution of the MIGM system 160 of Figure 1A, the MIGM system 389 of Figure 3, and/or an MIGM system as described elsewhere herein, such as to generate a floor plan and optionally other mapping information *(e.g.,* a 3D computer model) for a defined area based at least in part on images of the area. In the example of Figures 5A-5B, the generated mapping information includes a 2D floor plan and 3D computer model of a building, such as a house, but in other embodiments, other types of mapping information may be determined and generated for other types of buildings and used in other manners, as discussed elsewhere herein.

The illustrated embodiment of the routine begins at block 505, where information or instructions are received. The routine continues to block 510 to determine whether the instructions received in block 505 indicate to generate mapping information for an indicated building, and if so the routine continues to perform blocks 515-588 to do so, and otherwise continues to block 590.

In block 515, the routine determines whether image information is already available for the building, or if such information instead needs to be acquired. If it is determined in block 515 that the information needs to be acquired, the routine continues to block 520 to acquire such information, optionally waiting for one or more users or devices to move throughout the building and acquire panoramas or other images at multiple acquisition locations in multiple rooms of the building, and to optionally further analyze the images and/or metadata information about their acquisition to interconnect the images, as discussed in greater detail elsewhere herein - Figure 4 provides one example embodiment of an ICA system routine for performing such image acquisition. If it is instead determined in block 515 that it is not necessary to acquire the images, the routine continues instead to block 530 to obtain existing panoramas or other images from multiple acquisition locations in multiple rooms of the building, optionally along with interconnection information for the images and acquisition of metadata information related to movement between the acquisition locations, such as may in some situations have been supplied in block 505 along with the corresponding instructions.

After blocks 520 or 530, the routine continues to block 535 to optionally obtain additional information about the building (whether based on activities performed during initial image acquisition and/or afterwards), such as based on acquired annotation information and/or information from one or more external sources (*e.g.,* online databases, information provided by one or more end-users, etc.) and/or information from analysis of acquired images (*e.g.,* initial panorama images and/or additional images, such as for additional images at locations different from acquisition locations of the initial panorama images) - such additional obtained information may include, for example, exterior dimensions and/or shape of the building, information about built-in features (*e.g.,* a kitchen island), information about installed fixtures and/or appliances (*e.g.,* kitchen appliances, bathroom items, etc.); information about visual appearance information for building interior locations (*e.g.,* color and/or material type and/or texture for installed items such as floor coverings or wall coverings or surface coverings), information about views from particular windows or other building locations, other information about areas external to the building (*e.g.,* other associated buildings or structures, such as sheds, garages, pools, decks, patios, walkways, gardens, etc.; a type of an external space; items present in an external space; etc.).

After block 535, the routine continues to block 550 to determine, for each room inside the building with one or more acquisition locations and associated acquired images, a room shape of the room from data in the image(s) taken inside the room, and optionally a position within the room of its acquisition location(s), such as in an automated manner. In block 555, the routine further uses visual data in the images and/or the acquisition metadata for them to determine, for each room in the building, any connecting passages in or out of the room (*e.g.,* in an automated manner). In block 560, the routine further uses visual data in the images and/or the acquisition metadata for them to determine, for each room in the building, any wall elements in the room and their positions (*e.g.,* in an automated manner), such as for windows, inter-wall borders, etc. It will be appreciated that, while blocks 550-560 are illustrated as separate operations in this example, in some embodiments a single analysis of the images may be performed to acquire or determine multiple types of information, such as those discussed with respect to blocks 550-560.

In block 565, the routine then determines estimated positions of the room shapes to create an initial 2D floor plan, such as by connecting inter-room passages in their respective rooms, by optionally positioning room shapes around determined acquisition location positions (*e.g.,* if the acquisition location positions are inter-connected), and by optionally applying one or more constraints or optimizations. Such a floor plan may include, for example, relative position and shape information for the various rooms without providing any actual dimension information for the individual rooms or building as a whole, and may further include multiple linked or associated sub-maps (*e.g.,* to reflect different stories, levels, sections, etc.) of the building. The routine further associates positions of the doors, wall openings and other identified wall elements on the floor plan.

After block 565, the routine optionally performs one or more steps 575-580 to determine and associate additional information with the floor plan. In block 575, the routine optionally estimates the dimensions of some or all of the rooms, such as from analysis of images and/or their acquisition metadata or from overall dimension information obtained for the exterior of the building, and associates the estimated dimensions with the floor plan - it will be appreciated that if sufficiently detailed dimension information were available, architectural drawings, blue prints, etc. may be generated from the floor plan. After block 575, the routine continues to block 580 to optionally associate further information with the floor plan (*e.g.,* with particular rooms or other locations within the building), such as additional images and/or annotation information. In block 585, the routine further estimates heights of walls in some or all rooms, such as from analysis of images and optionally sizes of known objects in the images, as well as height information about a camera when the images were acquired, and further uses such information to generate a 3D computer model of the building, with the 3D model and the floor plan being associated with each other.

After block 585, the routine continues to block 588 to store the generated mapping information and optionally other generated information, and to optionally further use the generated mapping information, such as to provide the generated 2D floor plan and/or 3D computer model for display on one or more client devices, to provide that generated information to one or more other devices for use in automating navigation of those devices and/or associated vehicles or other entities, etc.

If it is instead determined in block 510 that the information or instructions received in block 505 are not to generate mapping information for an indicated building, the routine continues instead to block 590 to perform one or more other indicated operations as appropriate. Such other operations may include, for example, receiving and responding to requests for previously generated computer models and/or floor plans and/or other generated information (*e.g.,* requests for such information for use by an FPSDM system, requests for such information for display on one or more client devices, requests for such information to provide it to one or more other devices for use in automated navigation, etc.), obtaining and storing information about buildings for use in later operations (*e.g.,* information about dimensions, numbers or types of rooms, total square footage, adjacent or nearby other buildings, adjacent or nearby vegetation, exterior images, etc.), etc.

After blocks 588 or 590, the routine continues to block 595 to determine whether to continue, such as until an explicit indication to terminate is received, or instead only if an explicit indication to continue is received. If it is determined to continue, the routine returns to block 505 to wait for and receive additional instructions or information, and otherwise continues to block 599 and ends.

Figures 6A-6B illustrate an example embodiment of a flow diagram for a Floor Plan Similarity Determination Manager (FPSDM) System routine 600. The routine may be performed by, for example, execution of the FPSDM system 140 of Figure 1A, the FPSDM system 340 of Figure 3, and/or an FPSDM system as described with respect to Figures 2D-2K and elsewhere herein, such as to perform automated operations related to predicting information for building floor plans (*e.g.,* room types, types of inter-room connections, etc.), to identifying building floor plans that have attributes satisfying target criteria, and to provide information about the identified floor plans for subsequent use in one or more automated manners. In the example embodiment of Figures 6A-6B, the floor plans are for houses or other buildings, and the analysis of floor plan information includes generating and using corresponding adjacency graphs and in some cases embedding vectors, along with using trained neural networks or other trained machine learning models to predict certain floor plan information, but in other embodiments, other types of data structures and analyses may be used for other types of structures or for non-structure locations, and the identified buildings and/or their floor plans may be used in other manners than those discussed with respect to routine 600, as discussed elsewhere herein. In addition, while the example embodiment of the routine may use adjacency graphs and/or embedding vectors and/or other specified criteria (*e.g.,* search terms) to identify building floor plans that match or otherwise are similar to that information, other embodiments of the routine may use only one such type of information and/or may use other additional types of information and analyses.

The illustrated embodiment of the routine begins at block 605, where information or instructions are received. The routine continues to block 610 to determine whether the instructions or other information received in block 605 indicate to use one or more indicated initial buildings to determine one or more other similar target buildings, and if so the routine continues to perform blocks 615-660 to do so, and otherwise continues to block 670.

In block 615, for each of the one or more indicated initial buildings (*e.g.,* as identified in the instructions or information received in block 605), the routine performs several activities as part of determining the similarity of those indicated building(s) to various other building *(e.g.,* from a database or other group of stored floor plans and associated information for various buildings, which optionally include other initial buildings previously supplied to the routine 600). In the illustrated example, the activities performed by the routine in block 615 for each indicated building include generating or otherwise obtaining information (e.g., retrieving stored information) to represent the building, such as to represent some or all information from a floor plan for the building in an adjacency graph that includes information about room adjacency and/or interconnectedness and about various other room and building attributes, and/or in an embedding vector that represents some or all of the building information in a compact form. If the representative information for the building is not already generated and available for retrieval, the techniques may include obtaining a floor plan for the building that includes information about locations of doors and other inter-room openings, windows, etc., room labels and/or types, and any other available building information that is associated with the floor plan (*e.g.,* images and/or other information acquired in one or more rooms of the building). The activities performed by the routine in block 615 for each indicated building may further include associating the other available building information (if any) with corresponding room(s) and inter-room openings of the floor plan for the building, if not already done, and optionally analyzing the acquired other building information to determine additional attributes for a corresponding room or inter-room opening (or for the building as a whole), with those additional determined attributes then also associated with the building floor plan (*e.g.,* with corresponding rooms or inter-room openings, or with the building as a whole). The activities performed by the routine in block 615 for each indicated building may further include generating an adjacency graph for the building floor plan that includes nodes for the rooms (and optionally for other areas, such as adjacent spaces external to the building, including areas outside of doors or other openings from the building to the exterior), and with edges representing inter-room connectivity (*e.g.,* based on doors or other inter-room openings between rooms) and/or other inter-room adjacency, and with attributes from the floor plan and its associated additional information being stored with or otherwise associated with the corresponding nodes and edges for the rooms and inter-room connections/adjacencies in the adjacency graph. The activities performed by the routine in block 615 for each indicated building may further include optionally providing the adjacency graph for the building to one or more trained classification neural network(s) that each classify the building floor plan according to one or more subjective factors (*e.g.,* accessibility friendly, an open floor plan, an atypical floor plan, etc.), and similarly storing any resulting classification attributes with the floor plan and its adjacency graph.

After block 615, the routine continues to block 617 to determine whether to use information from block 615 to generate predictions of one or more types of additional representative information for the indicated buildings, such as to add new information to the indicated buildings' floor plans and/or adjacency graphs, and/or to correct or otherwise supplement existing information in the indicated buildings' floor plans and/or adjacency graphs, and if not continues to block 620. Otherwise, the routine continues to block 619 to, for each indicated building, provide the indicated building's adjacency graph and/or a subset of information from it to one or more trained machine learning models (*e.g.,* one or more trained neural networks) to obtain predictions about one or more types of information for the indicated building. In the illustrated embodiment, the predicted information includes a type of room for some or all rooms in the building and types of inter-room connections between some or all rooms (*e.g.,* connected by a door or other opening, adjacent with an intervening wall but not otherwise connected, not adjacent, etc.), although in other embodiments only one of the two types of information may be predicted, and/or other types of building attribute information may be predicted. The information predicted in block 619 is then used to update the floor plan and adjacency graph for the indicated building.

After block 619, or if it is determined in block 617 not to predict further building information, the routine continues to block 620 to determine whether to compare the indicated initial building(s) to the other buildings using embedding vectors, and if not continues to block 655 to compare pairs of buildings using their adjacency graphs. Otherwise, the routine continues to block 622 to, for each indicated initial building, use representation learning to generate a floor plan embedding vector for the indicated building that concisely represents the information included in the adjacency graph for the building. After block 622, the routine continues to block 625 to, for each of multiple other buildings (*e.g.,* all available/known other buildings, a subset of the available other buildings that satisfy one or more defined tests, a group of other buildings supplied or otherwise indicated in the information received in block 605, etc.), determine a value for a distance (or other measure of difference or similarity) between a stored embedding vector for the other building (or to optionally dynamically generate and use a new embedding vector for that other building, if not previously generated and stored) and the embedding vector for each indicated initial building that was generated in block 622 - if there are multiple indicated initial buildings, the routine further generates a combined distance value (*e.g.,* an average, a cumulative total, etc.) for each other building by combining the determined distance values between that other building and all of the multiple indicated initial buildings. As discussed elsewhere, one or more of various distance metrics may be used to determine the distance values. After block 625, the routine continues to block 635, where it rank orders the multiple other buildings using the distance values determined in block 625 (using the combined distance values if there are multiple indicated initial buildings), and selects one or more best matches to use as the identified target buildings (*e.g.,* all matches above a defined threshold, the single best match, etc., and optionally based on instructions or other information received in block 605), with those selected one or more best matches having the smallest determined distance values (*i.e.,* the highest similarity to the one or more indicated buildings).

If it is instead determined in block 620 to not use embedding vectors for the comparison, the routine continues instead to block 655 where, for each combination of one of multiple other buildings (whether the same other buildings discussed with respect to block 625 or a different group of other buildings, such as a subset of all available other buildings that satisfy one or more criteria that may be the same or different than those used in block 625) and one of the one or more indicated initial buildings, the routine provides information for that other building and that indicated building (*e.g.,* the adjacency graphs for the two buildings, the floor plans for the two buildings, etc.) to one or more trained similarity machine learning models (*e.g.,* one or more trained neural networks) to determine a degree of similarity between the two buildings (*e.g.,* a bi-model yes or no value, from a range or enumeration of multiple possible similarity values, a probability or other likelihood that the two buildings have a similarity above a defined threshold, etc.) - if there are multiple indicated initial buildings, the routine further generates a combined similarity degree value (*e.g.,* an average, a cumulative total, etc.) for each of the other buildings by combining the determined similarity degree values for the other building from all of the multiple indicated initial buildings. After block 655, the routine continues to block 660, where it rank orders the multiple other buildings using the similarity degree values determined in block 655 (using the combined similarity degree values if there are multiple indicated buildings), and selects one or more best matches to use as the identified target buildings (*e.g.,* all matches above a defined threshold, the single best match, etc., and optionally based on instructions or other information received in block 605), with the selected one or more best matches having the largest determined similarity degree values.

If it is instead determined in block 610 not to determine other target buildings that are similar to one or more indicated buildings, the routine continues instead to block 670, where it determines whether the instructions or other information received in block 605 indicate to determine other target buildings that match or are otherwise similar to one or more specified criteria, and if not continues to block 690. In some embodiments and situations (*e.g.,* based on the instructions received in block 605), only other buildings that completely match all specified criteria may be considered, while in other embodiments and situations, other buildings may be considered that are only a partial match to the specified criteria. If it is determined in block 670 to determine other target buildings that match or are otherwise similar to one or more specified criteria, the routine continues instead to block 675 where, for each of multiple other buildings (whether the same other buildings discussed with respect to block 625 or a different group of other buildings, such as a subset of all available other buildings that satisfy one or more tests that may optionally be different than those used in block 625), stored adjacency graph information for the other building (or dynamically generated adjacency graph information for the other building, if not previously generated and stored) is analyzed to determine a degree of match to the specified criteria. It will be appreciated that a variety of matching criteria may be used, as discussed elsewhere herein. After block 675, the routine continues to block 680, where it rank orders the multiple other buildings using the degrees of match determined in block 675, and selects one or more best matches to use as the identified target buildings (*e.g.,* all matches above the defined threshold, a single best match, etc., and optionally based on instructions or other information received in block 605), with the selected one or more best matches having the largest determined degrees of match (*i.e.,* the highest similarity to the one or more specified criteria).

After block 635, 660 or 680, the routine continues to block 688, where it stores some or all of the information determined and generated in blocks 615-680, and returns information about the one or more selected best match target buildings.

If it is instead determined in block 670 that the information or instructions received in block 605 are not to determine one or more other target buildings that match one or more specified criteria, the routine continues instead to block 690 to perform one or more other indicated operations as appropriate. Such other operations may include, for example, receiving and responding to requests for previously identified building floor plan information (*e.g.,* requests for such information for display on one or more client devices, requests for such information to provide it to one or more other devices for use in automated navigation, etc.), training one or more neural networks or other machine learning models to recognize and predict types of floor plan information (*e.g.,* room types, types of inter-room connections, etc.), training one or more neural networks or other machine learning models to recognize similarities between buildings based on similarities in the buildings' information (*e.g.,* floor plans, adjacency graphs, encoding vectors, etc.), training one or more classification neural networks or other machine learning models to classify building floor plans according to one or more subjective factors (*e.g.,* accessibility friendly, an open floor plan, an atypical floor plan, a non-standard floor plan, etc.), using machine learning techniques to learn the attributes and/or other characteristics of adjacency graphs to encode in corresponding embedding vectors that are generated (*e.g.,* the best attributes and/or other characteristics to allow subsequent automated identification of building floor plans that have attributes satisfying target criteria), generating and storing representative information for buildings (*e.g.,* floor plans, adjacency graphs, embedding vectors, etc.) for later use, obtaining and storing information about users of the routine (*e.g.,* search and/or selection preferences of a current user), etc.

After blocks 688 or 690, the routine continues to block 695 to determine whether to continue, such as until an explicit indication to terminate is received, or instead only if an explicit indication to continue is received. If it is determined to continue, the routine returns to block 605 to wait for and receive additional instructions or information, and otherwise continues to block 699 and ends.

Figure 7 illustrates an example embodiment of a flow diagram for a Building Map Viewer system routine 700. The routine may be performed by, for example, execution of a map viewer client computing device 175 and its software system(s) (not shown) of Figure 1A, the Building Map Viewer system 345 and/or a client computing device 390 of Figure 3, and/or a mapping information viewer or presentation system as described elsewhere herein, such as to select one or more building floor plans to display to a user based on userspecific criteria, to receive and display one or more corresponding floor plans and/or other mapping information (*e.g.,* a 3D computer model, a 2.5D computer model, etc.), as well as to optionally display additional information (*e.g.,* images) associated with particular locations in the floor plan(s) or other mapping information. In the example of Figure 7, the presented mapping information is for the interior of a building (such as a house), but in other embodiments, other types of mapping information may be presented for other types of buildings or environments and used in other manners, as discussed elsewhere herein.

The illustrated embodiment of the routine begins at block 705, where instructions or information are received. After block 705, the routine continues to block 750, where it determines whether the instructions or other information received in block 705 indicate to select one or more target buildings for presentation based on one or more indicated other buildings, and if not continues to block 760. Otherwise, the routine continues to block 752, where it obtains indications of one or more initial buildings to use, such as from current user selections (*e.g.,* as currently selected by the user and/or indicated in the information or instructions received in block 705) and/or from one or more buildings previously identified as being of interest to the user (*e.g.,* based on previous user selections or other previous user activities). The routine then invokes the FPSDM routine and supplies information about the one or more indicated initial buildings with corresponding instructions to determine one or more other buildings that are most similar to the initial buildings, and selects a best match target building to further use from the one or more returned other buildings (*e.g.,* the returned other building with the highest similarity rating, or using another selection technique indicated in the instructions or other information received in block 705).

After block 752, or if it was instead determined in block 750 that the instructions or other information received in block 705 are not to select one or more target buildings based on other buildings, the routine continues to block 760 to determine whether the instructions or other information received in block 705 are to select one or more target buildings using specified criteria, and if not continues to block 770, where it obtains an indication of a target building to use from the user (*e.g.,* based on a current user selection, such as from a displayed list or other user selection mechanism; based on information received in block 705; etc.). Otherwise, if it is determined in block 760 to select one or more target buildings from specified criteria, the routine continues instead to block 762, where it obtains indications of one or more search criteria to use, such as from current user selections or as indicated in the information or instructions received in block 705, and then invokes the FPSDM routine and supplies the one or more specified criteria with corresponding instructions to determine one or more buildings that satisfy the search criteria, and then selects a best match target building from the one or more returned buildings (*e.g.,* the returned other building with the highest similarity rating, or using another selection technique indicated in the instructions or other information received in block 705). In some embodiments and situations, the user of the routine 700 may indicate to select target buildings based on both one or more other buildings and one or more specified criteria, and if so both blocks 752 and 762 may be performed, such as with the invocation in block 762 of the FPSDM routine supplying not only the search criteria but also one or more determined other buildings from block 752 for use by the FPSDM routine as the multiple other buildings to consider as potentially satisfying the search criteria. In other embodiments, the user may specify either search criteria or other buildings (but not both), or instead the functionality for only one of the two types of searches may be provided.

After blocks 762 or 770, the routine continues to block 710 to determine whether the instructions or other information received in block 705 are to display information or otherwise present information about a target building (e.g., via a floor plan that includes information about the interior of the target building), such as the target building from blocks 752, 762 or 770, and if not continues to block 790. Otherwise, the routine proceeds to block 712 to obtain the floor plan and/or other generated mapping information (*e.g.,* a 3D computer model) for the target building and optionally indications of associated or linked information for the building interior and/or a surrounding location (*e.g.,* additional images taken within or around the building), and selects an initial view of the retrieved information (*e.g.,* a view of the floor plan, of at least some of the 3D computer model, etc.). In block 715, the routine then displays or otherwise presents the current view of the retrieved information, and waits in block 717 for a user selection. After a user selection in block 717, if it is determined in block 720 that the user selection corresponds to the current target building location (*e.g.,* to change the current view of the displayed mapping information for that target building), the routine continues to block 722 to update the current view in accordance with the user selection, and then returns to block 715 to update the displayed or otherwise presented information accordingly. The user selection and corresponding updating of the current view may include, for example, displaying or otherwise presenting a piece of associated linked information that the user selects (*e.g.,* a particular image associated with a displayed visual indication of a determined acquisition location), changing how the current view is displayed (*e.g.,* zooming in or out; rotating information if appropriate; selecting a new portion of the floor plan and/or 3D computer model to be displayed or otherwise presented, such as with some or all of the new portion not being previously visible, or instead with the new portion being a subset of the previously visible information; etc.).

If it is instead determined in block 710 that the instructions or other information received in block 705 are not to present information representing a building interior, the routine continues instead to block 790 to perform any other indicated operations as appropriate, such as any housekeeping tasks, to configure parameters to be used in various operations of the system (*e.g.,* based at least in part on information specified by a user of the system, such as a user of a mobile device who captures one or more building interiors, an operator user of the FPSDM system, etc.), to obtain and store other information about users of the routine (*e.g.,* presentation and/or search preferences of a current user), to respond to requests for generated and stored information, etc.

Following block 790, or if it is determined in block 720 that the user selection does not correspond to the current target building location, the routine proceeds to block 795 to determine whether to continue, such as until an explicit indication to terminate is received, or instead only if an explicit indication to continue is received. If it is determined to continue (*e.g.,* if the user made a selection in block 717 related to a new target building location to present), the routine returns to block 705 to await additional instructions or information (or to continue on past block 705 if the user made a selection in block 717 related to a new building location to present), and if not proceeds to step 799 and ends. In the illustrated embodiment, the routine in blocks 752 and 762 selects a best match target building to use, optionally from multiple returned other building candidates - in at least some embodiments, a queue of other such returned other buildings that are not first selected as best matches may further be saved and subsequently used (*e.g.,* for the user to consecutively display or otherwise present information for multiple such other buildings), such as with the user selection in block 717 optionally indicating to select and use a next returned other building from such a queue, and if so for the routine to proceed to block 770 in the next iteration of the routine after returning to block 705.

Non-exclusive example embodiments described herein are further described in the following clauses.

A01. A computer-implemented method comprising:

obtaining, by a computing device, and for each of a plurality of houses, information about the house that includes a floor plan for the house having at least shapes and relative positions of rooms of the house;

determining, by the computing device and via analysis of the floor plans for the plurality of houses, characteristics of floor plans associated with one or more indicated subjective attributes;

determining, by the computing device and for each of multiple indicated houses, whether a floor plan for that indicated house has characteristics matching at least some of the determined characteristics to be associated with at least one of the one or more indicated subjective attributes, wherein the multiple indicated houses include one or more houses that are not part of the plurality of houses;
receiving, by the computing device, an indication of one house of the multiple indicated houses and one or more search criteria;
generating, by the computing device, and for the one indicated house by using at least the floor plan of the one indicated house, an adjacency graph that represents the one indicated house and that stores attributes associated with the one indicated house including at least one subjective attribute determined for the one indicated house, wherein the adjacency graph has multiple nodes that are each associated with one of multiple rooms of the one indicated house and stores information about one or more of the attributes that correspond to the associated room, and wherein the adjacency graph further has multiple edges between the multiple nodes that are each between two nodes and represent an adjacency in the one indicated house of the associated rooms for those two nodes;
generating, by the computing device, and using representation learning, an embedding vector to represent information from the adjacency graph that corresponds to a subset of a plurality of attributes of the indicated house including the at least one subjective attribute determined for the one indicated house;
determining, by the computing device, and from multiple other houses of the multiple indicated houses separate from the one indicated house, at least one other house that is similar to the one indicated house and that satisfies the one or more search criteria, including:

determining, by the computing device, and for each of the multiple other houses, a degree of similarity between the generated embedding vector for the one indicated house and an additional embedding vector that is associated with the other house to represent at least some attributes of the other house and that is based at least in part on an additional adjacency graph for the other house, wherein the at least some attributes of the other house include objective attributes about the other house that are able to be independently verified and further include one or more additional subjective attributes for the other house that are predicted by one or more first trained machine learning models and further include room types for at least some rooms of the other house that are predicted by one or more second trained machine learning models and further include inter-room connection types for at least some adjacencies between rooms of the other house that are predicted by one or more third trained machine learning models, and wherein the additional adjacency graph for the other house includes information about adjacencies between the rooms of the other house and further includes information about visual attributes of an interior of the other house that are determined based at least in part on analysis of visual data of one or more images taken in the interior of the other house;
determining, by the computing device, and for each of the multiple other houses, if information in the additional adjacency graph for the other house matches the one or more search criteria, wherein the one or more search criteria include at least one indicated interior visual attribute and include at least one indicated objective attribute and include at least one indicated subjective attribute and include at least one indicated type of adjacency between at least two types of rooms and include at least one indicated type of inter-room connection between at least two types of rooms; and
selecting, by the computing device, one or more of the multiple other houses that each has an associated additional embedding vector with a determined degree of similarity to the generated embedding vector for the one indicated house that is above a determined threshold and that is determined to have information in the additional adjacency graph for that other house matching the one or more search criteria, and using the selected one or more other houses as the determined at least one other house; and

presenting, by the computing device, information about attributes of the determined at least one other house, to enable a determination of one or more relations to the plurality of attributes associated with the indicated house.

A02. The computer-implemented method of clause A01 further comprising:

generating, by the computing device, and for each of the plurality of houses based at least in part on the floor plan for the house, an adjacency graph that represents the house and stores attributes associated with the house, wherein the adjacency graph has multiple nodes that are each associated with one of multiple rooms of the house and stores information about one or more of the attributes associated with the house that correspond to the associated room, and wherein the adjacency graph further has multiple edges between the multiple nodes that are each between two nodes and represents an adjacency in the house of the associated rooms for those two nodes;
learning, by the computing device, the subset of attributes for use in representing houses in embedding vectors, wherein the learning is based at least in part on using graph representation learning to search for a mapping function to map nodes in the adjacency graphs for the plurality of houses to a learned space with d-dimensional vectors in such a manner that similar graph nodes have similar embeddings in the learned space,
and wherein the generating of the embedding vector for the indicated house is performed after the learning and includes using the learned subset of attributes for the generated embedding vector.

A03. A computer-implemented method comprising:

obtaining, by a computing device, information about an indicated building having multiple rooms, including a floor plan determined for the indicated building that includes information about the multiple rooms including at least two-dimensional shapes and relative positions;
generating, by the computing device, and using at least the floor plan, an adjacency graph that represents the indicated building and that stores attributes associated with the indicated building, wherein the adjacency graph has multiple nodes that are each associated with one of the multiple rooms and stores information about one or more of the attributes that correspond to the associated room, and wherein the adjacency graph further has multiple edges between the multiple nodes that are each between two nodes and represent an adjacency in the indicated building of the associated rooms for those two nodes;
generating, by the computing device, and using representation learning, an embedding vector to represent information from the adjacency graph that corresponds to a subset of a plurality of attributes of the indicated building;
determining, by the computing device, and from a plurality of other buildings, at least one other building similar to the indicated building, including:

determining, by the computing device, and for each of the plurality of other buildings, a degree of similarity between the generated embedding vector for the indicated building and an additional embedding vector associated with the other building to represent at least some attributes of the other building; and
selecting, by the computing device, one or more of the plurality of other buildings that each has an associated additional embedding vector with a determined degree of similarity to the generated embedding vector for the indicated building that is above a determined threshold, and using the selected one or more other buildings as the determined at least one other building; and

presenting, by the computing device, information about attributes of the determined at least one other building, to enable a determination of one or more relations to the plurality of attributes associated with the indicated building.

A04. A computer-implemented method comprising:

obtaining, by a computing device, and for each of a plurality of buildings, information about the building that includes a floor plan for the building having at least shapes and relative positions of multiple rooms of the building, and that includes one or more labels for each floor plan of whether it satisfies each of one or more indicated subjective attributes;
learning, by the computing device and via analysis of the floor plans for the plurality of buildings and of the labels included with the floor plans, characteristics of floor plans associated with the one or more indicated subjective attributes;
determining, by the computing device and for each of multiple indicated buildings separate from the plurality of buildings, whether a floor plan for that indicated building has characteristics matching at least some of the determined characteristics so as to be associated with at least one of the one or more indicated subjective attributes;
receiving, by the computing device, one or more search criteria that includes at least one specified subjective attribute of the one or more indicated subjective attributes;
determining, by the computing device, and from the multiple indicated buildings, an indicated building that matches the one or more search criteria, including determining that the indicated building has the at least one specified subjective attribute; and
presenting, by the computing device, information about the indicated building, to enable a determination of one or more relations to the one or more search criteria.

A05. A computer-implemented method comprising:

obtaining, by a computing device, information about an indicated building having multiple rooms, including a floor plan determined for the indicated building that includes at least shapes and relative positions of the multiple rooms;

generating, by the computing device and using at least the floor plan, an adjacency graph that represents the indicated building and stores a plurality of attributes associated with the indicated building, wherein the adjacency graph has multiple nodes that are each associated with one of the multiple rooms and stores information about one or more of the plurality of attributes that correspond to the associated room, and wherein the adjacency graph further has multiple edges between the multiple nodes that are each between two nodes and represents an adjacency in the indicated building of the associated rooms for those two nodes;

determining, by the computing device, and from a plurality of other buildings, one of the other buildings similar to the indicated building, including:

determining, by the computing device, and for each of the plurality of other buildings, a degree of similarity between the generated adjacency graph for the indicated building and an additional adjacency graph that represents the other building and stores at least some attributes of the other building, including submitting the generated and additional adjacency graphs to one or more trained machine learning models that provide the degree of similarity; and

selecting, by the computing device and for use as the determined one other building, one of the plurality of other buildings that has a determined degree of similarity above a determined threshold; and

presenting, by the computing device, information about attributes of the determined one other building, to enable a determination of one or more relations to the plurality of attributes associated with the indicated building.

A06. A computer-implemented method comprising:

obtaining, by a computing device, and for each of a plurality of buildings, information about the building that includes a floor plan for the building having at least shapes and relative positions of multiple rooms of the building;

generating, by the computing device, and for each of the plurality of buildings based at least in part on the floor plan for the building, an adjacency graph that represents the building and stores attributes associated with the building, wherein the adjacency graph has multiple nodes that are each associated with one of the multiple rooms of the building and stores information about one or more of the attributes associated with the building that correspond to the associated room, and wherein the adjacency graph further has multiple edges between the multiple nodes that are each between two nodes and represents an adjacency in the building of the associated rooms for those two nodes;

receiving, by the computing device, one or more search criteria that are based at least in part on an indicated adjacency of at least two types of rooms;

determining, by the computing device and from the plurality of buildings, an indicated building that matches the one or more search criteria, including searching the adjacency graph for the indicated building to identify one or more edges in the adjacency graph representing one or more adjacencies in the indicated building that satisfy the indicated adjacency; and

presenting, by the computing device, information about attributes of the indicated building, to enable a determination of one or more relations to the one or more search criteria.

A07. A computer-implemented method comprising:

obtaining, by a computing device and for each of a plurality of buildings, information about the building that includes a floor plan for the building having at least shapes and relative positions of multiple rooms of the building, and one or more images taken in an interior of the building;

analyzing, by the computing device and for each of the plurality of buildings, the one or more images taken in the interior of the building to identify one or more visual attributes of that interior;

generating, by the computing device and for each of the plurality of buildings using at least the floor plan for that building, an adjacency graph representing the building and storing attributes associated with the building that include the one or more visual attributes of the interior of the building, wherein the adjacency graph has multiple nodes that are each associated with one of the multiple rooms of the building and stores information about one or more attributes that correspond to the associated room, wherein the stored information for at least one of the multiple nodes includes at least one of the visual attributes of the building that relates to the associated room for the at least one node, and wherein the adjacency graph further has multiple edges between the multiple nodes that are each between two nodes and represents an adjacency in the building of the associated rooms for those two nodes;

receiving, by the computing device, one or more search criteria based at least in part on one or more indicated visual attributes of one or more rooms;
determining, by the computing device, that an indicated building of the plurality of buildings matches the one or more search criteria, including searching the adjacency graph of the indicated building to identify at least one of the multiple rooms of the indicated building whose associated node has stored information that includes at least one visual attribute satisfying the one or more indicated visual attributes; and
presenting, by the computing device, information about attributes of the indicated building, to enable a determination of one or more relations to the one or more search criteria.

A08. A computer-implemented method comprising:

obtaining, by a computing device and for each of a plurality of buildings, information about the building that includes a floor plan for the building having at least shapes and relative positions of multiple rooms of the building;
generating, by the computing device and for each of the plurality of buildings using at least the floor plan for that building, an adjacency graph representing the building and storing attributes associated with the building including objective attributes about the building that are able to be independently verified, wherein the adjacency graph has multiple nodes that are each associated with one of the multiple rooms of the building and stores information about one or more attributes that correspond to the associated room, and wherein the adjacency graph further has multiple edges between the multiple nodes that are each between two nodes and represents an adjacency in the building of the associated rooms for those two nodes;
predicting, by the computing device and for each of the plurality of buildings, one or more additional subjective attributes for the building by supplying information about the building to one or more trained machine learning models and receiving output indicating the one or more additional subjective attributes, and updating the adjacency graph for the building to further store information about the one or more additional subjective attributes for the building;
determining, by the computing device and after the updating, that an indicated building of the plurality of buildings matches one or more specified criteria corresponding to at least one indicated subjective attribute and at least one indicated objective attribute, by searching the updated adjacency graph for the indicated building to determine that stored information in that updated adjacency graph satisfies the at least one indicated subjective attribute and the at least one indicated objective attribute; and
presenting, by the computing device, information about attributes of the indicated building, to enable a determination of one or more relations to the one or more specified criteria.

A09. A computer-implemented method comprising:

obtaining, by a computing device and for each of a plurality of buildings, information about the building that includes a floor plan for the building having at least shapes and relative positions of multiple rooms of the building;
generating, by the computing device and for each of the plurality of buildings using at least the floor plan for that building, an adjacency graph representing the building and storing attributes associated with the building including objective attributes about the building that are able to be independently verified, wherein the adjacency graph has multiple nodes that are each associated with one of the multiple rooms of the building and stores information about one or more attributes that correspond to the associated room, and wherein the adjacency graph further has multiple edges between the multiple nodes that are each between two nodes and represents an adjacency in the building of the associated rooms for those two nodes;
predicting, by the computing device and for each of the plurality of buildings, room types for the multiple rooms of the building by supplying information about the building to one or more trained machine learning models and receiving output indicating the room types of the multiple rooms, and updating the adjacency graph for the building to further store information about the room types;
determining, by the computing device and after the updating, that an indicated building of the plurality of buildings matches one or more specified criteria corresponding to at least one indicated room type, by searching the updated adjacency graph for the indicated building to determine that stored information in that updated adjacency graph satisfies the at least one indicated room type; and
presenting, by the computing device, information about attributes of the indicated building, to enable a determination of one or more relations to the one or more specified criteria.

A10. A computer-implemented method comprising:

obtaining, by a computing device and for each of a plurality of buildings, information about the building that includes a floor plan for the building having at least shapes and relative positions of multiple rooms of the building; generating, by the computing device and for each of the plurality of buildings using at least the floor plan for that building, an adjacency graph representing the building and storing attributes associated with the building including objective attributes about the building that are able to be independently verified, wherein the adjacency graph has multiple nodes that are each associated with one of the multiple rooms of the building and stores information about one or more attributes that correspond to the associated room, and wherein the adjacency graph further has multiple edges between the multiple nodes that are each between two nodes and represents an adjacency in the building of the associated rooms for those two nodes;

predicting, by the computing device and for each of the plurality of buildings and for each of the edges representing an adjacency in the adjacency graph for that building between two rooms of that building, a connectivity status of whether the two rooms are connected by an inter-room wall opening by supplying information about that building to one or more trained machine learning models and receiving output indicating that connectivity status, and updating the adjacency graph for that building to further store information about the connectivity status for each of the edges in the adjacency graph for that building;

determining, by the computing device and after the updating, that an indicated building of the plurality of buildings matches one or more specified criteria corresponding to at least one indicated connectivity status between at least two types of rooms, by searching the updated adjacency graph for the indicated building to determine that stored information in that updated adjacency graph satisfies the at least one indicated connectivity status; and

presenting, by the computing device, information about attributes of the indicated building, to enable a determination of one or more relations to the one or more specified criteria.

A11. A computer-implemented method comprising:

obtaining, by a computing device, and for each of a plurality of buildings, information about the building that includes a floor plan for the building having at least shapes and relative positions of multiple rooms of the building;

generating, by the computing device, and for each of the plurality of buildings based at least in part on the floor plan for the building, an adjacency graph that represents the building and stores attributes associated with the building, wherein the adjacency graph has multiple nodes that are each associated with one of the multiple rooms of the building and stores information about one or more of the attributes associated with the building that correspond to the associated room, and wherein the adjacency graph further has multiple edges between the multiple nodes that are each between two nodes and represents an adjacency in the building of the associated rooms for those two nodes;

learning, by the computing device, a subset of attributes to represent buildings based at least in part on using graph representation learning to search for a mapping function to map nodes in the adjacency graphs for the plurality of buildings to a learned space with d-dimensional vectors in such a manner that similar graph nodes have similar embeddings in the learned space;

obtaining, by the computing device, information about an indicated building that is separate from the plurality of buildings and has multiple rooms, including a floor plan determined for the indicated building that includes at least shapes and relative positions of the multiple rooms and that indicates a plurality of attributes associated with the indicated building;

generating, by the computing device, and using representation learning, an embedding vector to represent information about the indicated building that corresponds to the subset of attributes;

determining, by the computing device, that the indicated building matches one or more specified criteria corresponding to one or more of the subset of attributes, by measuring a distance from the generated embedding vector to an additional embedding vector corresponding to the one or more specified criteria; and

presenting, by the computing device, information about attributes of the indicated building, to enable a determination of one or more relations to the one or more specified criteria.

B01. A non-transitory computer-readable medium having stored executable software instructions and/or other stored contents that cause one or more computing systems to perform automated operations to implement the method of any one of clauses A01-A11.

B02. A non-transitory computer-readable medium having stored executable software instructions and/or other stored contents that cause one or more computing systems to perform automated operations to implement described techniques substantially as disclosed herein.

B03. A non-transitory computer-readable medium having stored contents that cause one or more computing systems to perform automated operations, the automated operations including at least:

determining, by the one or more computing systems, information about an indicated building having multiple rooms, including obtaining an embedding vector for the indicated building that is generated to represent at least a subset of a plurality of attributes associated with the indicated building and that is based at least in part on adjacency information for the indicated building including at least one attribute for each of the multiple rooms and further including indications of pairs of the multiple rooms adjacent to each other in the indicated building;
determining, by the one or more computing systems and from a plurality of other buildings, an other building corresponding to the indicated building, including:

determining, by the one or more computing systems and for each of the plurality of other buildings, a measure of a difference between the embedding vector for the indicated building and an additional embedding vector that is associated with the other building to represent at least some attributes of the other building; and
selecting, by the one or more computing systems, one of the plurality of other buildings to use as the determined other building based at least in part on the determined measure of difference between the associated additional embedding vector for the determined other building and the embedding vector for the indicated building; and

providing, by the one or more computing systems, information about attributes of the determined other building, to enable a determination of one or more relations to the plurality of attributes associated with the indicated building.

B04. The non-transitory computer-readable medium of clause B03 wherein the determining of the information about the indicated building includes:

obtaining, by the one or more computing systems, information about the indicated building that includes a floor plan determined for the indicated building based at least in part on analysis of visual data of a plurality of images acquired at multiple acquisition locations within the building, wherein the floor plan has information about the multiple rooms including at least shapes of the multiple rooms and relative positions of the multiple rooms;
generating, by the one or more computing systems and using at least the floor plan, the adjacency information for the indicated building, including an adjacency graph that stores the plurality of attributes and that has multiple nodes each associated with one of the multiple rooms and storing information about one or more of the attributes corresponding to the associated room and that further has multiple edges between the multiple nodes that are each between two nodes and represent an adjacency in the indicated building of the associated rooms for those two nodes; and
generating, by the one or more computing systems and using at least the adjacency graph, the embedding vector to represent information from the adjacency graph corresponding to the subset of the plurality of attributes of the indicated building, including representing information about adjacencies between the multiple rooms of the building.

B05. The non-transitory computer-readable medium of clause B04 wherein the stored contents include software instructions that, when executed by at least one of the one or more computing systems, cause the at least one computing system to perform further automated operations including obtaining the plurality of images, wherein the plurality of images further include one or more images acquired at one or more acquisition locations external to the building, wherein the selecting of the one other building includes using a similarity distance as the measure of difference to measure a degree of similarity for that other building between the associated additional embedding vector for that other building and the embedding vector for the indicated building, and further includes selecting the other building based each of the one or more other buildings being above a defined threshold, and wherein the providing of the information about the attributes of the determined other building includes transmitting the information about the attributes of the determined other building over one or more computer networks to at least one client computing device for display.

B06. The non-transitory computer-readable medium of any one of clauses B03-B05 wherein the automated operations further include receiving, by the one or more computing systems, one or more search criteria and identifying the indicated building based at least in part on the one or more search criteria, and wherein the providing of the information about the attributes of the determined other building includes providing search results for presentation that include the determined other building.

B07. The non-transitory computer-readable medium of clause B06 wherein the one or more search criteria include one or more criteria that are based on adjacency of at least two types of rooms, wherein the embedding vector includes information about adjacencies of the multiple rooms in the indicated building, and wherein the additional embedding vector for the determined other building represents information about adjacencies of rooms in that other building, and the determined measure of difference for that additional embedding vector for the determined other building to the embedding vector for the indicated building is based at least in part on the adjacencies of the multiple rooms in the indicated building and the adjacencies of rooms in that other building.

B08. The non-transitory computer-readable medium of clause B06 wherein the one or more search criteria include one or more criteria that are based on visual attributes of a building interior, wherein the embedding vector includes information about visual attributes of an interior of the indicated building, and wherein the additional embedding vector for the determined other building represents information about additional visual attributes of an interior of that other building, and the determined measure of difference for that additional embedding vector for the determined other building to the embedding vector for the indicated building is based at least in part on the visual attributes of the interior of the indicated building and the additional visual attributes of the interior of that other building.

B09. The non-transitory computer-readable medium of clause B06 wherein the one or more search criteria include one or more criteria that are based on one or more types of exterior views from a building, wherein the embedding vector includes information about views from the indicated building to its surroundings, and wherein the additional embedding vector for the determined other building represents information about additional views from that other building to its surroundings, and the determined measure of difference for that additional embedding vector for the determined other building to the embedding vector for the indicated building is based at least in part on the views from the indicated building to its surroundings and the additional views from that other building to its surroundings.

B10. The non-transitory computer-readable medium of any one of clauses B03-B09 wherein the automated operations further include receiving, by the one or more computing systems, information about the indicated building being associated with a user, wherein the determining of the at least one other building is performed in response to the receiving of the information and includes determining information about the attributes of the determined other building that is personalized to the user, and wherein the providing of the information about the attributes of the determined other building includes presenting to the user the information about the attributes of the determined other building.

B11. The non-transitory computer-readable medium of any one of clauses B03-B10 wherein the determined other building includes multiple other buildings, and wherein the providing of the information about the attributes of the determined other building includes determining, by the one or more computing systems, an expected assessment of at least one of condition or quality or value of the indicated building based at least in part on assessments of the multiple other buildings, and providing information about the determined expected assessment.

B12. The non-transitory computer-readable medium of any one of clauses B03-B11 wherein the adjacency information for the indicated building includes an adjacency graph that stores the plurality of attributes and that has multiple nodes each associated with one of the multiple rooms and storing information about one or more of the attributes corresponding to the associated room and that further has multiple edges between the multiple nodes that are each between two nodes and represent an adjacency in the indicated building of the associated rooms for those two nodes, and wherein the automated operations further include automatically learning, by the one or more computing systems, a subset of some attributes from the plurality of attributes of the indicated building to include in the embedding vector based at least in part on using graph representation learning to search for a mapping function to map nodes in the adjacency graph to a learned space with d-dimensional vectors in such a manner that similar graph nodes have similar embeddings in the learned space, and generating the embedding vector to encode information about the some attributes of the indicated building.

B13. The non-transitory computer-readable medium of any one of clauses B03-B12 wherein the automated operations further include generating, by the one or more computing systems, the embedding vector for the indicated building, including incorporating information in the embedding vector about, for each of the multiple rooms, at least one attribute that corresponds to the room and about information about adjacencies of rooms in the indicated building.

B14. The non-transitory computer-readable medium of clause B13 wherein the generating of the embedding vector further includes incorporating, by the one or more computing systems, information in the embedding vector about visual attributes of an interior of the indicated building that are determined based at least in part on an analysis of one or more images acquired in the interior of the indicated building.

B15. The non-transitory computer-readable medium of clause B13 wherein the generating of the embedding vector further includes incorporating, by the one or more computing systems, information in the embedding vector about views from the indicated building to its surroundings that are determined based on at least one of an analysis of one or more images acquired for the indicated building or information from one or more public records about the surroundings of the indicated building.

B16. The non-transitory computer-readable medium of clause B13 wherein the generating of the embedding vector further includes incorporating, by the one or more computing systems, information in the embedding vector about an exterior of the indicated building that is determined based at least in part on an analysis of one or more images acquired from the exterior of the indicated building.

B17. The non-transitory computer-readable medium of clause B13 wherein the plurality of attributes associated with the indicated building are objective attributes that are independently verifiable, wherein the automated operations further include predicting, by the one or more computing systems, one or more additional subjective attributes by supplying information about the indicated building to one or more trained machine learning models and receiving output indicating the one or more additional subjective attributes, and wherein the generating of the embedding vector further includes incorporating, by the one or more computing systems, information in the embedding vector about the one or more additional subjective attributes and about at least some of the objective attributes.

B18. The non-transitory computer-readable medium of clause B17 wherein the one or more additional subjective attributes include at least one of an atypical floor plan that differs from typical floor plans, or an open floor plan, or an accessible floor plan, or a non-standard floor plan.

B19. The non-transitory computer-readable medium of clause B13 wherein the automated operations further include predicting, by the one or more computing systems, room types of the multiple rooms by supplying information about the indicated building to one or more trained machine learning models and receiving output indicating the room types of the multiple room, and wherein the generating of the embedding vector further includes incorporating, by the one or more computing systems, information in the embedding vector about the room types of the multiple rooms.

B20. The non-transitory computer-readable medium of clause B19 wherein the predicting of the room types of the multiple rooms includes using, by the one or more computing systems and for each of the multiple rooms, information about any adjacencies of that room to any other rooms of the indicated building that are indicated by the adjacency information.

B21. The non-transitory computer-readable medium of clause B13 wherein the automated operations further include predicting, by the one or more computing systems, and for each adjacency in the indicated building between two rooms of the indicated building, a connectivity status of whether the two rooms are connected via an inter-room wall opening by supplying information about the indicated building to one or more trained machine learning models and receiving output indicating the connectivity status for each of the edges, and wherein the generating of the embedding vector further includes incorporating, by the one or more computing systems, information in the embedding vector about the connectivity status for each of the edges.

B22. The non-transitory computer-readable medium of clause B21 wherein the predicting, for each adjacency in the indicated building between two rooms of the indicated building, of the connectivity status includes at least one of predicting a wall between the two rooms without an inter-room wall opening or predicting a doorway between the two rooms or predicting a non-doorway wall opening between the two rooms, and wherein the incorporated information in the embedding vector includes information about the at least one of the predicted wall or the predicted doorway or other predicted non-doorway wall opening.

B23. The non-transitory computer-readable medium of clause B13 wherein the adjacency information for the indicated building includes an adjacency graph that stores the plurality of attributes and that has multiple nodes each associated with one of the multiple rooms and storing information about one or more of the attributes corresponding to the associated room and that further has multiple edges between the multiple nodes that are each between two nodes and represent an adjacency in the indicated building of the associated rooms for those two nodes, wherein the edges of the adjacency graph include one or more connectivity edges that each represents that two rooms whose adjacency is represented by the connectivity edge are connected in the indicated building via a doorway or a non-doorway wall opening, wherein the one or more connectivity edges each further stores information about characteristics of the doorway or the non-doorway wall opening for that connectivity edge, and wherein the generating of the embedding vector further includes incorporating, by the computing device, information in the embedding vector about characteristics of the doorway or the non-doorway wall opening for each of the one or more connectivity edges.

B24. The non-transitory computer-readable medium of clause B13 wherein the automated operations further include generating, by the one or more computing systems, the adjacency information, including generating an adjacency graph that stores the plurality of attributes and that has multiple nodes each associated with one of the multiple rooms and storing information about one or more of the attributes corresponding to the associated room and that further has multiple edges between the multiple nodes that are each between two nodes and represent an adjacency in the indicated building of the associated rooms for those two nodes and that further has one or more additional nodes that each corresponds to at least one of an exterior area outside of the indicated building or an external view from an interior of the building to an exterior of the indicated building and that further has at least one additional edge for each of the one or more additional nodes that connects that additional node to another node of the adjacency graph, and wherein the generating of the embedding vector for the indicated building includes incorporating information in the embedding vector about the at least one of the exterior area or the external view for each of the one or more additional nodes.

B25. The non-transitory computer-readable medium of any one of clauses B03-B24 wherein the automated operations further include receiving information about multiple buildings that include the indicated building and one or more additional indicated buildings, and obtaining a further embedding vector for each of the one or more additional indicated buildings, wherein the determining of the measure of difference is further performed for each of the one or more additional indicated buildings between the further embedding vector for that additional indicated building and the additional embedding vectors for each of the plurality of other buildings, and wherein the selecting of the one or more other buildings is further based on the determined measures of difference between the associated additional embedding vector for each of the one or more other buildings and the further embedding vectors for each of the one or more additional indicated buildings, such that selection of the one or more other buildings is based on aggregate differences for the embedding vector of the indicated building and the further embedding vectors for the additional indicated buildings to the associated additional embedding vector for each of the one or more other buildings.

B26. A non-transitory computer-readable medium having stored contents that cause one or more computing systems to perform automated operations, the automated operations including at least:

determining, by the one or more computing systems and via analysis of floor plans for a plurality of buildings, floor plan characteristics associated with one or more indicated subjective attributes;
determining, by the one or more computing systems and for each of multiple indicated buildings that include one or more buildings separate from the plurality of buildings, whether a floor plan for that indicated building has characteristics matching at least some of the determined characteristics so as to be associated with at least one of the one or more indicated subjective attributes;
determining, by the one or more computing systems, a building from the multiple indicated buildings that has at least one specified subjective attribute of the one or more indicated subjective attributes; and
providing, by the one or more computing systems, information about the determined building, to enable a determination of information related to the at least one specified subjective attribute.

B27. The non-transitory computer-readable medium of clause B26 wherein the stored contents include software instructions that, when executed by at least one of the one or more computing systems, cause the at least one computing system to receive information for the floor plans of the plurality of buildings that includes one or more supplied indications for each floor plan of whether it satisfies each of the one or more indicated subjective attributes, and to perform the determining of the floor plan characteristics by learning the floor plan characteristics based at least in part on the supplied indications for the floor plans of the plurality of buildings, and to perform the providing of the information about the determined building by transmitting the information about the determined building over one or more computer networks to a client computing device of a user for display, wherein the automated operations further include receiving one or more search criteria separate from the at least one specified subjective attribute, and wherein the determining of the building further includes determining that the building further matches the one or more search criteria.

B28. The non-transitory computer-readable medium of clause B26 wherein the at least one specified subjective attribute includes at least one of an atypical floor plan that differs from typical floor plans, or an open floor plan, or an accessible floor plan, or a non-standard floor plan.

B29. A non-transitory computer-readable medium having stored contents that cause one or more computing systems to perform automated operations, the automated operations including at least:

determining, by the one or more computing systems, information about an indicated building having multiple rooms, including obtaining adjacency information for the indicated building that includes a plurality of attributes associated with the indicated building and further includes indications of adjacencies in the indicated building of the multiple rooms, wherein each of the multiple rooms is associated with at least one attribute;
determining, by the one or more computing systems, an other building corresponding to the indicated building, including:

determining by the one or more computing systems, a measure of a difference between the adjacency information for the indicated building and additional adjacency information for the other building that includes at least some attributes of the other building; and
selecting, by the one or more computing systems, the other building to use as the determined other building based at least in part on the determined measure of difference between the additional adjacency information for the other building and the adjacency information for the indicated building; and
providing information about the determined other building, to enable a determination of one or more relations to the plurality of attributes associated with the indicated building.

B30. The non-transitory computer-readable medium of clause B29 wherein the stored contents include software instructions that, when executed by at least one of the one or more computing systems, cause the at least one computing system to perform the determining of the information about the indicated building by:

obtaining information about the indicated building that includes a floor plan determined for the indicated building based at least in part on analysis of visual data of a plurality of images acquired at multiple acquisition locations within the building, wherein the floor plan has information about the multiple rooms including at least shapes and relative positions of the multiple rooms; and
generating, using at least the floor plan, an adjacency graph that includes the adjacency information for the indicated building, wherein the adjacency graph has multiple nodes that are each associated with one of the multiple rooms and stores information about one or more of the plurality of attributes that correspond to the associated room, and wherein the adjacency graph further has multiple edges between the multiple nodes that are each between two nodes and represents an adjacency in the indicated building of the associated rooms for those two nodes,
and wherein the stored instructions include software instructions that, when executed by at least one of the one or more computing systems, cause the at least one computing system to perform the providing of the information about the determined other building by transmitting the information about the determined other building over one or more computer networks to a client computing device for display to a user.

B31. A non-transitory computer-readable medium having stored contents that cause one or more computing systems to perform automated operations, the automated operations including at least:

obtaining, by the one or more computing systems, adjacency information for an indicated building that includes a plurality of attributes associated with the indicated building and further includes indications of adjacencies between multiple rooms of the indicated building, wherein each of the multiple rooms is associated with at least one attribute about the indicated building;
receiving, by the one or more computing systems, one or more criteria that are based at least in part on an indicated adjacency of at least two types of rooms;
determining, by the one or more computing systems, that the indicated building matches the one or more specified criteria, including searching the adjacency information to identify one or more adjacencies in the indicated building that satisfy the indicated adjacency; and
providing, by the one or more computing systems, information about the indicated building, to enable a determination of one or more relations of the indicated building to the one or more specified criteria.

B32. The non-transitory computer-readable medium of clause B31 wherein the stored contents include software instructions that, when executed by at least one of the one or more computing systems, cause the at least one computing system to perform the obtaining of the adjacency information by:

obtaining information about the indicated building that includes a floor plan determined for the indicated building based at least in part on analysis of visual data of a plurality of images acquired at multiple acquisition locations within the indicated building, wherein the floor plan has information about the multiple rooms of the indicated building including at least shapes and relative positions of the multiple rooms; and
generating, using at least the floor plan, an adjacency graph that includes the adjacency information for the indicated building, wherein the adjacency graph has multiple nodes that are each associated with one of the multiple rooms and stores information about one or more of the plurality of attributes associated with the indicated building that correspond to the associated room, and wherein the adjacency graph further has multiple edges between the multiple nodes that are each between two nodes and represents an adjacency in the indicated building of the associated rooms for those two nodes,
and wherein the stored instructions include software instructions that, when executed by at least one of the one or more computing systems, cause the at least one computing system to perform the providing of the information about the indicated building by transmitting the information about the indicated building over one or more computer networks to a client computing device for display to a user.

B33. A non-transitory computer-readable medium having stored contents that cause one or more computing systems to perform automated operations, the automated operations including at least:

obtaining, by the one or more computing systems, information about an indicated building having multiple rooms, including one or more visual attributes of an interior of the indicated building that are determined from analysis of visual data of one or more images taken in that interior, and further including adjacency information for the indicated building that includes a plurality of attributes associated with the indicated building and further includes indications of adjacencies between multiple rooms of the indicated building, wherein each of the multiple rooms is associated with at least one attribute about the indicated building, and wherein at least one of the multiple rooms is associated with at least one of the visual attributes of the indicated building that relates to that room;
receiving, by the one or more computing systems, one or more criteria based at least in part on one or more indicated visual attributes of one or more rooms;
determining, by the one or more computing systems, that the indicated building matches the one or more criteria, including searching the adjacency information to identify at least one of the multiple rooms having associated information that includes at least one visual attribute satisfying the one or more indicated visual attributes; and
providing, by the one or more computing systems, information about the indicated building, to enable a determination of one or more relations to the plurality of attributes associated with the indicated building.

B34. The non-transitory computer-readable medium of clause B33 wherein the stored contents include software instructions that, when executed by at least one of the one or more computing systems, cause the at least one computing system to perform the obtaining of the information about the indicated building by:

obtaining information about the indicated building that includes a floor plan determined for the indicated building based at least in part on analysis of visual data of a plurality of images acquired at multiple acquisition locations within the indicated building, wherein the floor plan has information about the multiple rooms of the indicated building including at least shapes and relative positions of the multiple rooms; and
generating, using at least the floor plan, an adjacency graph that includes the adjacency information for the indicated building, wherein the adjacency graph has multiple nodes that are each associated with one of the multiple rooms and stores information about one or more of the plurality of attributes associated with the indicated building that correspond to the associated room, and wherein the adjacency graph further has multiple edges between the multiple nodes that are each between two nodes and represents an adjacency in the indicated building of the associated rooms for those two nodes,
and wherein the stored instructions include software instructions that, when executed by at least one of the one or more computing systems, cause the at least one computing system to perform the providing of the information about the indicated building by transmitting the information about the indicated building over one or more computer networks to a client computing device for display to a user.

B35. A non-transitory computer-readable medium having stored contents that cause one or more computing systems to perform automated operations, the automated operations including at least:

obtaining, by the one or more computing systems, information about an indicated building having multiple rooms, including adjacency information for the indicated building that includes a plurality of attributes associated with the indicated building and further includes indications of adjacencies between multiple rooms of the indicated building, wherein the plurality of attributes include objective attributes about the indicated building that are able to be independently verified, wherein each of the multiple rooms is associated with at least one attribute about the indicated building, and wherein at least one of the multiple rooms is associated with at least one of the visual attributes of the indicated building that relates to that room;

predicting, by the one or more computing systems, one or more additional subjective attributes for the indicated building, and updating the adjacency information for the indicated building to further store information about the one or more additional subjective attributes for the indicated building;

determining, by the one or more computing systems and after the updating, that the indicated building matches one or more specified criteria corresponding to at least one indicated subjective attribute, by searching the updated adjacency information for the indicated building to determine that stored information in that updated adjacency information satisfies the at least one indicated subjective attribute; and

providing, by the one or more computing systems, information about the indicated building, to enable a determination of one or more relations of the indicated building to the one or more specified criteria.

B36. The non-transitory computer-readable medium of clause B35 wherein the stored contents include software instructions that, when executed by at least one of the one or more computing systems, cause the at least one computing system to perform the obtaining of the information about the indicated building by:

obtaining information about the indicated building that includes a floor plan determined for the indicated building based at least in part on analysis of visual data of a plurality of images acquired at multiple acquisition locations within the indicated building, wherein the floor plan has information about the multiple rooms of the indicated building including at least shapes and relative positions of the multiple rooms; and

generating, using at least the floor plan, an adjacency graph that includes the adjacency information for the indicated building, wherein the adjacency graph has multiple nodes that are each associated with one of the multiple rooms and stores information about one or more of the plurality of attributes associated with the indicated building that correspond to the associated room, and wherein the adjacency graph further has multiple edges between the multiple nodes that are each between two nodes and represents an adjacency in the indicated building of the associated rooms for those two nodes,

and wherein the stored instructions include software instructions that, when executed by at least one of the one or more computing systems, cause the at least one computing system to perform the providing of the information about the indicated building by transmitting the information about the indicated building over one or more computer networks to a client computing device for display to a user.

B37. A non-transitory computer-readable medium having stored contents that cause one or more computing systems to perform automated operations, the automated operations including at least:

obtaining, by the one or more computing systems, information about an indicated building having multiple rooms, including adjacency information for the indicated building that includes a plurality of attributes associated with the indicated building and further includes indications of adjacencies between multiple rooms of the indicated building, wherein each of the multiple rooms is associated with at least one attribute about the indicated building, and wherein at least one of the multiple rooms is associated with at least one of the visual attributes of the indicated building that relates to that room;

predicting, by the one or more computing systems, one or more room types for one or more rooms in the indicated building, and updating the adjacency information for the indicated building to further store information about the one or more room types for the one or more rooms;

determining, by the one or more computing systems and after the updating, that the indicated building matches one or more specified criteria corresponding to at least one indicated room type, by searching the updated adjacency information for the indicated building to determine that stored information in that updated adjacency information satisfies the at least one indicated room type; and

providing, by the one or more computing systems, information about the indicated building, to enable a determination of one or more relations of the indicated building to the one or more specified criteria.

B38. The non-transitory computer-readable medium of clause B37 wherein the stored contents include software instructions that, when executed by at least one of the one or more computing systems, cause the at least one computing system to perform the obtaining of the information about the indicated building by:

obtaining information about the indicated building that includes a floor plan determined for the indicated building based at least in part on analysis of visual data of a plurality of images acquired at multiple acquisition locations within the indicated building, wherein the floor plan has information about the multiple rooms of the indicated building including at least shapes and relative positions of the multiple rooms; and
generating, using at least the floor plan, an adjacency graph that includes the adjacency information for the indicated building, wherein the adjacency graph has multiple nodes that are each associated with one of the multiple rooms and stores information about one or more of the plurality of attributes associated with the indicated building that correspond to the associated room, and wherein the adjacency graph further has multiple edges between the multiple nodes that are each between two nodes and represents an adjacency in the indicated building of the associated rooms for those two nodes,
and wherein the stored instructions include software instructions that, when executed by at least one of the one or more computing systems, cause the at least one computing system to perform the providing of the information about the indicated building by transmitting the information about the indicated building over one or more computer networks to a client computing device for display to a user.

B39. A non-transitory computer-readable medium having stored contents that cause one or more computing systems to perform automated operations, the automated operations including at least:

obtaining, by the one or more computing systems, information about an indicated building having multiple rooms, including adjacency information for the indicated building that includes a plurality of attributes associated with the indicated building and further includes indications of adjacencies between multiple rooms of the indicated building, wherein each of the multiple rooms is associated with at least one attribute about the indicated building, and wherein at least one of the multiple rooms is associated with at least one of the visual attributes of the indicated building that relates to that room;
predicting, by the one or more computing systems, one or more connectivity statuses between two or more rooms in indicated building, and updating the adjacency information for the indicated building to further store information about the one or more connectivity statuses for the two or more rooms;
determining, by the one or more computing systems and after the updating, that the indicated building matches one or more specified criteria corresponding to at least one indicated connectivity status, by searching the updated adjacency information for the indicated building to determine that stored information in that updated adjacency information satisfies the at least one indicated connectivity status; and
providing, by the one or more computing systems, information about the indicated building, to enable a determination of one or more relations of the indicated building to the one or more specified criteria.

B40. The non-transitory computer-readable medium of clause B39 wherein the stored contents include software instructions that, when executed by at least one of the one or more computing systems, cause the at least one computing system to perform the obtaining of the information about the indicated building by:

obtaining information about the indicated building that includes a floor plan determined for the indicated building based at least in part on analysis of visual data of a plurality of images acquired at multiple acquisition locations within the indicated building, wherein the floor plan has information about the multiple rooms of the indicated building including at least shapes and relative positions of the multiple rooms; and
generating, using at least the floor plan, an adjacency graph that includes the adjacency information for the indicated building, wherein the adjacency graph has multiple nodes that are each associated with one of the multiple rooms and stores information about one or more of the plurality of attributes associated with the indicated building that correspond to the associated room, and wherein the adjacency graph further has multiple edges between the multiple nodes that are each between two nodes and represents an adjacency in the indicated building of the associated rooms for those two nodes,
and wherein the stored instructions include software instructions that, when executed by at least one of the one or more computing systems, cause the at least one computing system to perform the providing of the information about the indicated building by transmitting the information about the indicated building over one or more computer networks to a client computing device for display to a user.

B41. A non-transitory computer-readable medium having stored contents that cause one or more computing systems to perform automated operations, the automated operations including at least:

obtaining, by the one or more computing systems and for each of a plurality of buildings, adjacency information for the building that includes a plurality of attributes associated with the building and further includes indications of adjacencies between multiple rooms of the building, wherein each of the multiple rooms is associated with at least one attribute about the building;

learning, by the one or more computing systems and based at least in part on the adjacency information for each of the plurality of buildings, a subset of attributes to represent buildings such that similar buildings have similar information about the subset of attributes for those similar buildings;
generating, by the one or more computing systems and for an indicated building separate from the plurality of buildings, an embedding vector to represent information about the indicated building that corresponds to the subset of attributes;
determining, by the one or more computing systems, that the generated embedding vector for the indicated building matches one or more specified criteria corresponding to one or more of the subset of attributes; and
providing, by the one or more computing systems, information about the indicated building, to enable a determination of one or more relations of the indicated building to the one or more specified criteria.

B42. The non-transitory computer-readable medium of clause B41 wherein the stored contents include software instructions that, when executed by at least one of the one or more computing systems, cause the at least one computing system to perform the generating of the embedding vector for the indicated building by:

obtaining information about the indicated building that includes a floor plan determined for the indicated building based at least in part on analysis of visual data of a plurality of images acquired at multiple acquisition locations within the indicated building, wherein the floor plan has information about the multiple rooms of the indicated building including at least shapes and relative positions of the multiple rooms; and
generating, using at least the floor plan, adjacency information for the indicated building that includes a plurality of attributes associated with the indicated building and further includes indications of adjacencies between multiple rooms of the indicated building, wherein each of the multiple rooms is associated with at least one attribute about the indicated building; and
performing the generating of the embedding vector for the indicated building based at least in part on the generated adjacency information for the indicated building,
and wherein the stored instructions include software instructions that, when executed by at least one of the one or more computing systems, cause the at least one computing system to perform the providing of the information about the indicated building by transmitting the information about the indicated building over one or more computer networks to a client computing device for display to a user.

C01. One or more computing systems comprising one or more hardware processors and one or more memories with stored instructions that, when executed by at least one of the one or more hardware processors, cause the one or more computing systems to perform automated operations to implement the method of any of clauses A01-A11.

C02. One or more computing systems comprising one or more hardware processors and one or more memories with stored instructions that, when executed by at least one of the one or more hardware processors, cause the one or more computing systems to perform automated operations to implement described techniques substantially as disclosed herein.

C03. A system comprising:

one or more hardware processors of one or more computing systems; and
one or more memories with stored instructions that, when executed by at least one of the one or more hardware processors, cause the one or more computing systems to perform automated operations including at least:

determining information about an indicated building having multiple rooms, including obtaining an embedding vector for the indicated building that is generated to represent at least a subset of a plurality of attributes associated with the indicated building and using an adjacency graph representing the indicated building and storing the plurality of attributes, wherein the adjacency graph has multiple nodes each associated with one of the multiple rooms and storing information about one or more of the attributes corresponding to the associated room, and wherein the adjacency graph further has multiple edges between the multiple nodes that are each between two nodes and represent an adjacency in the indicated building of the associated rooms for those two nodes;
determining, from a plurality of other buildings, at least one other building similar to the indicated building, including:

determining, for each of the plurality of other buildings, a degree of similarity between the embedding vector for the indicated building and an additional embedding vector that is associated with the other building to represent at least some attributes of the other building; and
selecting one or more of the plurality of other buildings that each has an associated additional embedding vector with a determined degree of similarity to the embedding vector for the indicated building that is above a determined threshold, and using the selected one or more other buildings as the determined at least one other building; and
providing information about attributes of the determined at least one other building, to enable a determination of one or more relations to the plurality of attributes associated with the indicated building.

C04. The system of clause C03 wherein the determining of the information about the indicated building includes:

obtaining information about the indicated building that includes a floor plan determined for the indicated building based at least in part on analysis of visual data of a plurality of images acquired at multiple acquisition locations within the building, wherein the floor plan has information about the multiple rooms including at least shapes and relative positions of the multiple rooms;
generating, using at least the floor plan, the adjacency graph; and
generating, using at least the adjacency graph, the embedding vector to represent information from the adjacency graph corresponding to the subset of the plurality of attributes of the indicated building, including representing information about adjacencies between the multiple rooms of the building.

C05. The system of any one of clauses C03-C04 further comprising a client computing device of a user, wherein the stored instructions include software instructions that, when executed by at least one of the one or more computing systems, cause the at least one computing system to perform further automated operations including generating the adjacency graph based at least in part on analysis of visual data of a plurality of images acquired at a plurality of acquisition locations that are associated with the building and that include multiple acquisition locations with the multiple rooms of the building and that further include one or more acquisition locations external to the building, wherein the providing of the information about the attributes of the determined at least one other building includes transmitting the information about the attributes of the determined at least one other building over one or more computer networks to the client computing device, and wherein the automated operations further include receiving by the client computing device and displaying on the client computing device the provided information about the attributes of the determined at least one other building, and transmitting, by the client computing device and to the one or more computing systems, information from an interaction of the user with a user-selectable control on the client computing device to cause a modification of information displayed on the client computing device for the determined at least one other building.

C06. A system comprising:

one or more hardware processors of one or more computing systems; and
one or more memories with stored instructions that, when executed by at least one of the one or more hardware processors, cause the one or more computing systems to perform automated operations including at least:

determining, via analysis of floor plans for a plurality of buildings, floor plan characteristics associated with one or more indicated subjective attributes;
determining, for each of multiple indicated buildings that include one or more buildings separate from the plurality of buildings, whether a floor plan for that indicated building has characteristics matching at least some of the determined characteristics so as to be associated with at least one of the one or more indicated subjective attributes;
determining, from the multiple indicated buildings, at least one indicated building that matches one or more search criteria including at least one specified subjective attribute of the one or more indicated subjective attributes; and
providing information about the at least one indicated building, to enable a determination of one or more relations to the one or more search criteria.

C07. The system of clause C06 further comprising a client computing device of a user, wherein the stored instructions include software instructions that, when executed by at least one of the one or more computing systems, cause the at least one computing system to receive information for the floor plans of the plurality of buildings that includes one or more supplied indications for each floor plan of whether it satisfies each of the one or more indicated subjective attributes, and to perform the determining of the floor plan characteristics by learning the floor plan characteristics based at least in part on the supplied indications for the floor plans of the plurality of buildings, and to perform the providing of the information about the at least one indicated building by transmitting the information about the at least one indicated building over one or more computer networks to the client computing device, and wherein the automated operations further include receiving by the client computing device and displaying on the client computing device the provided information about the at least one indicated building, and transmitting, by the client computing device and to the one or more computing systems, information from an interaction of the user with a user-selectable control on the client computing device to cause a modification of information displayed on the client computing device for the at least one indicated building.

C08. A system comprising:

one or more hardware processors of one or more computing systems; and
one or more memories with stored instructions that, when executed by at least one of the one or more hardware processors, cause the one or more computing systems to perform automated operations including at least:

obtaining information about an indicated building having multiple rooms, including an adjacency graph that represents the indicated building and stores a plurality of attributes associated with the indicated building, wherein the adjacency graph has multiple nodes that are each associated with one of the multiple rooms and stores information about one or more of the plurality of attributes that correspond to the associated room, and wherein the adjacency graph further has multiple edges between the multiple nodes that are each between two nodes and represents an adjacency in the indicated building of the associated rooms for those two nodes;
determining, from a plurality of other buildings, at least one other building similar to the indicated building, including:

determining, for each of the plurality of other buildings, a degree of similarity between the adjacency graph for the indicated building and an additional adjacency graph that represents the other building and stores at least some attributes of the other building; and
selecting one or more of the plurality of other buildings that each has an additional adjacency graph with a determined degree of similarity to the adjacency group for the indicated building above a determined threshold, and using the selected one or more other buildings as the determined at least one other building; and

providing information about the determined at least one other building, to enable a determination of one or more relations to the plurality of attributes associated with the indicated building.

C09. The system of clause C08 further comprising a client computing device of a user, wherein the obtaining of the information about the indicated building further includes:

obtaining information about the indicated building that includes a floor plan determined for the indicated building based at least in part on analysis of visual data of a plurality of images acquired at multiple acquisition locations within the building, wherein the floor plan has information about the multiple rooms including at least shapes and relative positions of the multiple rooms; and
generating, using at least the floor plan, the adjacency graph,
and wherein the stored instructions include software instructions that, when executed by at least one of the one or more computing systems, cause the at least one computing system to perform the providing of the information about the determined at least one other building by transmitting the information about the determined at least one other building over one or more computer networks to the client computing device, and wherein the automated operations further include receiving by the client computing device and displaying on the client computing device the provided information about the determined at least one other building, and transmitting, by the client computing device and to the one or more computing systems, information from an interaction of the user with a user-selectable control on the client computing device to cause a modification of information displayed on the client computing device for the determined at least one other building.

C10. A system comprising:

one or more hardware processors of one or more computing systems; and
one or more memories with stored instructions that, when executed by at least one of the one or more hardware processors, cause the one or more computing systems to perform automated operations including at least:

obtaining, for each of a plurality of buildings, information about the building that includes an adjacency graph that represents the building and stores a plurality of attributes associated with the building, wherein the adjacency graph has multiple nodes that are each associated with one of multiple rooms of the building and stores information about one or more of the plurality of attributes that correspond to the associated room, and wherein the adjacency graph further has multiple edges between the multiple nodes that are each between two nodes and represents an adjacency in the building of the associated rooms for those two nodes;
receiving one or more search criteria that are based at least in part on an indicated adjacency of at least two types of rooms;
determining, from the plurality of buildings, at least one indicated building that matches the one or more search criteria, including searching the adjacency graph for each of the at least one indicated buildings to identify one or more edges in that adjacency graph representing one or more adjacencies in that indicated building that satisfy the indicated adjacency; and
providing information about the at least one indicated building, to enable a determination of one or more relations to the plurality of attributes associated with the at least one indicated building.

C11. The system of clause C10 further comprising a client computing device of a user, wherein the obtaining of the information about each of the plurality of buildings further includes:

obtaining information about the building that includes a floor plan determined for the building based at least in part on analysis of visual data of a plurality of images acquired at multiple acquisition locations within the building, wherein the floor plan has information about the multiple rooms including at least shapes and relative positions of the multiple rooms; and
generating, using at least the floor plan, the adjacency graph for the building,
and wherein the stored instructions include software instructions that, when executed by at least one of the one or more computing systems, cause the at least one computing system to perform the providing of the information about the at least one indicated building by transmitting the information about the at least one indicated building over one or more computer networks to the client computing device, and wherein the automated operations further include receiving by the client computing device and displaying on the client computing device the provided information about the at least one indicated building, and transmitting, by the client computing device and to the one or more computing systems, information from an interaction of the user with a user-selectable control on the client computing device to cause a modification of information displayed on the client computing device for the at least one indicated building.

C12. A system comprising:

one or more hardware processors of one or more computing systems; and
one or more memories with stored instructions that, when executed by at least one of the one or more hardware processors, cause the one or more computing systems to perform automated operations including at least:

obtaining, for each of a plurality of buildings, information about the building that includes one or more visual attributes of an interior of the building that are determined from analysis of visual data of one or more images taken in that interior, and that further includes an adjacency graph that represents the building and stores a plurality of attributes associated with the building that include the one or more visual attributes of the interior of the building, wherein the adjacency graph has multiple nodes that are each associated with one of multiple rooms of the building and stores information about one or more of the plurality of attributes that correspond to the associated room, wherein the stored information for at least one of the multiple nodes includes at least one of the visual attributes of the building that relates to the associated room for the at least one node, and wherein the adjacency graph further has multiple edges between the multiple nodes that are each between two nodes and represents an adjacency in the building of the associated rooms for those two nodes;
receiving one or more search criteria based at least in part on one or more indicated visual attributes of one or more rooms;
determining that at least one indicated building of the plurality of buildings matches the one or more search criteria, including searching, for each of the at least one indicated buildings, the adjacency graph of that indicated building to identify at least one of the multiple rooms of that indicated building whose associated node has stored information that includes at least one visual attribute satisfying the one or more indicated visual attributes; and

providing information about the at least one indicated building, to enable a determination of one or more relations to the plurality of attributes associated with the at least one indicated building.

C13. The system of clause C12 further comprising a client computing device of a user, wherein the obtaining of the information about each of the plurality of buildings further includes:

obtaining information about the building that includes a floor plan determined for the building based at least in part on analysis of visual data of a plurality of images acquired at multiple acquisition locations within the building, wherein the floor plan has information about the multiple rooms including at least shapes and relative positions of the multiple rooms; and
generating, using at least the floor plan, the adjacency graph for the building,
and wherein the stored instructions include software instructions that, when executed by at least one of the one or more computing systems, cause the at least one computing system to perform the providing of the information about the at least one indicated building by transmitting the information about the at least one indicated building over one or more computer networks to the client computing device, and wherein the automated operations further include receiving by the client computing device and displaying on the client computing device the provided information about the at least one indicated building, and transmitting, by the client computing device and to the one or more computing systems, information from an interaction of the user with a user-selectable control on the client computing device to cause a modification of information displayed on the client computing device for the at least one indicated building.

C14. A system comprising:

one or more hardware processors of one or more computing systems; and
one or more memories with stored instructions that, when executed by at least one of the one or more hardware processors, cause the one or more computing systems to perform automated operations including at least:

obtaining, for each of a plurality of buildings, information about the building that includes an adjacency graph that represents the building and stores a plurality of attributes associated with the building including objective attributes about the building that are able to be independently verified, wherein the adjacency graph has multiple nodes that are each associated with one of multiple rooms of the building and stores information about one or more of the plurality of attributes that correspond to the associated room, and wherein the adjacency graph further has multiple edges between the multiple nodes that are each between two nodes and represents an adjacency in the building of the associated rooms for those two nodes;
predicting, for each of the plurality of buildings, one or more additional subjective attributes for the building, and updating the adjacency graph for the building to further store information about the one or more additional subjective attributes for the building;
determining, after the updating, that at least one indicated building of the plurality of buildings matches one or more specified criteria corresponding to at least one indicated subjective attribute and at least one indicated objective attribute, by searching, for each of the at least one indicated buildings, the updated adjacency graph for that indicated building to determine that stored information in that updated adjacency graph satisfies the at least one indicated subjective attribute and the at least one indicated objective attribute; and
providing information about the at least one indicated building, to enable a determination of one or more relations of the at least one indicated buildings to the one or more specified criteria.

C15. The system of clause C14 further comprising a client computing device of a user, wherein the obtaining of the information about each of the plurality of buildings further includes:

obtaining information about the building that includes a floor plan determined for the building based at least in part on analysis of visual data of a plurality of images acquired at multiple acquisition locations within the building, wherein the floor plan has information about the multiple rooms including at least shapes and relative positions of the multiple rooms; and
generating, using at least the floor plan, the adjacency graph for the building,
and wherein the stored instructions include software instructions that, when executed by at least one of the one or more computing systems, cause the at least one computing system to perform the providing of the information about the at least one indicated building by transmitting the information about the at least one indicated building over one or more computer networks to the client computing device, and wherein the automated operations further include receiving by the client computing device and displaying on the client computing device the provided information about the at least one indicated building, and transmitting, by the client computing device and to the one or more computing systems, information from an interaction of the user with a user-selectable control on the client computing device to cause a modification of information displayed on the client computing device for the at least one indicated building.

C16. A system comprising:

one or more hardware processors of one or more computing systems; and
one or more memories with stored instructions that, when executed by at least one of the one or more hardware processors, cause the one or more computing systems to perform automated operations including at least:

obtaining, for each of a plurality of buildings, information about the building that includes an adjacency graph that represents the building and stores a plurality of attributes associated with the building, wherein the adjacency graph has multiple nodes that are each associated with one of multiple rooms of the building and stores information about one or more of the plurality of attributes that correspond to the associated room, and wherein the adjacency graph further has multiple edges between the multiple nodes that are each between two nodes and represents an adjacency in the building of the associated rooms for those two nodes;
predicting, for each of the plurality of buildings, one or more room types for one or more rooms in the building, and updating the adjacency graph for the building to further store information about the one or more room types for the one or more rooms in the building;
determining, after the updating, that at least one indicated building of the plurality of buildings matches one or more specified criteria corresponding to at least one indicated room type, by searching, for each of the at least one indicated buildings, the updated adjacency graph for that indicated building to determine that stored information in that updated adjacency graph satisfies the at least one indicated room type; and
providing information about the at least one indicated building, to enable a determination of one or more relations of the at least one indicated buildings to the one or more specified criteria.

C17. The system of clause C16 further comprising a client computing device of a user, wherein the obtaining of the information about each of the plurality of buildings further includes:

obtaining information about the building that includes a floor plan determined for the building based at least in part on analysis of visual data of a plurality of images acquired at multiple acquisition locations within the building, wherein the floor plan has information about the multiple rooms including at least shapes and relative positions of the multiple rooms; and
generating, using at least the floor plan, the adjacency graph for the building,
and wherein the stored instructions include software instructions that, when executed by at least one of the one or more computing systems, cause the at least one computing system to perform the providing of the information about the at least one indicated building by transmitting the information about the at least one indicated building over one or more computer networks to the client computing device, and wherein the automated operations further include receiving by the client computing device and displaying on the client computing device the provided information about the at least one indicated building, and transmitting, by the client computing device and to the one or more computing systems, information from an interaction of the user with a user-selectable control on the client computing device to cause a modification of information displayed on the client computing device for the at least one indicated building.

C18. A system comprising:

one or more hardware processors of one or more computing systems; and
one or more memories with stored instructions that, when executed by at least one of the one or more hardware processors, cause the one or more computing systems to perform automated operations including at least:

obtaining, for each of a plurality of buildings, information about the building that includes an adjacency graph that represents the building and stores a plurality of attributes associated with the building, wherein the adjacency graph has multiple nodes that are each associated with one of multiple rooms of the building and stores information about one or more of the plurality of attributes that correspond to the associated room, and wherein the adjacency graph further has multiple edges between the multiple nodes that are each between two nodes and represents an adjacency in the building of the associated rooms for those two nodes;

predicting, for each of the plurality of buildings, one or more connectivity statuses between two or more rooms in the building, and updating the adjacency graph for the building to further store information about the one or more connectivity statuses for the building;

determining, after the updating, that at least one indicated building of the plurality of buildings matches one or more specified criteria corresponding to at least one indicated connectivity status between at least two rooms, by searching, for each of the at least one indicated buildings, the updated adjacency graph for that indicated building to determine that stored information in that updated adjacency graph satisfies the at least one indicated connectivity status; and

providing information about the at least one indicated building, to enable a determination of one or more relations of the at least one indicated buildings to the one or more specified criteria.

C19. The system of clause C18 further comprising a client computing device of a user, wherein the obtaining of the information about each of the plurality of buildings further includes:

obtaining information about the building that includes a floor plan determined for the building based at least in part on analysis of visual data of a plurality of images acquired at multiple acquisition locations within the building, wherein the floor plan has information about the multiple rooms including at least shapes and relative positions of the multiple rooms; and

generating, using at least the floor plan, the adjacency graph for the building,

and wherein the stored instructions include software instructions that, when executed by at least one of the one or more computing systems, cause the at least one computing system to perform the providing of the information about the at least one indicated building by transmitting the information about the at least one indicated building over one or more computer networks to the client computing device, and wherein the automated operations further include receiving by the client computing device and displaying on the client computing device the provided information about the at least one indicated building, and transmitting, by the client computing device and to the one or more computing systems, information from an interaction of the user with a user-selectable control on the client computing device to cause a modification of information displayed on the client computing device for the at least one indicated building.

C20. A system comprising:

one or more hardware processors of one or more computing systems; and

one or more memories with stored instructions that, when executed by at least one of the one or more hardware processors, cause the one or more computing systems to perform automated operations including at least:

obtaining, for each of a plurality of buildings, information about the building that includes an adjacency graph that represents the building and stores a plurality of attributes associated with the building, wherein the adjacency graph has multiple nodes that are each associated with one of multiple rooms of the building and stores information about one or more of the plurality of attributes that correspond to the associated room, and wherein the adjacency graph further has multiple edges between the multiple nodes that are each between two nodes and represents an adjacency in the building of the associated rooms for those two nodes;

learning a subset of attributes to represent buildings based at least in part on determining a mapping function to map nodes in the adjacency graphs for the plurality of buildings to a learned space in which similar graph nodes have similar embeddings in the learned space;

generating, for each of multiple indicated buildings, an embedding vector to represent information about that indicated building that corresponds to the subset of attributes;

determining, for each of at least one indicated building of the multiple indicated buildings, that the generated embedding vector for that indicated building matches one or more specified criteria corresponding to one or more of the subset of attributes; and

providing information about the at least one indicated building, to enable a determination of one or more relations of the at least one indicated buildings to the one or more specified criteria.

C21. The system of clause C20 further comprising a client computing device of a user, wherein the multiple indicated buildings are separate from the plurality of buildings, and wherein the obtaining of the information about each of the plurality of buildings further includes:

obtaining information about the building that includes a floor plan determined for the building based at least in part on analysis of visual data of a plurality of images acquired at multiple acquisition locations within the building, wherein the floor plan has information about the multiple rooms including at least shapes and relative positions of the multiple rooms; and

generating, using at least the floor plan, the adjacency graph for the building,

and wherein the stored instructions include software instructions that, when executed by at least one of the one or more computing systems, cause the at least one computing system to perform the providing of the information about the at least one indicated building by transmitting the information about the at least one indicated building over one or more computer networks to the client computing device, and wherein the automated operations further include receiving by the client computing device and displaying on the client computing device the provided information about the at least one indicated building, and transmitting, by the client computing device and to the one or more computing systems, information from an interaction of the user with a user-selectable control on the client computing device to cause a modification of information displayed on the client computing device for the at least one indicated building.

D01. A computer program adapted to perform the method of any of clauses A01-A11 when the computer program is run on a computer.

D02. A computer program adapted to perform the automated operations of any of clauses B01-B42 when the computer program is run on a computer.

D03. A computer program adapted to perform the automated operations of any of clauses C01-C21 when the computer program is run on a computer.

Aspects of the present disclosure are described herein with reference to flowchart illustrations and/or block diagrams of methods, apparatus (systems), and computer program products according to embodiments of the present disclosure. It will be appreciated that each block of the flowchart illustrations and/or block diagrams, and combinations of blocks in the flowchart illustrations and/or block diagrams, can be implemented by computer readable program instructions. It will be further appreciated that in some implementations the functionality provided by the routines discussed above may be provided in alternative ways, such as being split among more routines or consolidated into fewer routines. Similarly, in some implementations illustrated routines may provide more or less functionality than is described, such as when other illustrated routines instead lack or include such functionality respectively, or when the amount of functionality that is provided is altered. In addition, while various operations may be illustrated as being performed in a particular manner (e.g., in serial or in parallel, or synchronous or asynchronous) and/or in a particular order, in other implementations the operations may be performed in other orders and in other manners. Any data structures discussed above may also be structured in different manners, such as by having a single data structure split into multiple data structures and/or by having multiple data structures consolidated into a single data structure. Similarly, in some implementations illustrated data structures may store more or less information than is described, such as when other illustrated data structures instead lack or include such information respectively, or when the amount or types of information that is stored is altered.

From the foregoing it will be appreciated that, although specific embodiments have been described herein for purposes of illustration, various modifications may be made without deviating from the spirit and scope of the invention. Accordingly, the invention is not limited except as by corresponding claims and the elements recited by those claims. In addition, while certain aspects of the invention may be presented in certain claim forms at certain times, the inventors contemplate the various aspects of the invention in any available claim form. For example, while only some aspects of the invention may be recited as being embodied in a computer-readable medium at particular times, other aspects may likewise be so embodied.

## Claims

**1.** A computer-implemented method comprising:

determining, by one or more computing systems, information about an indicated building having multiple rooms, including adjacency information for the indicated building that indicates groups of two or more of the multiple rooms adjacent to each other in the indicated building and that further includes a plurality of attributes associated with the indicated building, and wherein each of the multiple rooms is associated with at least one attribute of the plurality of attributes;

determining, by the one or more computing systems and from a plurality of other buildings separate from the indicated building, one of the other buildings based on the indicated building, including:

determining, by the one or more computing systems and for each of the plurality of other buildings, a measure of a difference between the adjacency information for the indicated building and additional adjacency information associated with that other building, wherein the additional adjacency information associated with that other building indicates one or more additional groups of two or more adjacent rooms of that other building and further includes attributes associated with that other building; and
selecting, by the one or more computing systems, one of the plurality of other buildings to use as the determined one other building based at least in part on the determined measure of difference between the additional adjacency information for the determined one other building and the adjacency information for the indicated building; and

providing, by the one or more computing systems, information about the determined one other building, to enable a determination of one or more relations to the plurality of attributes associated with the indicated building.

**2.** The computer-implemented method of claim 1,

wherein the determining of the information about the indicated building includes obtaining an embedding vector for the indicated building that is generated to represent a subset of the plurality of attributes associated with the indicated building and that is based at least in part on the adjacency information for the indicated building;
wherein the determining of the one other building includes obtaining, by the one or more computing systems and for each of the plurality of other buildings, an additional embedding vector for that other building that is generated to represent a subset of the attributes of that other building and that is based at least in part on the additional adjacency information for that other building; and
wherein the determining, for each of the plurality of other buildings, of the measure of the difference between the adjacency information for the indicated building and the additional adjacency information associated with that other building includes measuring that difference by comparing the embedding vector for the indicated building and the additional embedding vector for that other building.

**3.** The computer-implemented method of claim 2 wherein the determining of the information about the indicated building further includes:

obtaining, by the one or more computing systems, information about the indicated building that includes a floor plan determined for the indicated building based at least in part on analysis of visual data of a plurality of images acquired at multiple acquisition locations within the indicated building, wherein the floor plan has information about the multiple rooms including at least shapes of the multiple rooms and relative positions of the multiple rooms;
generating, by the one or more computing systems and using at least the floor plan, the adjacency information for the indicated building, including generating an adjacency graph that stores the plurality of attributes and that has multiple nodes each associated with one of the multiple rooms and storing information about one or more of the attributes corresponding to the associated room and that further has multiple edges between the multiple nodes that are each between two nodes and represent an adjacency in the indicated building of the associated rooms for those two nodes; and
generating, by the one or more computing systems and using at least the adjacency graph, the embedding vector to represent information from the adjacency graph corresponding to the subset of the plurality of attributes of the indicated building, including representing information about adjacencies between the multiple rooms of the building.

**4.** The computer-implemented method of claim 3 further comprising obtaining the plurality of images, wherein the plurality of images further include one or more images acquired at one or more acquisition locations external to the indicated building, wherein the measuring of the difference for each of the plurality of other buildings includes determining a degree of similarity for that other building between the additional embedding vector for that other building and the embedding vector for the indicated building, and further includes selecting the one other building based on the determined degree of similarity for that other building being above a defined threshold, wherein the providing of the information about the determined one other building includes transmitting the information about the determined one other building over one or more computer networks to at least one client computing device for display, and wherein the method further comprises automatically learning, by the one or more computing systems, the subset of the plurality of attributes of the indicated building to include in the embedding vector based at least in part on mapping nodes in the adjacency graph for the indicated building to a learned space in which similar graph nodes have similar embeddings.

5. The computer-implemented method of claim 2 further comprising generating, by the one or more computing systems, the embedding vector for the indicated building by incorporating information in that embedding vector about adjacencies of rooms in the indicated building and about at least one additional type of information, wherein the at least one additional type of information includes at least one of:

information about visual attributes of an interior of the indicated building that are determined based at least in part on an analysis of one or more first images acquired in the interior of the indicated building; or
information about views from the indicated building to its surroundings that are determined based on at least one of an analysis of one or more second images acquired for the indicated building; or
information about an exterior of the indicated building that is determined based at least in part on an analysis of one or more third images acquired from the exterior of the indicated building,
and wherein the additional embedding vector for each of the plurality of other buildings includes information about adjacencies of rooms in that other building and about the at least one additional type of information.

6. The computer-implemented method of claim 2 wherein the plurality of attributes associated with the indicated building include objective attributes that are independently verifiable, and wherein the method further comprises

predicting, by the one or more computing systems, one or more additional subjective attributes of the plurality of attributes by supplying information about the indicated building to one or more trained machine learning models and receiving output indicating the one or more additional subjective attributes; and
generating, by the one or more computing systems, the embedding vector for the indicated building, including incorporating information in the embedding vector about the one or more additional subjective attributes and about at least some of the objective attributes,
and wherein the additional embedding vector for each of the plurality of other buildings includes information about one or more further objective attributes of that other building and one or more further subjective attributes of that other building.

7. The computer-implemented method of claim 2 further comprising:

predicting, by the one or more computing systems, room types of the multiple rooms by supplying information about the indicated building to one or more trained machine learning models and receiving output indicating the room types of the multiple room; and
generating, by the one or more computing systems, the embedding vector for the indicated building, including incorporating information in the embedding vector about the room types of the multiple rooms,
and wherein the additional embedding vector for each of the plurality of other buildings includes information about room types of rooms in that other building.

8. The computer-implemented method of claim 2 further comprising:

predicting, by the one or more computing systems, connectivity status information between at least some of the multiple rooms by supplying information about the indicated building to one or more trained machine learning models and receiving output indicating the connectivity status information, wherein the connectivity status information includes, for each pair of two rooms in the indicated building that are in one of the groups of two or more rooms, a connectivity status of whether the two rooms of the pair are connected via an inter-room wall opening between the two rooms of the pair; and
generating, by the one or more computing systems, the embedding vector for the indicated building, including incorporating information in the embedding vector about the predicted connectivity status information,
and wherein the additional embedding vector for each of the plurality of other buildings includes information about connectivity status information for rooms in that other building.

9. The computer-implemented method of claim 8 wherein, for each pair of two rooms in the indicated building that are in one of the groups of two or more rooms, the connectivity status of whether the two rooms of the pair are connected via an inter-room wall opening between the two rooms of the pair includes at least one of a predicted wall between the two rooms without an inter-room wall opening or a predicted doorway between the two rooms or a predicted non-doorway wall opening between the two rooms, and wherein the incorporated information in the embedding vector includes information about the at least one of the predicted wall or the predicted doorway or the predicted non-doorway wall opening.

**10.** The computer-implemented method of claim 1 further comprising receiving, by the one or more computing systems, one or more search criteria and further performing the determining of the one other building based at least in part on the determined one other building matching the one or more search criteria, wherein the providing of the information about the determined one other building includes providing search results for presentation that include the determined one other building, and wherein the one or more search criteria include at least one of:

one or more criteria that are based on adjacency of at least two types of rooms, and wherein the determined measure of difference between the associated additional adjacency information for the determined one other building and the adjacency information for the indicated building is based at least in part on adjacencies of the multiple rooms in the indicated building and adjacencies of rooms in the determined one other building; or
one or more criteria that are based on visual attributes of a building interior, and wherein the determined measure of difference between the associated additional adjacency information for the determined one other building and the adjacency information for the indicated building is based at least in part on visual attributes of an interior of the indicated building and additional visual attributes of an interior of the determined one other building; or
one or more criteria that are based on one or more types of exterior views from a building, and wherein the determined measure of difference between the associated additional adjacency information for the determined one other building and the adjacency information for the indicated building is based at least in part on views from the indicated building to its surroundings and additional views from the determined one other building to its surroundings.

**11.** The computer-implemented method of claim 1 wherein the determined one other building includes multiple other buildings, and wherein the providing of the information about the determined one other building includes determining, by the one or more computing systems, an expected assessment of at least one of condition or quality of the indicated building based at least in part on assessments of the multiple other buildings, and providing information about the determined expected assessment.

**12.** The computer-implemented method of claim 1 further comprising generating, by the one or more computing systems, the adjacency information, including generating an adjacency graph, wherein the adjacency graph:

stores the plurality of attributes; and
has multiple nodes each associated with one of the multiple rooms and storing information about one or more of the attributes corresponding to the associated room; and
has multiple edges between the multiple nodes that are each between two nodes and represent an adjacency in the indicated building of the associated rooms for those two nodes; and
has one or more additional nodes that each corresponds to at least one of an exterior area outside of the indicated building or an external view from an interior of the building to an exterior of the indicated building; and
has at least one additional edge for each of the one or more additional nodes that connects that additional node to another node of the adjacency graph,
and wherein the generating of the embedding vector for the indicated building includes incorporating information in the embedding vector about the at least one of the exterior area or the external view for each of the one or more additional nodes, and wherein the additional adjacency information for each of the plurality of other buildings includes information about at least one of a further exterior area or a further external view for that other building.

**13.** The computer-implemented method of claim 1 further comprising receiving information about multiple buildings that include the indicated building and one or more additional indicated buildings, and obtaining further adjacency information for each of the one or more additional indicated buildings, wherein the determining of the measure of difference is further performed for each of the one or more additional indicated buildings between the further adjacency information for that additional indicated building and the additional adjacency information for each of the plurality of other buildings, and wherein the selecting of the one other building is further based on the determined measures of difference between the associated additional adjacency information for each of the one or more other buildings and the further adjacency information for each of the one or more additional indicated buildings, such that selection of the one other buildings is based on aggregate differences for the adjacency information of the indicated building and the further adjacency information for the additional indicated buildings to the associated additional adjacency information for the determined other building.

**14.** A non-transitory computer-readable medium having stored contents that cause a computing device to perform automated operations, the automated operations including at least:

obtaining, by the computing device, information about an indicated building having multiple rooms, including a floor plan determined for the indicated building that includes information about the multiple rooms including at least two-dimensional shapes and relative positions;
generating, by the computing device, and using at least the floor plan, an adjacency graph that represents the indicated building and that stores attributes associated with the indicated building, wherein the adjacency graph has multiple nodes that are each associated with one of the multiple rooms and stores information about one or more of the attributes that correspond to the associated room, and wherein the adjacency graph further has multiple edges between the multiple nodes that are each between two nodes and represent an adjacency in the indicated building of the associated rooms for those two nodes;
generating, by the computing device, and using representation learning, an embedding vector to represent information from the adjacency graph that corresponds to a subset of a plurality of attributes of the indicated building;
determining, by the computing device, and from a plurality of other buildings, at least one other building similar to the indicated building, including:

determining, by the computing device, and for each of the plurality of other buildings, a degree of similarity between the generated embedding vector for the indicated building and an additional embedding vector associated with the other building to represent at least some attributes of the other building; and
selecting, by the computing device, one or more of the plurality of other buildings that each has an associated additional embedding vector with a determined degree of similarity to the generated embedding vector for the indicated building that is above a determined threshold, and using the selected one or more other buildings as the determined at least one other building; and

presenting, by the computing device, information about attributes of the determined at least one other building, to enable a determination of one or more relations to the plurality of attributes associated with the indicated building.

**15.** A system comprising:

one or more hardware processors of one or more computing systems; and
one or more memories with stored instructions that, when executed by at least one of the one or more hardware processors, cause the one or more computing systems to perform automated operations including at least:

determining information about an indicated building having multiple rooms, including obtaining an embedding vector for the indicated building that is generated to represent at least a subset of a plurality of attributes associated with the indicated building and that is generated by using an adjacency graph representing the indicated building and storing the plurality of attributes, wherein the adjacency graph has multiple nodes each associated with one of the multiple rooms and storing information about one or more of the attributes corresponding to the associated room, and wherein the adjacency graph further has multiple edges between the multiple nodes that are each between two nodes and represent an adjacency in the indicated building of the associated rooms for those two nodes;
determining, from a plurality of other buildings, at least one other building similar to the indicated building, including:

determining, for each of the plurality of other buildings, a degree of similarity between the embedding vector for the indicated building and an additional embedding vector that is associated with the other building to represent at least some attributes of the other building; and
selecting one or more of the plurality of other buildings that each has an associated additional embedding vector with a determined degree of similarity to the embedding vector for the indicated building that is above a determined threshold, and using the selected one or more other buildings as the determined at least one other building; and

providing information about attributes of the determined at least one other building, to enable a determination of one or more relations to the plurality of attributes associated with the indicated building.

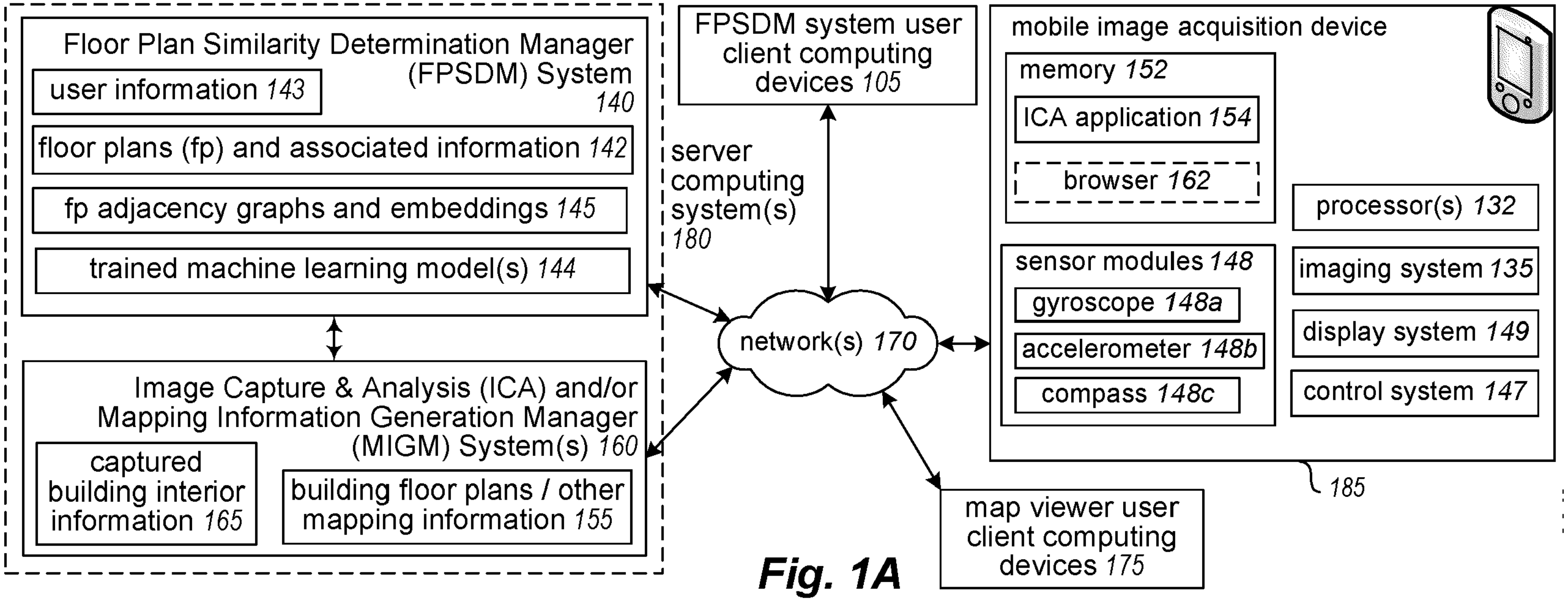

Floor Plan Similarity Determination Manager (FPSDM) System 140
user information 143
floor plans (fp) and associated information 142
fp adjacency graphs and embeddings 145
trained machine learning model(s) 144
Image Capture & Analysis (ICA) and/or Mapping Information Generation Manager (MIGM) System(s) 160
captured building interior information 165
building floor plans / other mapping information 155
server computing system(s) 180
FPSDM system user client computing devices 105
network(s) 170
map viewer user client computing devices 175
mobile image acquisition device
memory 152
ICA application 154
browser 162
processor(s) 132
sensor modules 148
gyroscope 148a
accelerometer 148b
compass 148c
imaging system 135
display system 149
control system 147
185


Fig. 1A

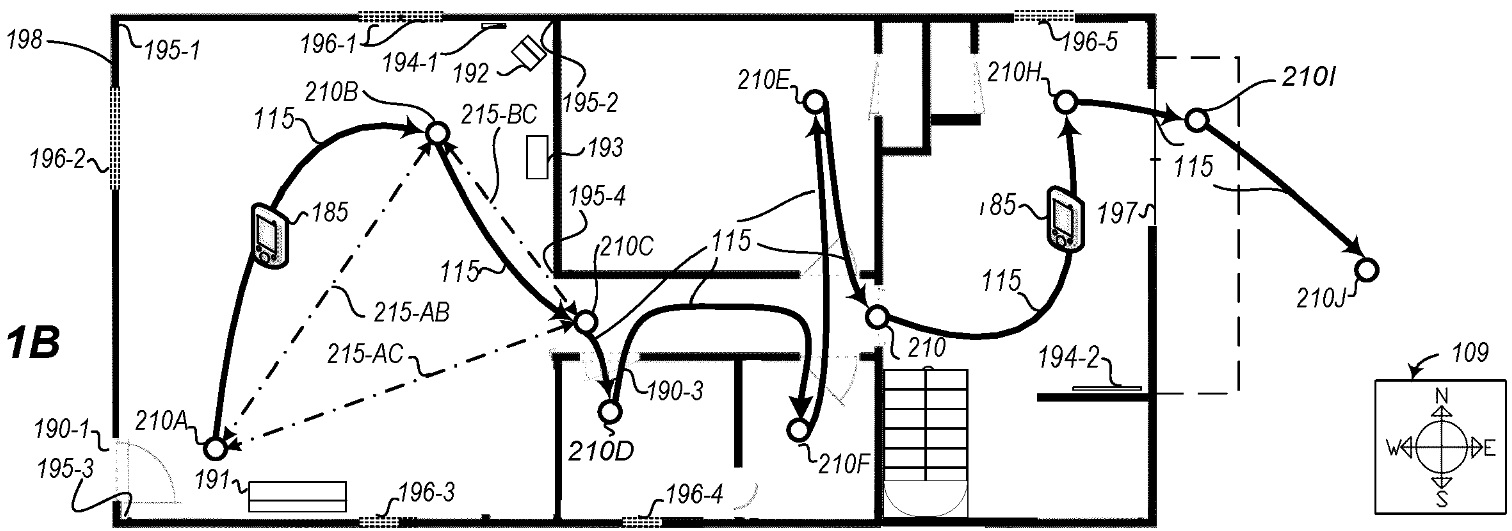

198
195-1
196-1
194-1
192
195-2
196-2
210B
115
215-BC
193
185
195-4
210C
215-AB
215-AC
190-1
210A
195-3
191
196-3
190-3
210D
196-4
210E
210F
210
210H
196-5
197
210I
210J
194-2
109
N
W
E
S


Fig. 1B

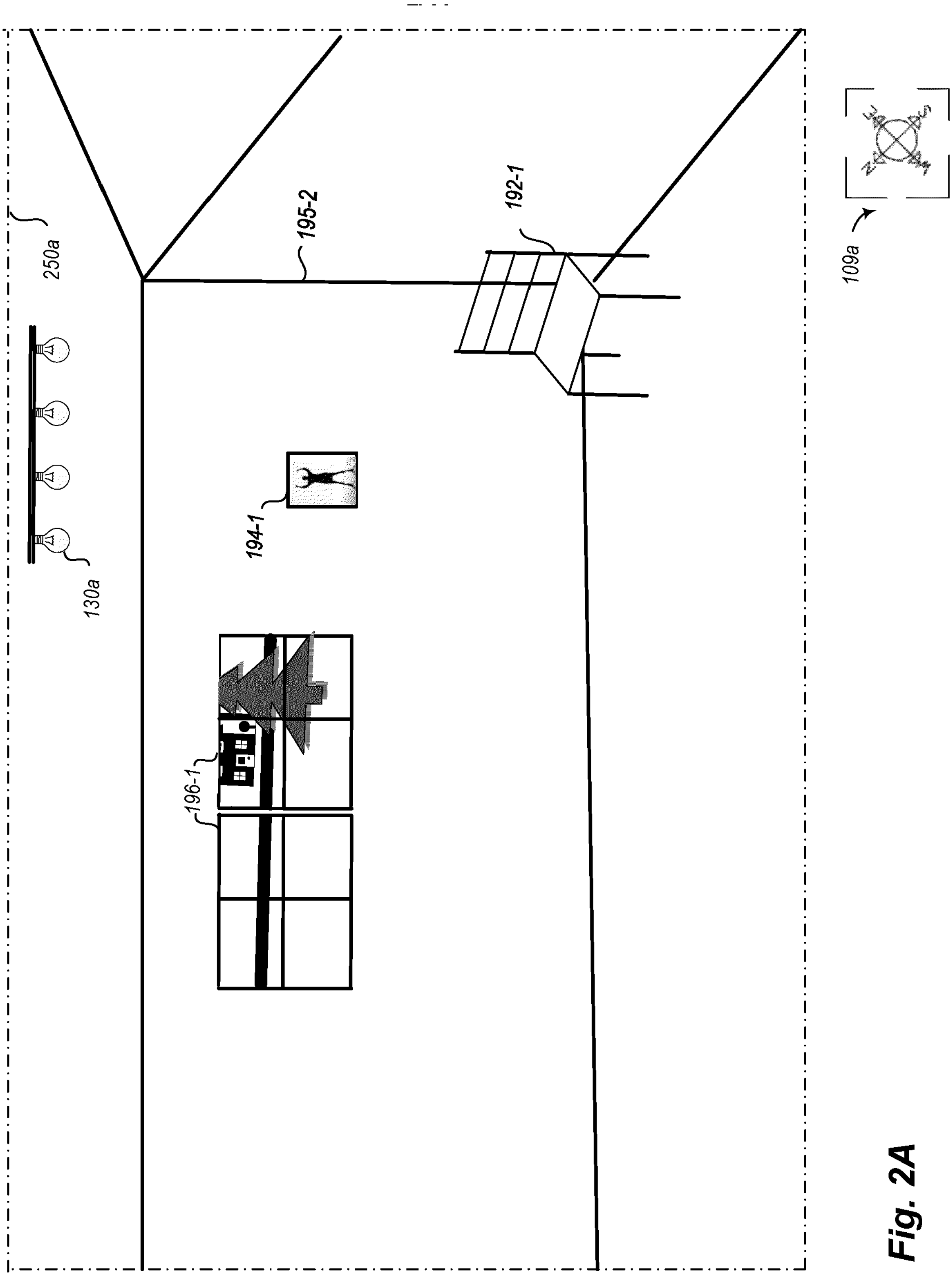


Fig. 2A

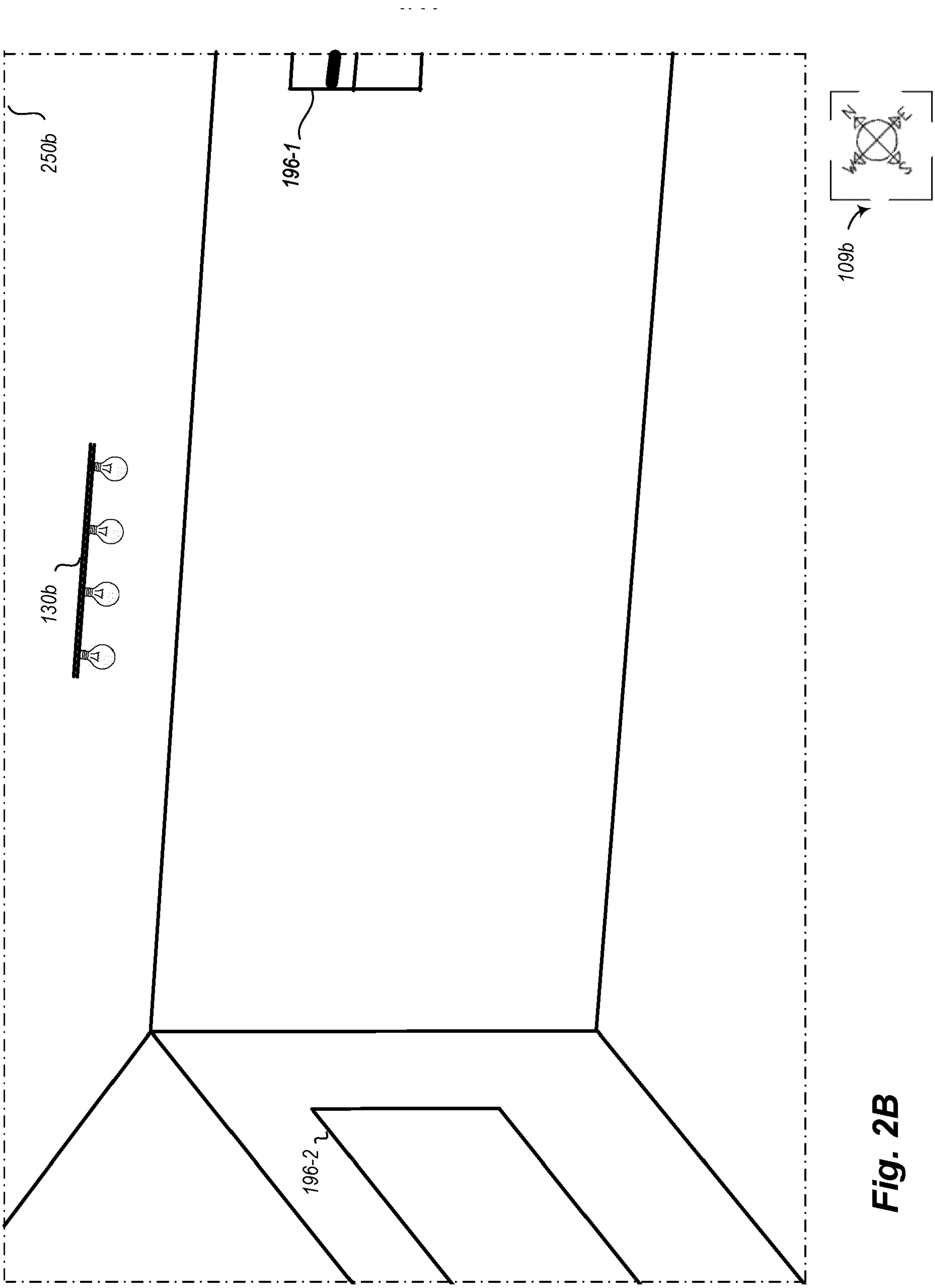


Fig. 2B

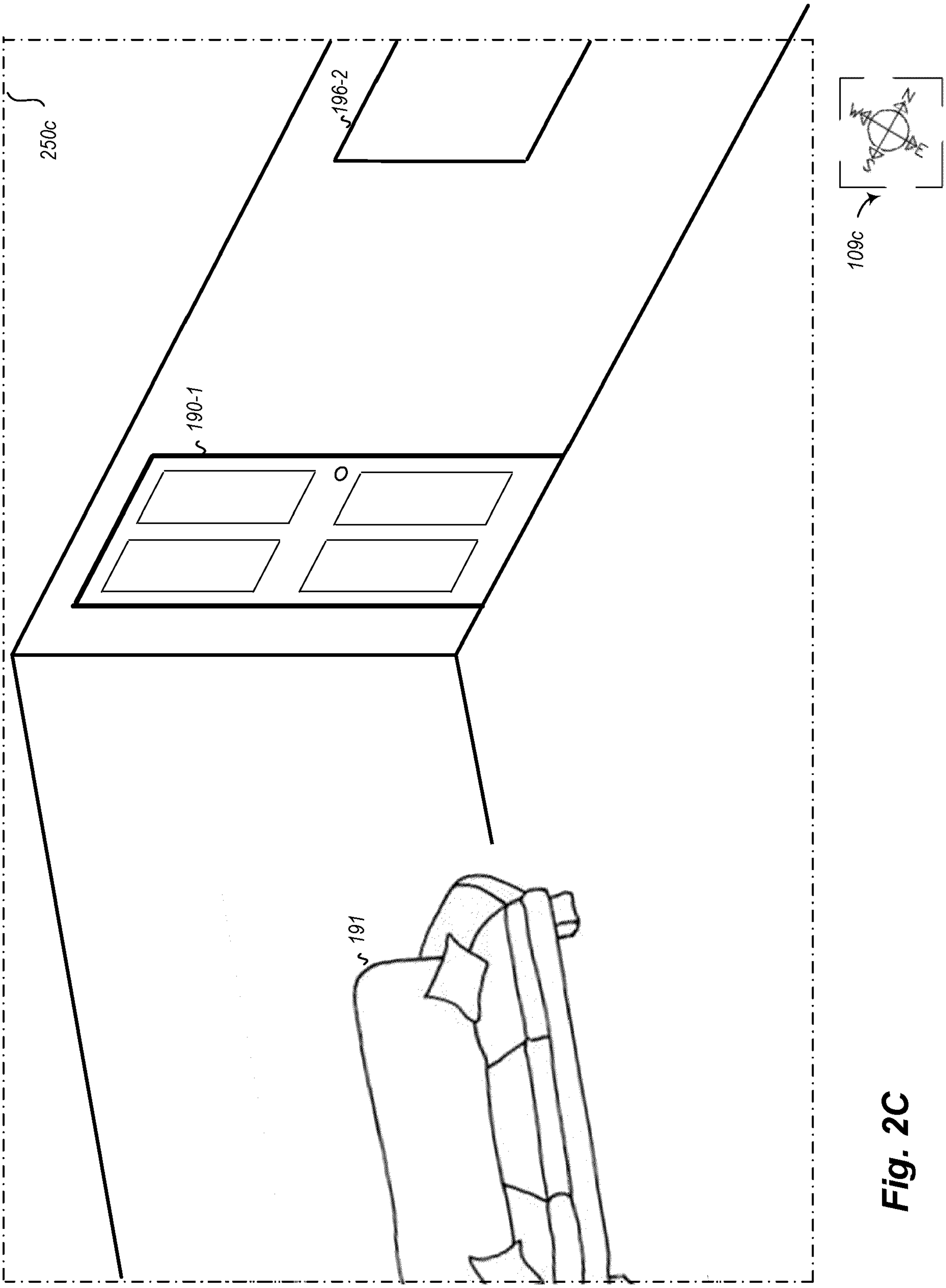


Fig. 2C

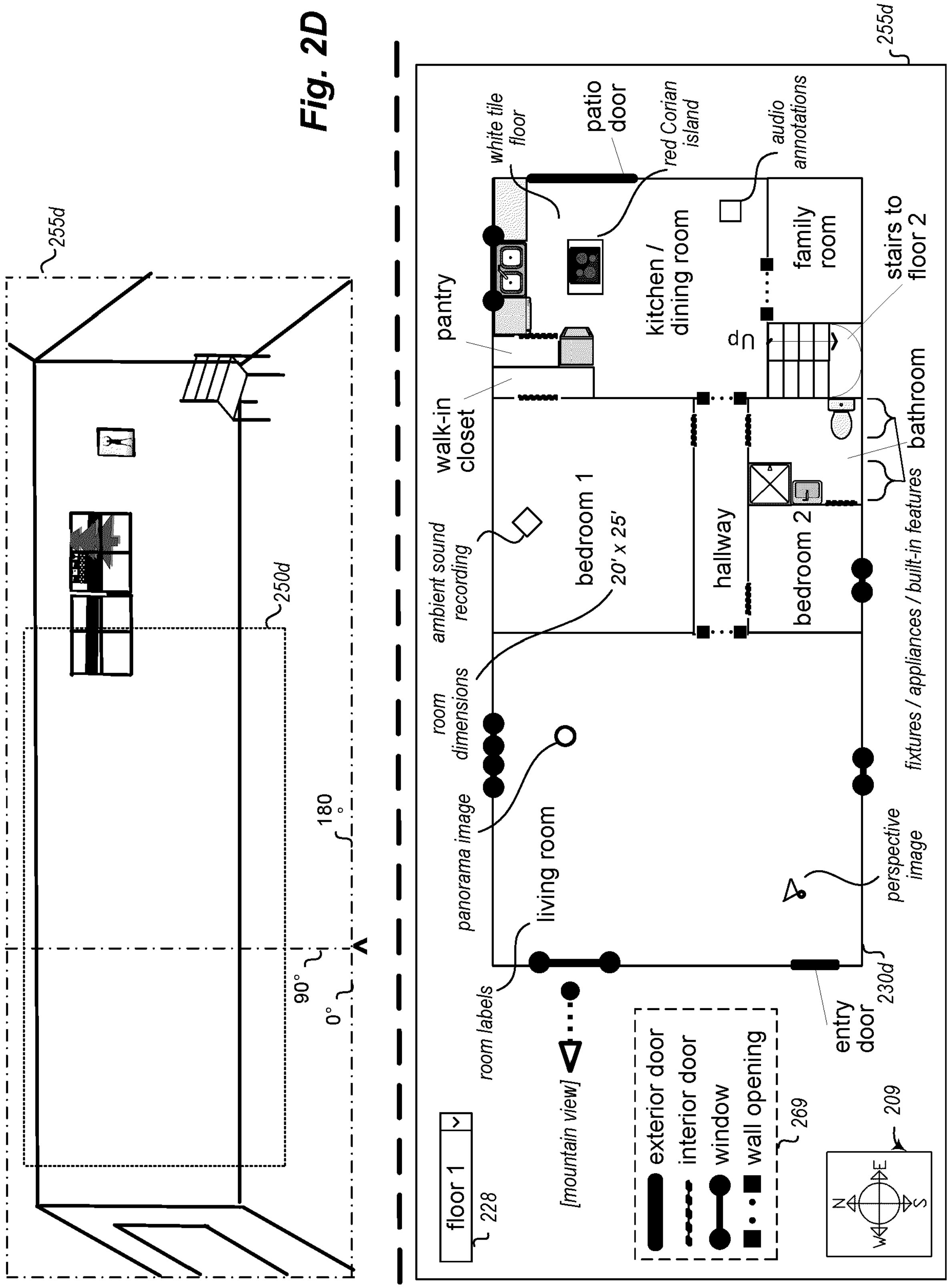
255d
250d
180°
90°
0°
255d
white tile floor
patio door
red Corian island
audio annotations
pantry
kitchen / dining room
family room
Up
stairs to floor 2
walk-in closet
bathroom
ambient sound recording
bedroom 1
20' x 25'
hallway
bedroom 2
fixtures / appliances / built-in features
room dimensions
panorama image
living room
perspective image
room labels
entry door
230d
[mountain view]
floor 1
228
exterior door
interior door
window
wall opening
269
209
N
E
S
W

Fig. 2D

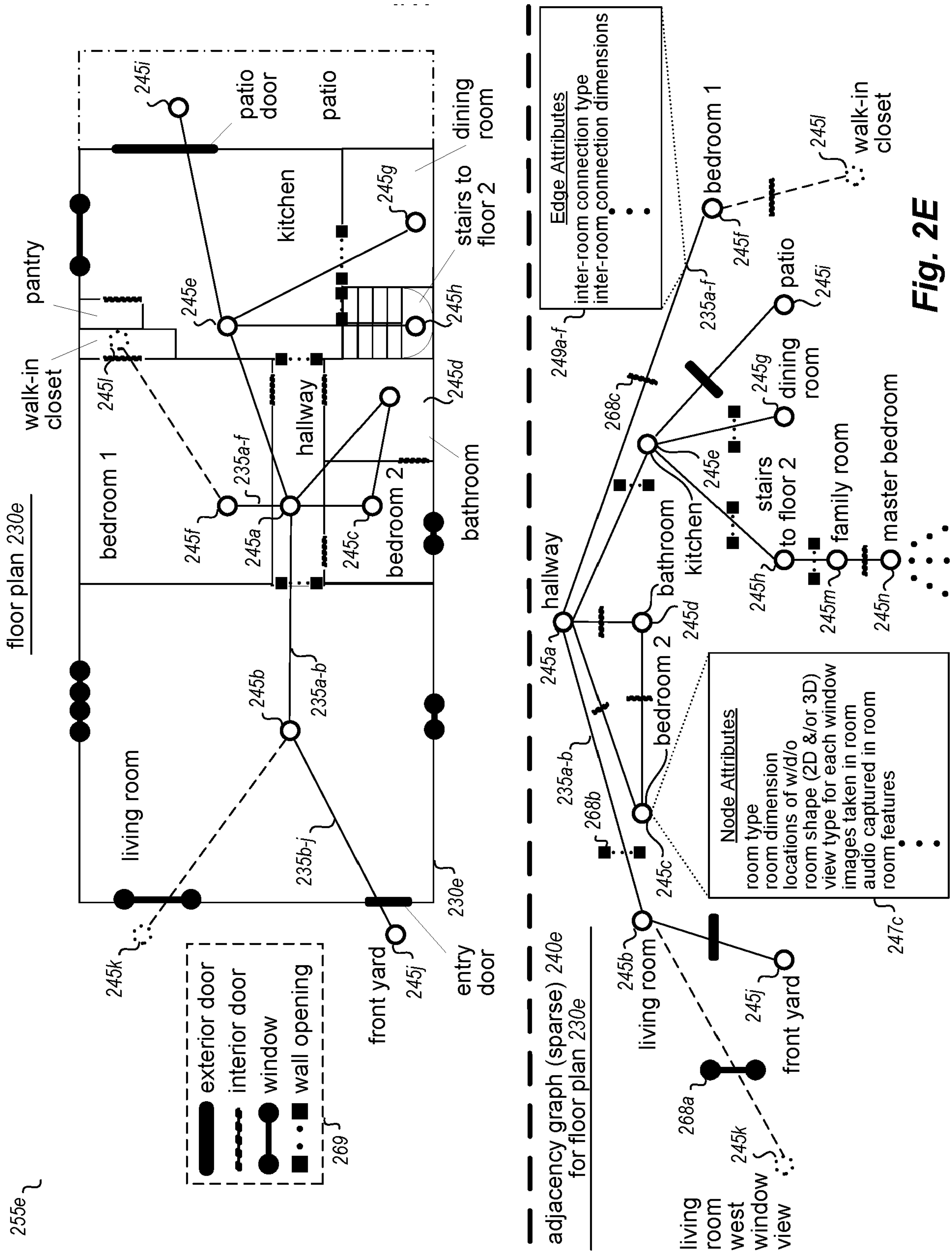

255e
floor plan 230e
pantry
walk-in closet
patio door
patio
kitchen
dining room
stairs to floor 2
hallway
bedroom 1
bedroom 2
bathroom
living room
front yard
entry door
245a
245b
245c
245d
245e
245f
245g
245h
245i
245j
245k
245l
235a-b
235a-f
235b-j
230e
exterior door
interior door
window
wall opening
269
adjacency graph (sparse) 240e for floor plan 230e
living room west window view
268a
268b
268c
245m
245n
family room
master bedroom
Node Attributes
room type
room dimension
locations of w/d/o
room shape (2D &/or 3D)
view type for each window
images taken in room
audio captured in room
room features
247c
Edge Attributes
inter-room connection type
inter-room connection dimensions
249a-f


Fig. 2E

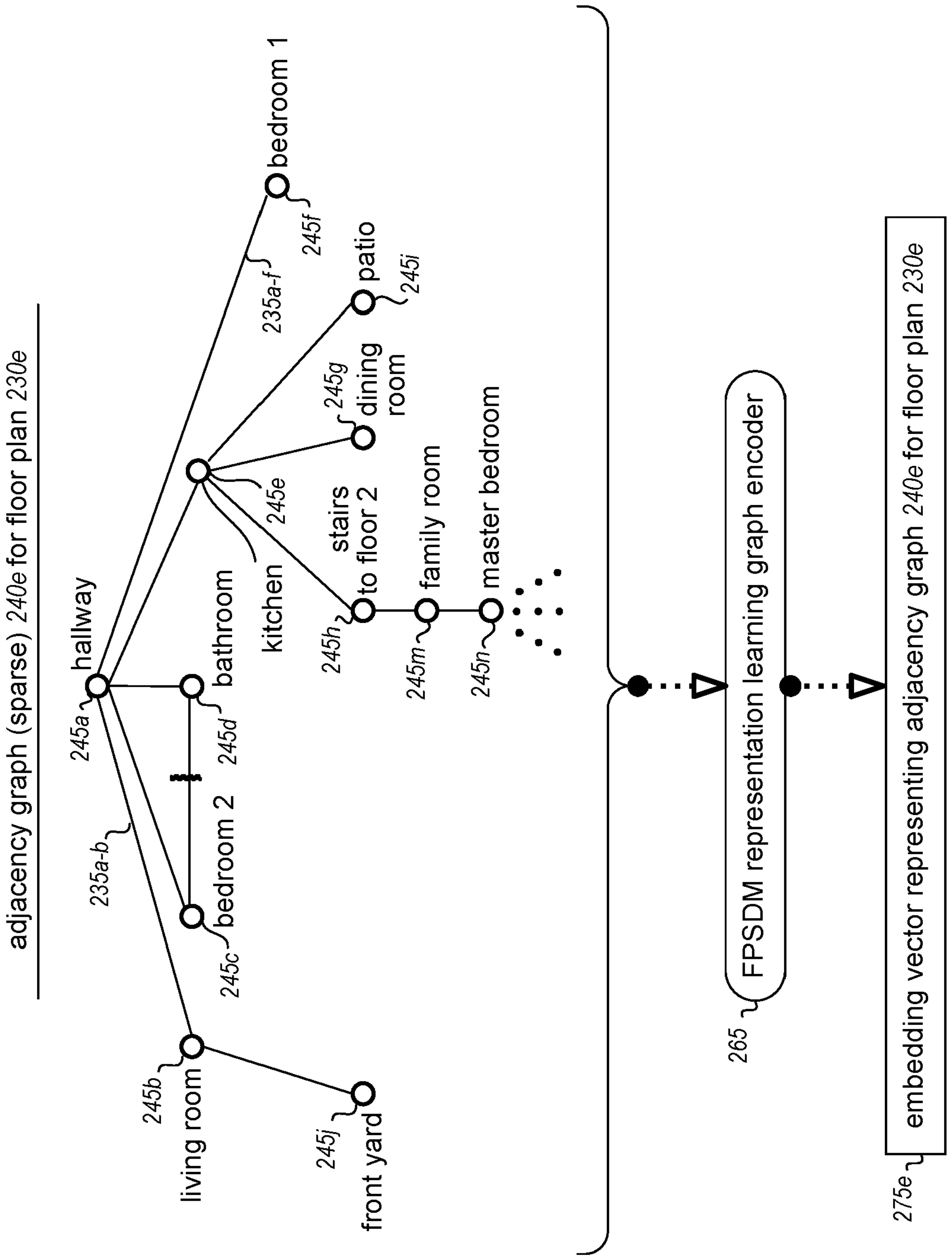
adjacency graph (sparse) 240e for floor plan 230e
hallway
245a
bathroom
245d
bedroom 2
245c
235a-b
living room
245b
front yard
245j
kitchen
245e
stairs to floor 2
245h
family room
245m
master bedroom
245n
dining room
245g
patio
245i
bedroom 1
245f
235a-f
FPSDM representation learning graph encoder
265
embedding vector representing adjacency graph 240e for floor plan 230e
275e

Fig. 2F

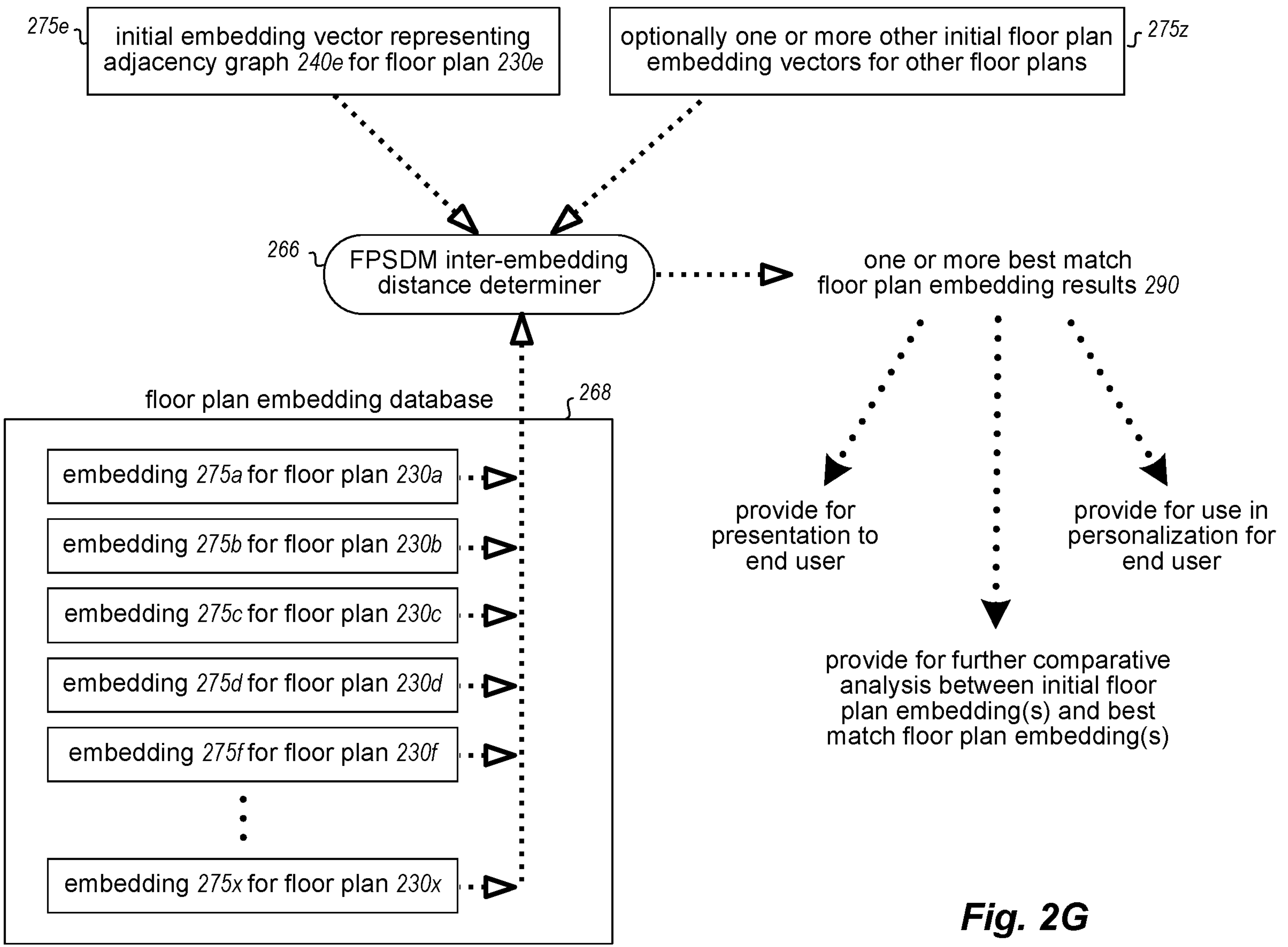
275e
initial embedding vector representing adjacency graph 240e for floor plan 230e
optionally one or more other initial floor plan embedding vectors for other floor plans
275z
266
FPSDM inter-embedding distance determiner
one or more best match floor plan embedding results 290
floor plan embedding database
268
embedding 275a for floor plan 230a
embedding 275b for floor plan 230b
embedding 275c for floor plan 230c
embedding 275d for floor plan 230d
embedding 275f for floor plan 230f
embedding 275x for floor plan 230x
provide for presentation to end user
provide for further comparative analysis between initial floor plan embedding(s) and best match floor plan embedding(s)
provide for use in personalization for end user

Fig. 2G

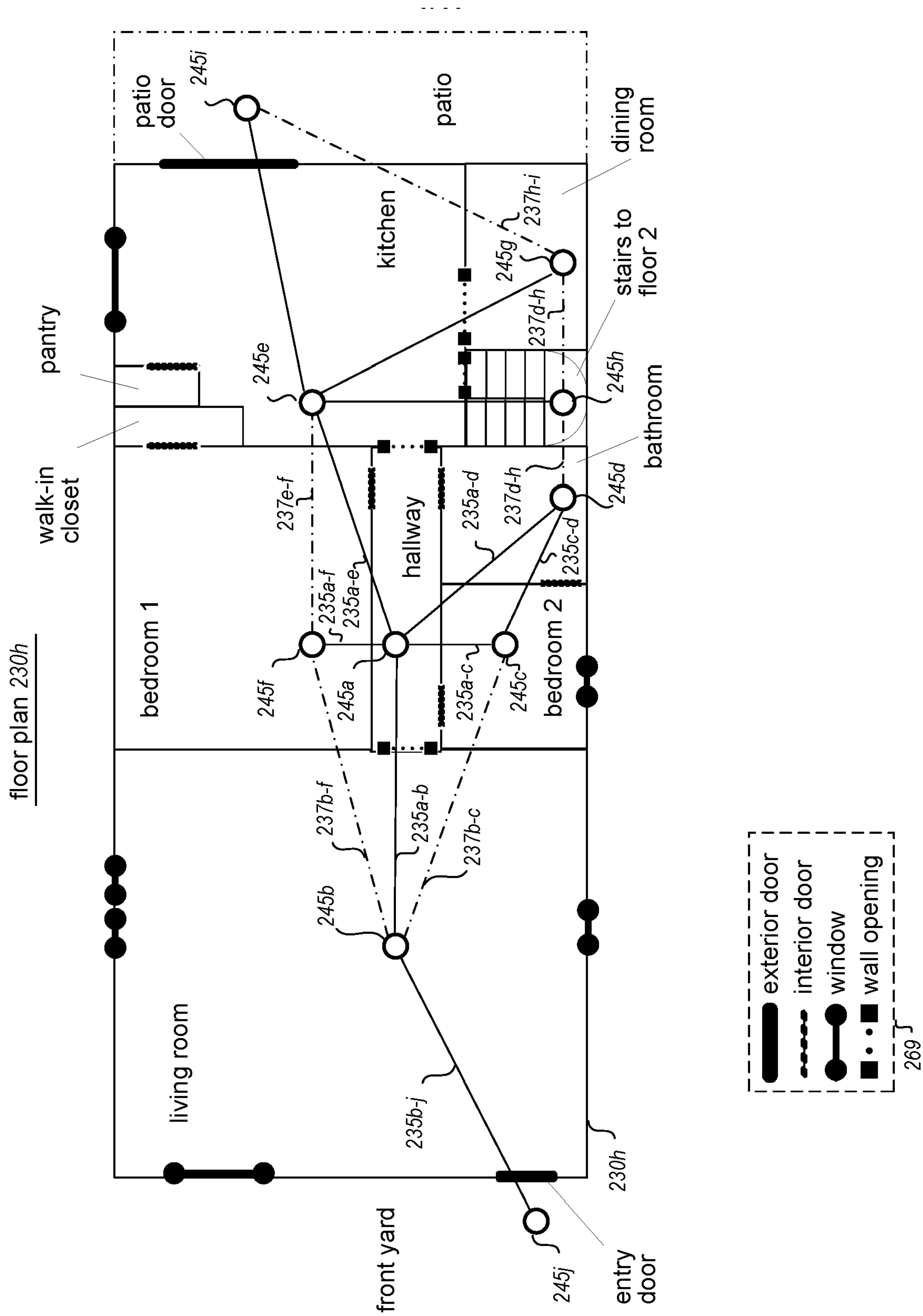
floor plan 230h
patio door
245i
patio
dining room
kitchen
pantry
walk-in closet
245e
245g
237h-i
stairs to floor 2
237d-h
245h
bathroom
245d
237d-h
235a-d
237e-f
hallway
235c-d
235a-f
235a-e
bedroom 1
bedroom 2
245f
245a
235a-c
245c
237b-f
235a-b
237b-c
245b
living room
235b-j
230h
front yard
245j
entry door
exterior door
interior door
window
wall opening
269

Fig. 2H

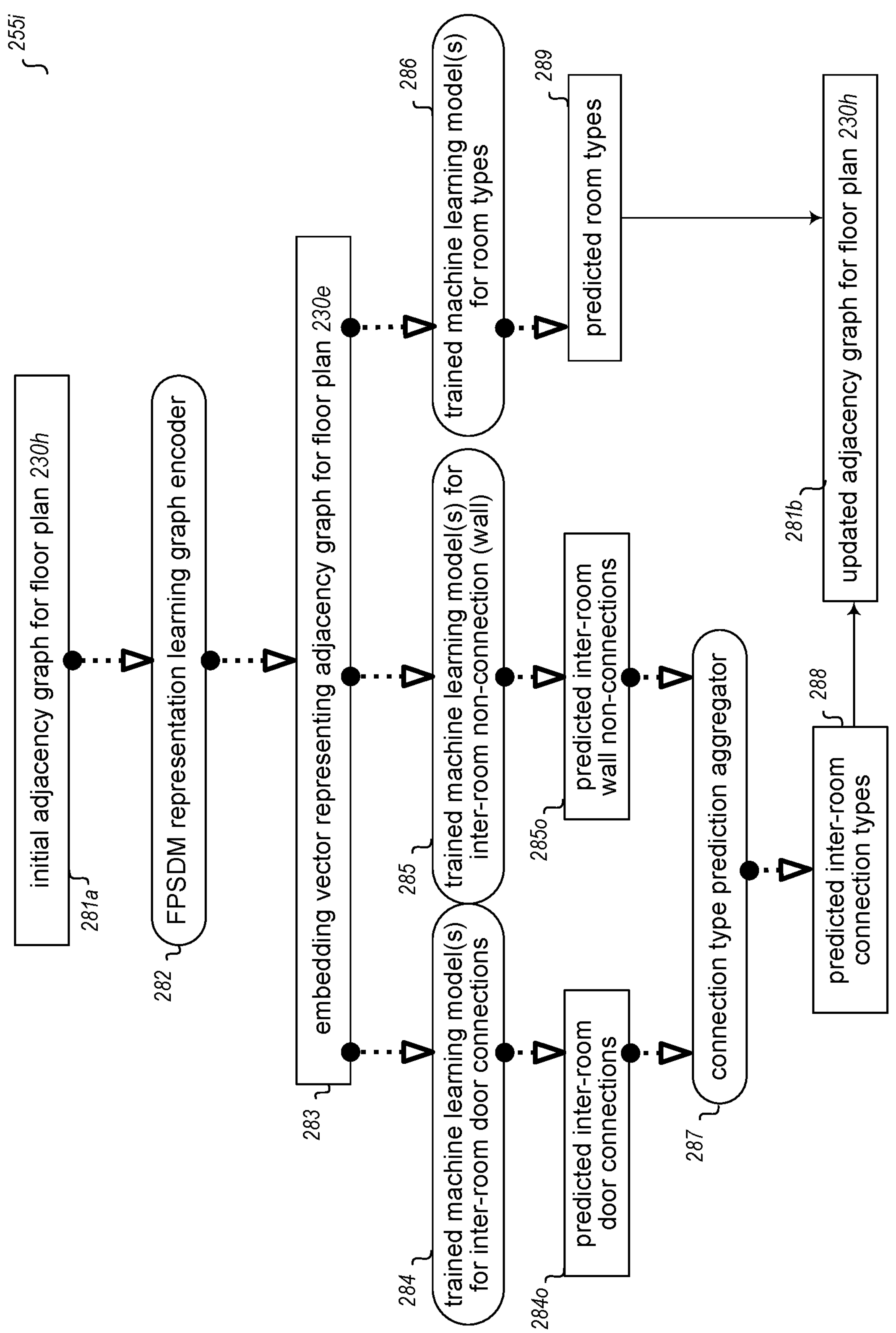
255i
initial adjacency graph for floor plan 230h
281a
FPSDM representation learning graph encoder
282
embedding vector representing adjacency graph for floor plan 230e
283
trained machine learning model(s) for inter-room door connections
284
trained machine learning model(s) for inter-room non-connection (wall)
285
trained machine learning model(s) for room types
286
predicted inter-room door connections
284o
predicted inter-room wall non-connections
285o
predicted room types
289
connection type prediction aggregator
287
predicted inter-room connection types
288
updated adjacency graph for floor plan 230h
281b

Fig. 2I

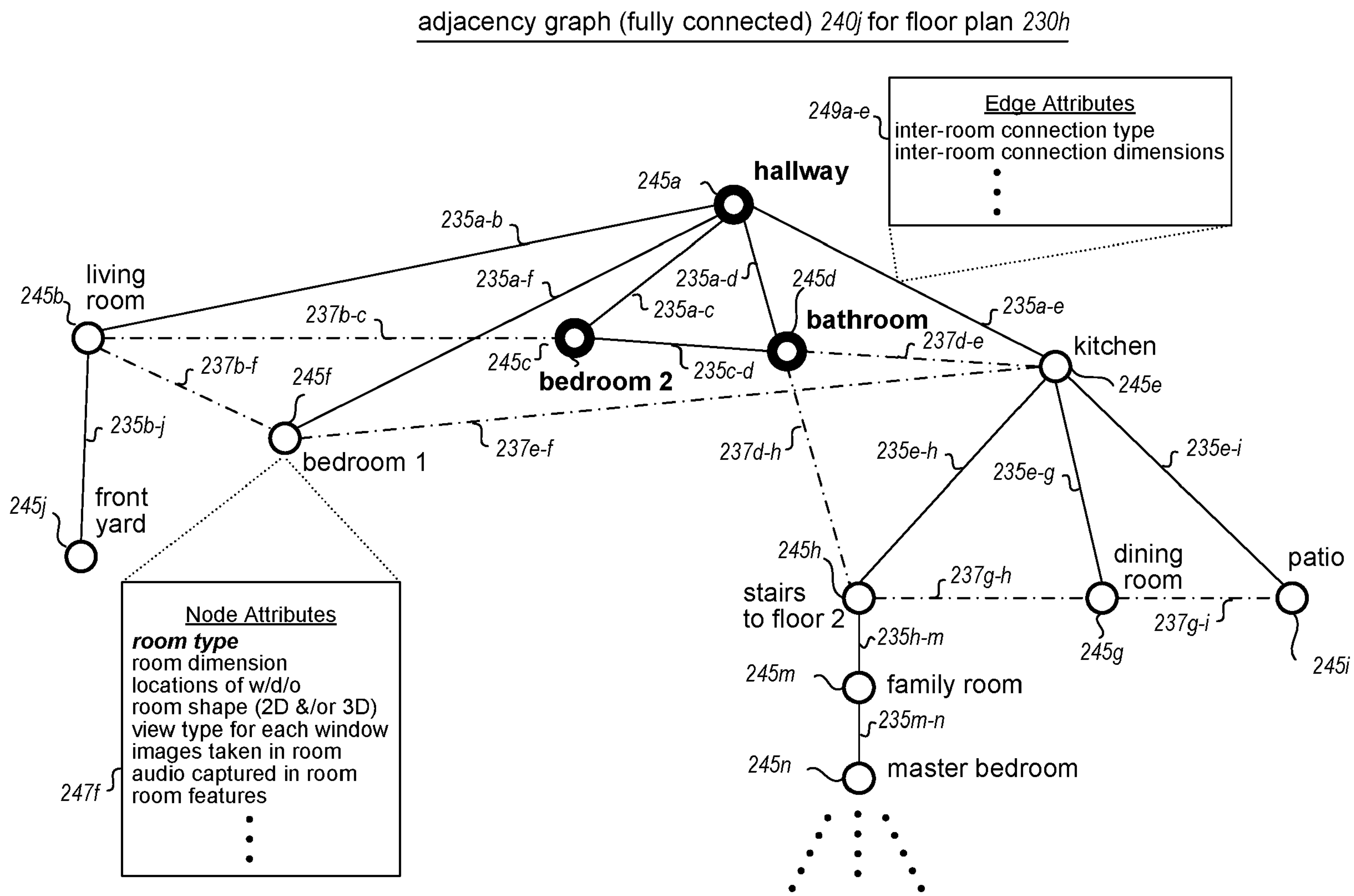
adjacency graph (fully connected) 240j for floor plan 230h
Edge Attributes
inter-room connection type
inter-room connection dimensions
249a-e
Node Attributes
room type
room dimension
locations of w/d/o
room shape (2D &/or 3D)
view type for each window
images taken in room
audio captured in room
room features
247f
hallway
245a
bathroom
245d
bedroom 2
245c
bedroom 1
245f
living room
245b
front yard
245j
kitchen
245e
dining room
245g
patio
245i
stairs to floor 2
245h
family room
245m
master bedroom
245n
235a-b
235a-f
235a-c
235a-d
235c-d
235a-e
235e-i
235e-g
235e-h
235h-m
235m-n
235b-j
237b-c
237b-f
237e-f
237d-h
237d-e
237g-h
237g-i

Fig. 2J

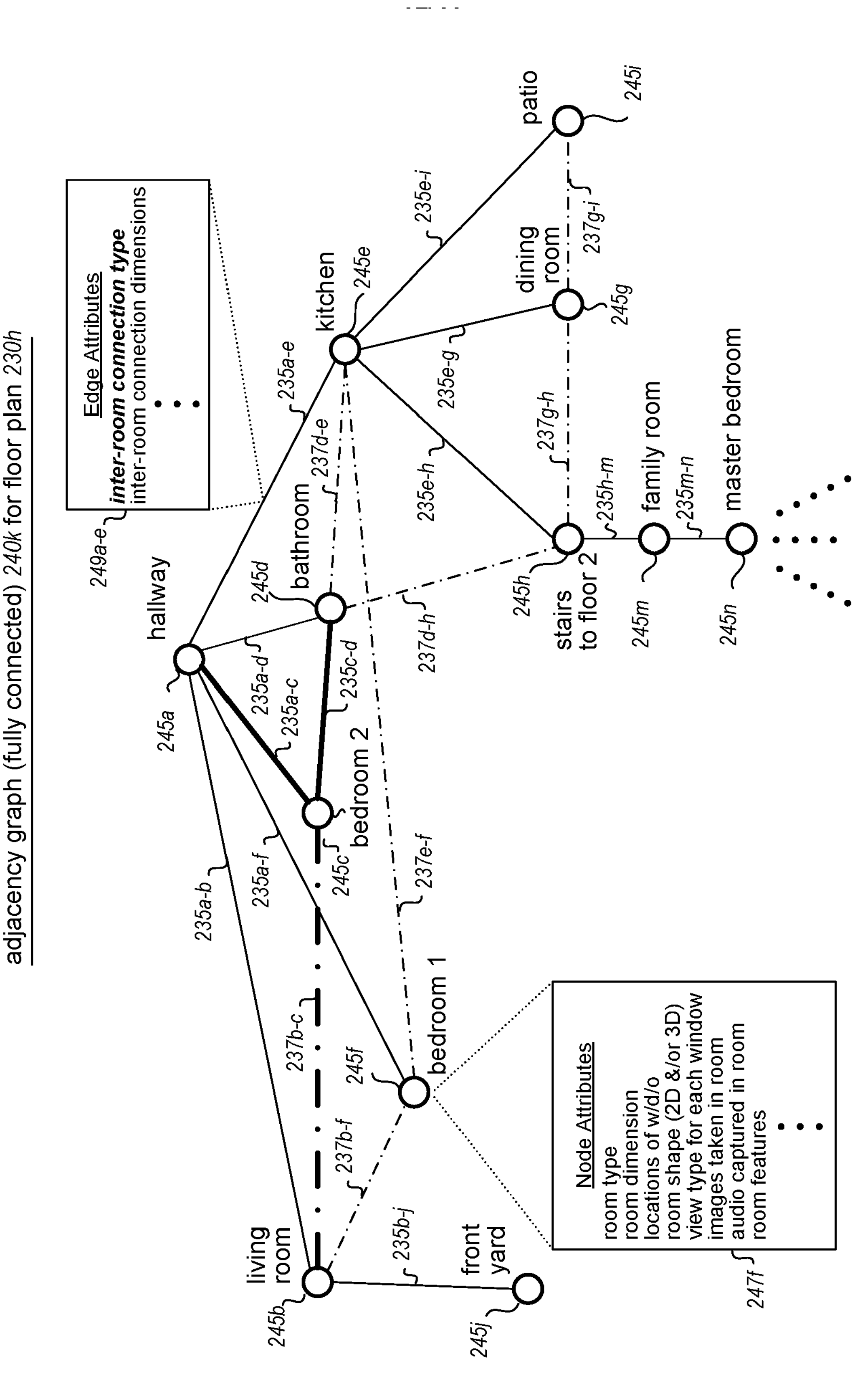
adjacency graph (fully connected) 240k for floor plan 230h
Edge Attributes
inter-room connection type
inter-room connection dimensions
249a-e
hallway
245a
kitchen
245e
patio
245i
dining room
245g
bathroom
245d
bedroom 2
245c
bedroom 1
245f
living room
245b
front yard
245j
stairs to floor 2
245h
family room
245m
master bedroom
245n
235a-e
235e-i
235e-g
235e-h
235a-d
235a-c
235c-d
235a-f
235a-b
235b-j
235h-m
235m-n
237d-e
237g-h
237g-i
237d-h
237e-f
237b-c
237b-f
Node Attributes
room type
room dimension
locations of w/d/o
room shape (2D &/or 3D)
view type for each window
images taken in room
audio captured in room
room features
247f

Fig. 2K

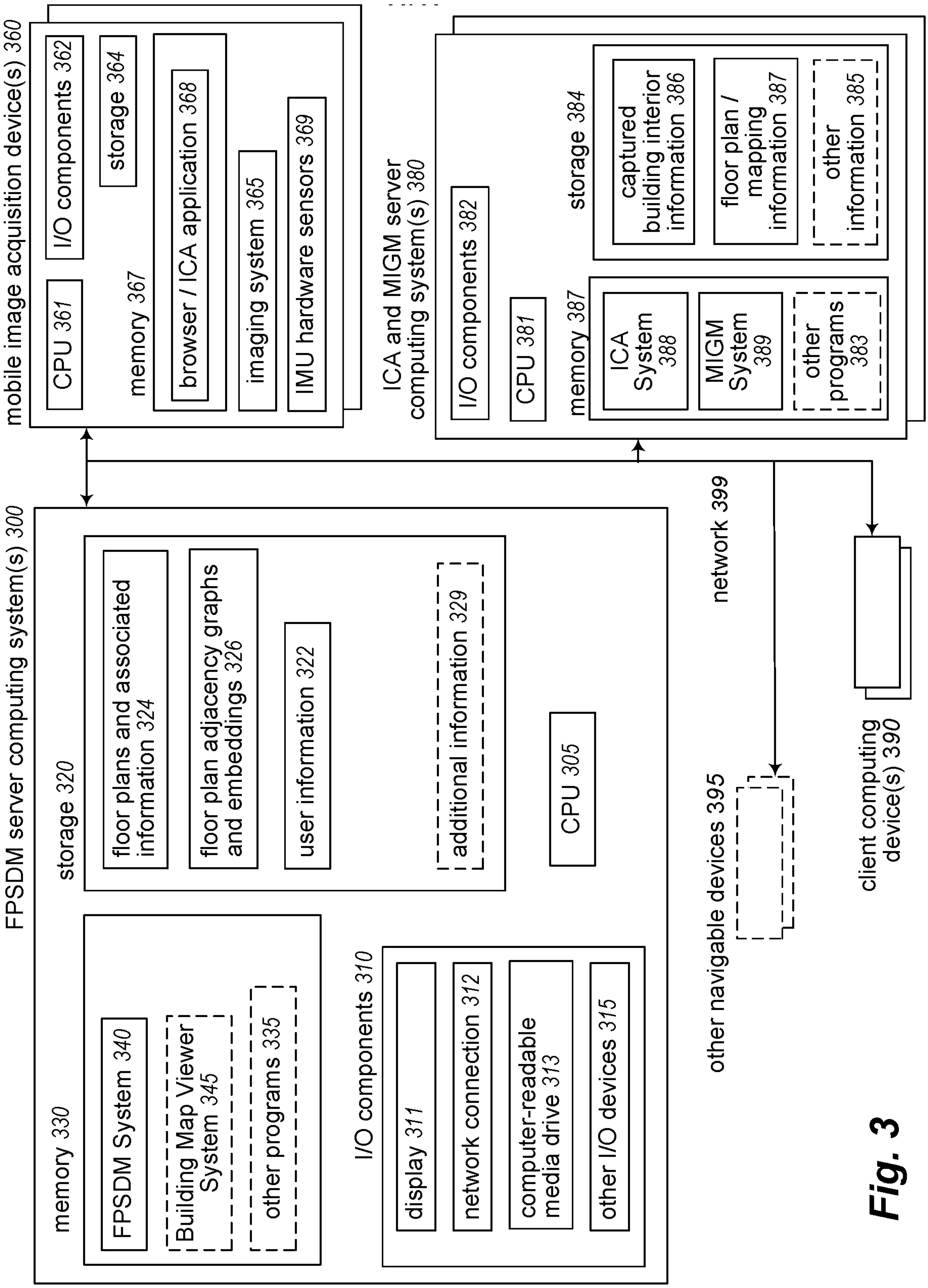

mobile image acquisition device(s) 360
CPU 361
I/O components 362
storage 364
memory 367
browser / ICA application 368
imaging system 365
IMU hardware sensors 369
ICA and MIGM server computing system(s) 380
I/O components 382
CPU 381
memory 387
ICA System 388
MIGM System 389
other programs 383
storage 384
captured building interior information 386
floor plan / mapping information 387
other information 385
FPSDM server computing system(s) 300
storage 320
floor plans and associated information 324
floor plan adjacency graphs and embeddings 326
user information 322
additional information 329
CPU 305
memory 330
FPSDM System 340
Building Map Viewer System 345
other programs 335
I/O components 310
display 311
network connection 312
computer-readable media drive 313
other I/O devices 315
network 399
other navigable devices 395
client computing device(s) 390


Fig. 3

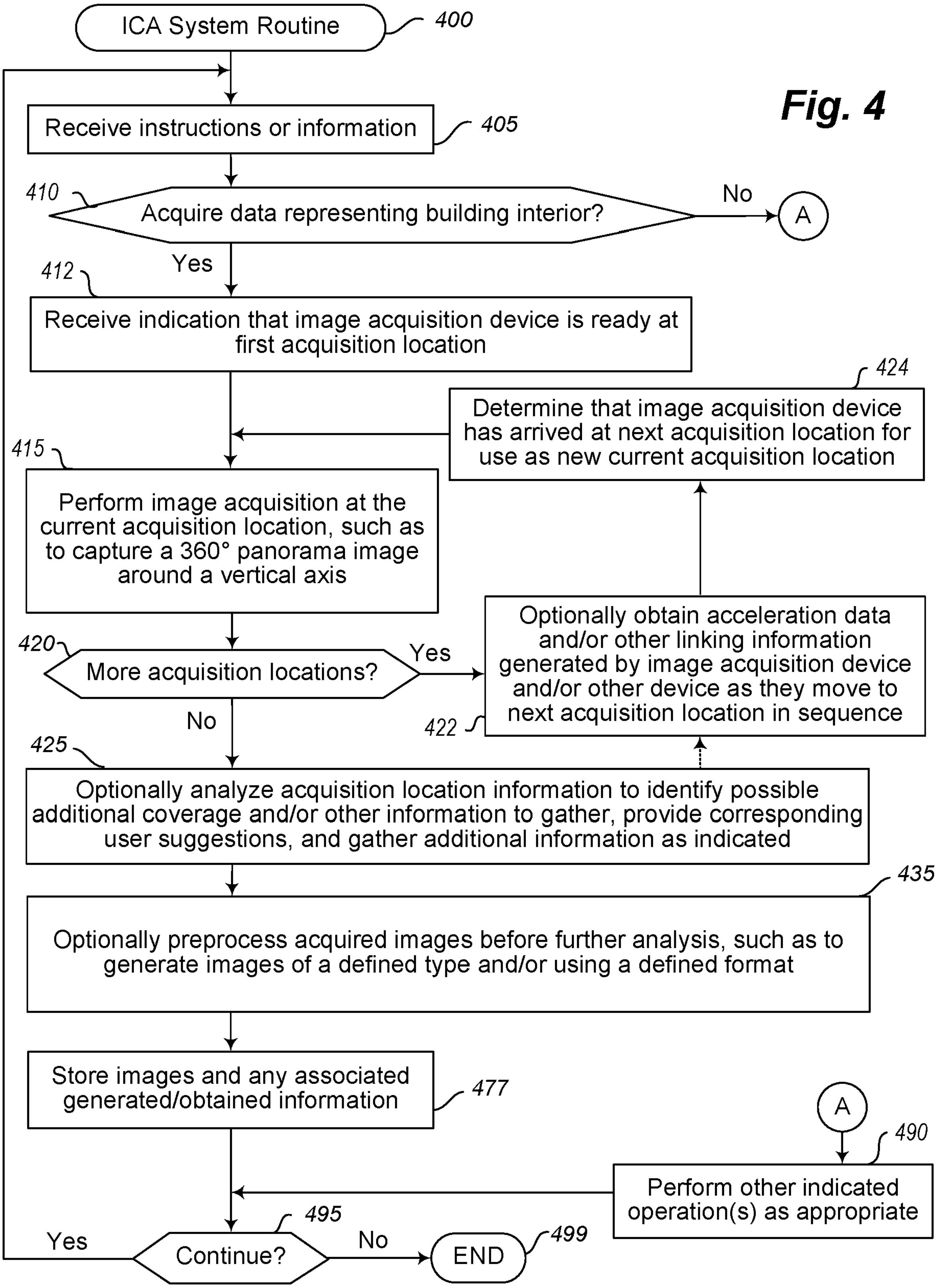
ICA System Routine
400
Receive instructions or information
405
410
Acquire data representing building interior?
No
A
Yes
412
Receive indication that image acquisition device is ready at first acquisition location
424
Determine that image acquisition device has arrived at next acquisition location for use as new current acquisition location
415
Perform image acquisition at the current acquisition location, such as to capture a 360° panorama image around a vertical axis
Optionally obtain acceleration data and/or other linking information generated by image acquisition device and/or other device as they move to next acquisition location in sequence
420
More acquisition locations?
Yes
No
422
425
Optionally analyze acquisition location information to identify possible additional coverage and/or other information to gather, provide corresponding user suggestions, and gather additional information as indicated
435
Optionally preprocess acquired images before further analysis, such as to generate images of a defined type and/or using a defined format
Store images and any associated generated/obtained information
477
A
490
Perform other indicated operation(s) as appropriate
495
Yes
Continue?
No
END
499

Fig. 4

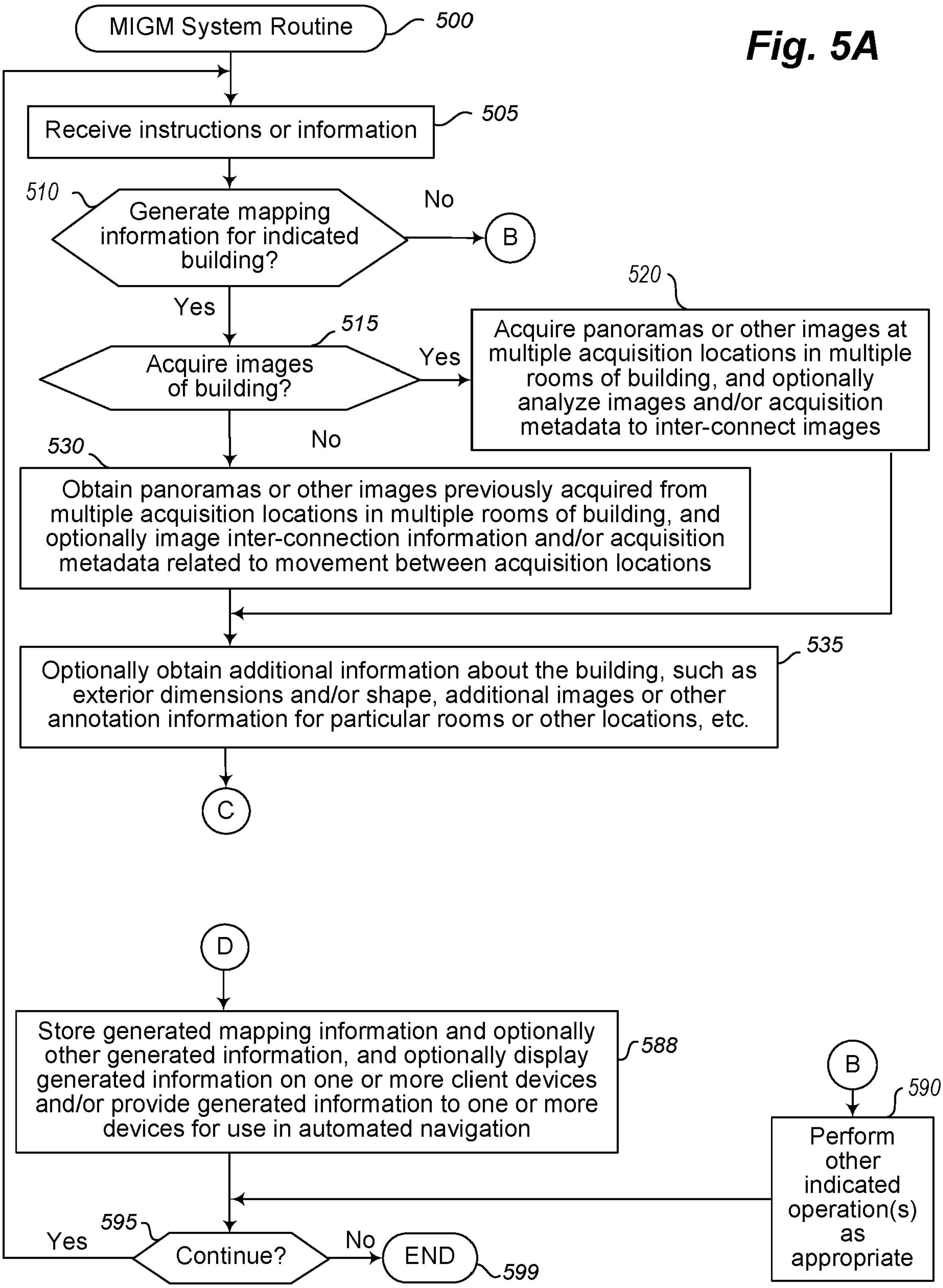
MIGM System Routine
500
Receive instructions or information
505
510
Generate mapping information for indicated building?
No
B
Yes
515
Acquire images of building?
Yes
520
Acquire panoramas or other images at multiple acquisition locations in multiple rooms of building, and optionally analyze images and/or acquisition metadata to inter-connect images
No
530
Obtain panoramas or other images previously acquired from multiple acquisition locations in multiple rooms of building, and optionally image inter-connection information and/or acquisition metadata related to movement between acquisition locations
535
Optionally obtain additional information about the building, such as exterior dimensions and/or shape, additional images or other annotation information for particular rooms or other locations, etc.
C
D
Store generated mapping information and optionally other generated information, and optionally display generated information on one or more client devices and/or provide generated information to one or more devices for use in automated navigation
588
B
590
Perform other indicated operation(s) as appropriate
595
Yes
Continue?
No
END
599

Fig. 5A

Fig. 5B

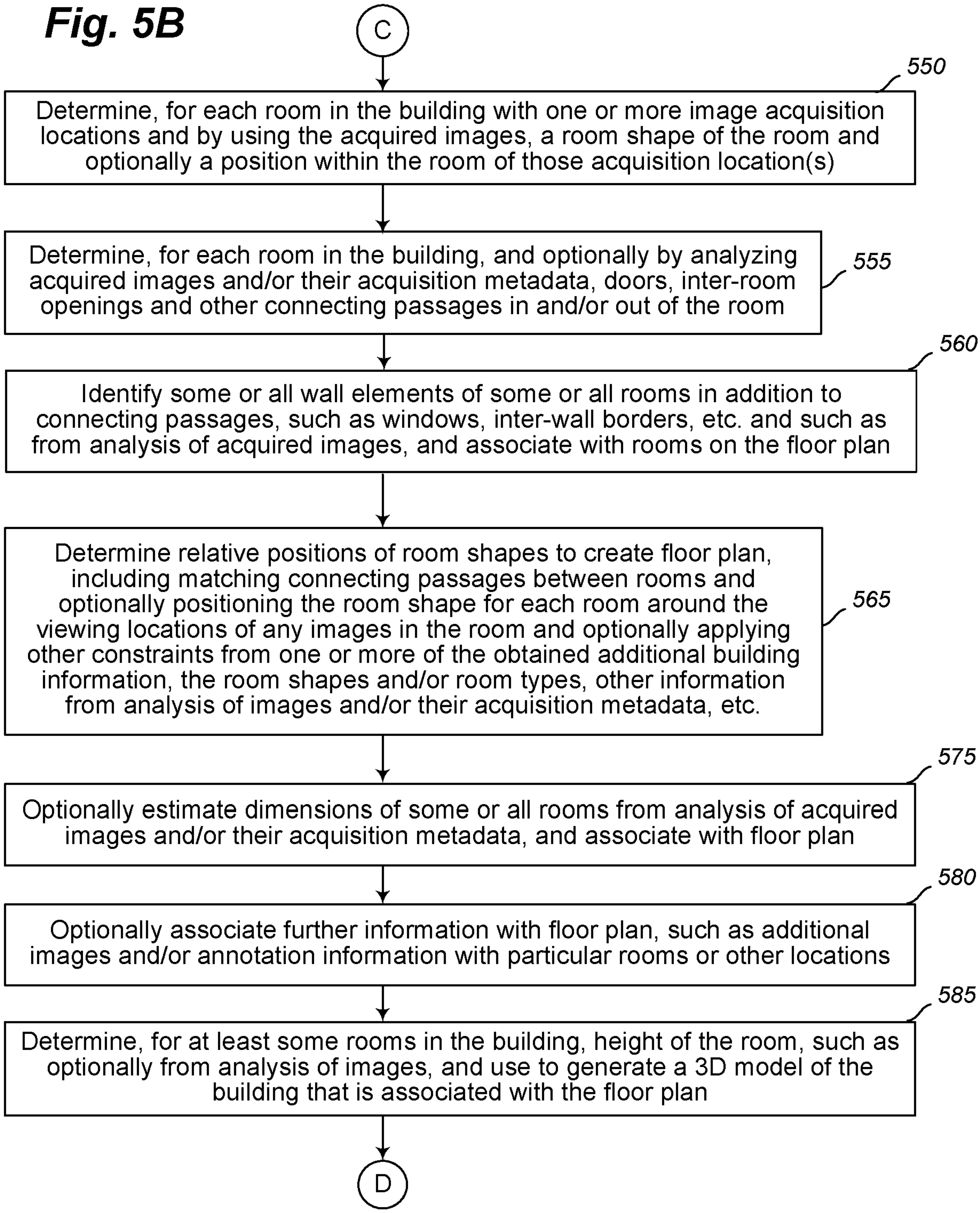
C
550
Determine, for each room in the building with one or more image acquisition locations and by using the acquired images, a room shape of the room and optionally a position within the room of those acquisition location(s)
555
Determine, for each room in the building, and optionally by analyzing acquired images and/or their acquisition metadata, doors, inter-room openings and other connecting passages in and/or out of the room
560
Identify some or all wall elements of some or all rooms in addition to connecting passages, such as windows, inter-wall borders, etc. and such as from analysis of acquired images, and associate with rooms on the floor plan
565
Determine relative positions of room shapes to create floor plan, including matching connecting passages between rooms and optionally positioning the room shape for each room around the viewing locations of any images in the room and optionally applying other constraints from one or more of the obtained additional building information, the room shapes and/or room types, other information from analysis of images and/or their acquisition metadata, etc.
575
Optionally estimate dimensions of some or all rooms from analysis of acquired images and/or their acquisition metadata, and associate with floor plan
580
Optionally associate further information with floor plan, such as additional images and/or annotation information with particular rooms or other locations
585
Determine, for at least some rooms in the building, height of the room, such as optionally from analysis of images, and use to generate a 3D model of the building that is associated with the floor plan
D

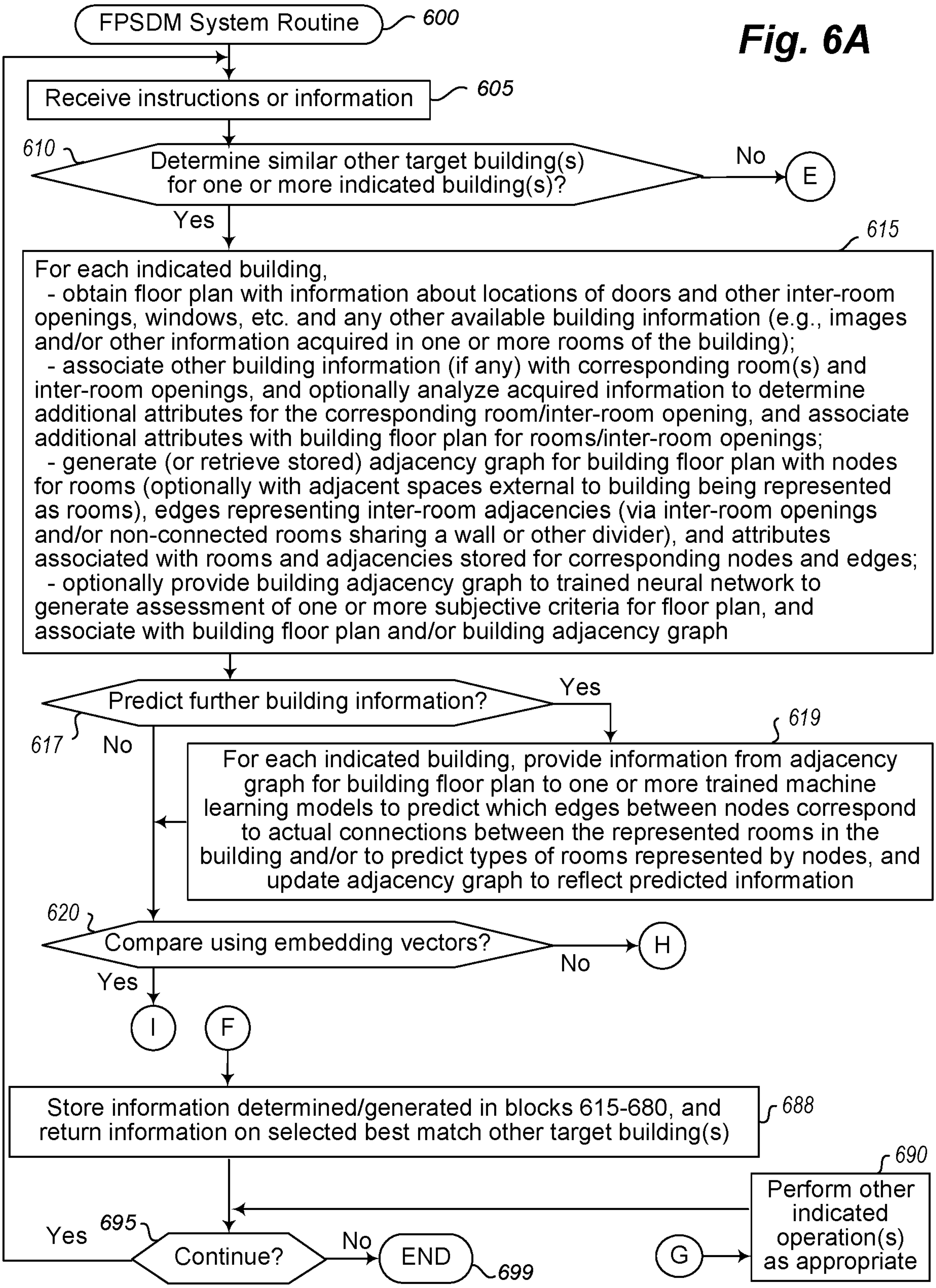
FPSDM System Routine
600
Fig. 6A
Receive instructions or information
605
610
Determine similar other target building(s) for one or more indicated building(s)?
No
E
Yes
615
For each indicated building,
- obtain floor plan with information about locations of doors and other inter-room openings, windows, etc. and any other available building information (e.g., images and/or other information acquired in one or more rooms of the building);
- associate other building information (if any) with corresponding room(s) and inter-room openings, and optionally analyze acquired information to determine additional attributes for the corresponding room/inter-room opening, and associate additional attributes with building floor plan for rooms/inter-room openings;
- generate (or retrieve stored) adjacency graph for building floor plan with nodes for rooms (optionally with adjacent spaces external to building being represented as rooms), edges representing inter-room adjacencies (via inter-room openings and/or non-connected rooms sharing a wall or other divider), and attributes associated with rooms and adjacencies stored for corresponding nodes and edges;
- optionally provide building adjacency graph to trained neural network to generate assessment of one or more subjective criteria for floor plan, and associate with building floor plan and/or building adjacency graph
Predict further building information?
Yes
617
No
619
For each indicated building, provide information from adjacency graph for building floor plan to one or more trained machine learning models to predict which edges between nodes correspond to actual connections between the represented rooms in the building and/or to predict types of rooms represented by nodes, and update adjacency graph to reflect predicted information
620
Compare using embedding vectors?
No
H
Yes
I
F
Store information determined/generated in blocks 615-680, and return information on selected best match other target building(s)
688
690
Perform other indicated operation(s) as appropriate
Yes
695
Continue?
No
END
699
G

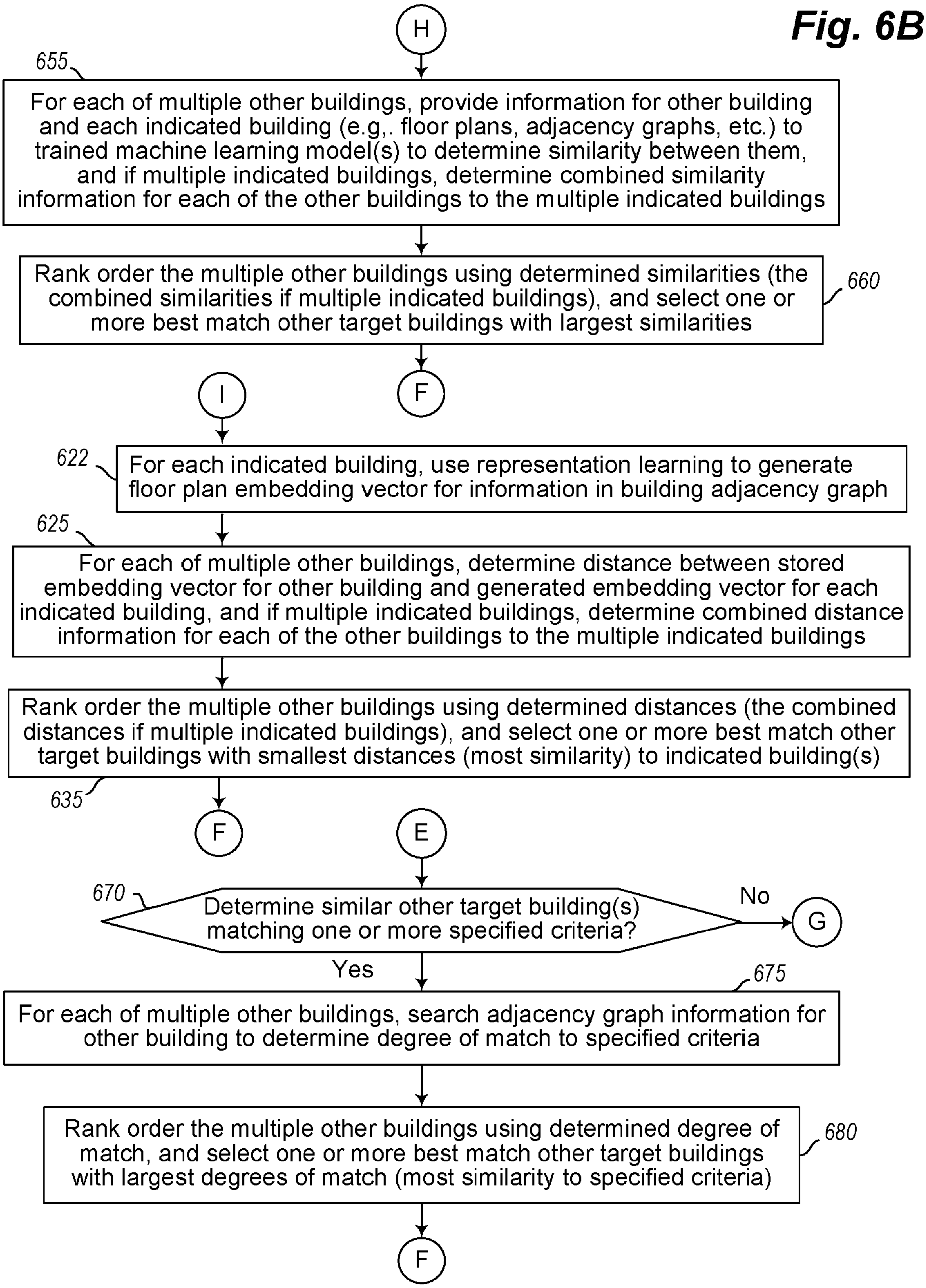
Fig. 6B
H
655
For each of multiple other buildings, provide information for other building and each indicated building (e.g,. floor plans, adjacency graphs, etc.) to trained machine learning model(s) to determine similarity between them, and if multiple indicated buildings, determine combined similarity information for each of the other buildings to the multiple indicated buildings
Rank order the multiple other buildings using determined similarities (the combined similarities if multiple indicated buildings), and select one or more best match other target buildings with largest similarities
660
I
F
622
For each indicated building, use representation learning to generate floor plan embedding vector for information in building adjacency graph
625
For each of multiple other buildings, determine distance between stored embedding vector for other building and generated embedding vector for each indicated building, and if multiple indicated buildings, determine combined distance information for each of the other buildings to the multiple indicated buildings
Rank order the multiple other buildings using determined distances (the combined distances if multiple indicated buildings), and select one or more best match other target buildings with smallest distances (most similarity) to indicated building(s)
635
F
E
670
Determine similar other target building(s) matching one or more specified criteria?
No
G
Yes
675
For each of multiple other buildings, search adjacency graph information for other building to determine degree of match to specified criteria
Rank order the multiple other buildings using determined degree of match, and select one or more best match other target buildings with largest degrees of match (most similarity to specified criteria)
680
F

Fig. 7

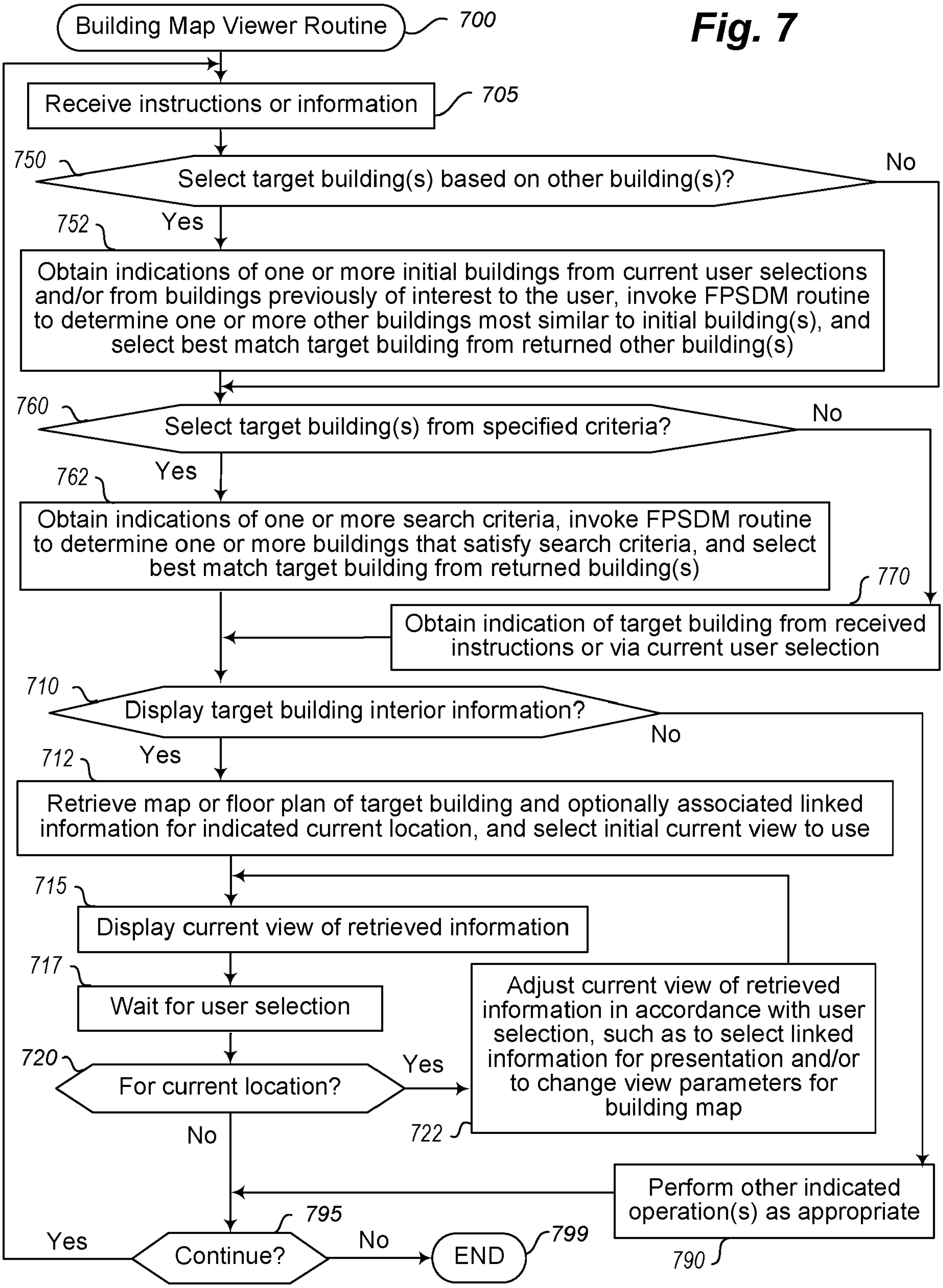
Building Map Viewer Routine
700
Receive instructions or information
705
750
Select target building(s) based on other building(s)?
No
752
Yes
Obtain indications of one or more initial buildings from current user selections and/or from buildings previously of interest to the user, invoke FPSDM routine to determine one or more other buildings most similar to initial building(s), and select best match target building from returned other building(s)
760
Select target building(s) from specified criteria?
No
762
Yes
Obtain indications of one or more search criteria, invoke FPSDM routine to determine one or more buildings that satisfy search criteria, and select best match target building from returned building(s)
770
Obtain indication of target building from received instructions or via current user selection
710
Display target building interior information?
No
712
Yes
Retrieve map or floor plan of target building and optionally associated linked information for indicated current location, and select initial current view to use
715
Display current view of retrieved information
717
Wait for user selection
Adjust current view of retrieved information in accordance with user selection, such as to select linked information for presentation and/or to change view parameters for building map
720
For current location?
Yes
No
722
Perform other indicated operation(s) as appropriate
790
795
Yes
Continue?
No
END
799

Europäisches Patentamt
European Patent Office
Office européen des brevets

# EUROPEAN SEARCH REPORT

Application Number
EP 21 19 7503

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/266293 A1 (ISHIDA YOTA [JP] ET AL) 29 August 2019 (2019-08-29)<br>* paragraph [0060] - paragraph [0061] *<br>* paragraph [0064] *<br>* paragraph [0070] *<br>* paragraph [0081] *<br>* paragraph [0101] *<br>----- | 1-15 | INV.<br>G06F30/13<br>G06F30/27<br>G06Q30/02<br>G06Q50/16 |
| X | US 2019/147115 A1 (LIU SU [US] ET AL) 16 May 2019 (2019-05-16)<br>* paragraph [0049] *<br>* paragraph [0051] *<br>* paragraph [0053] *<br>* paragraph [0057] *<br>* paragraph [0062] *<br>* paragraph [0066] *<br>----- | 1-15 | |

TECHNICAL FIELDS SEARCHED (IPC)
G06F
G06Q

1 The present search report has been drawn up for all claims

| Place of search | Date of completion of the search | Examiner |
|---|---|---|
| Munich | 8 February 2022 | Sohrt, Wolfgang |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 21 19 7503

This annex lists the patent family members relating to the patent documents cited in the above-mentioned European search report. The members are as contained in the European Patent Office EDP file on
The European Patent Office is in no way liable for these particulars which are merely given for the purpose of information.

08-02-2022

| Patent document cited in search report | Publication date | Patent family member(s) | Publication date |
|---|---|---|---|
| US 2019266293 A1 | 29-08-2019 | AU 2017362937 A1 | 16-05-2019 |
| | | EP 3543960 A1 | 25-09-2019 |
| | | JP 6116746 B1 | 19-04-2017 |
| | | JP 2018081548 A | 24-05-2018 |
| | | TW 201819726 A | 01-06-2018 |
| | | US 2019266293 A1 | 29-08-2019 |
| | | WO 2018092382 A1 | 24-05-2018 |
| US 2019147115 A1 | 16-05-2019 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 69328619
- US 23618718
- US 19016218
- US 68178719
- US 84158120
- US 62927032
- US 80713520
- US 01332320

### Non-patent literature cited in the description


- Symmetric Graph Convolution Autoencoder For Unsupervised Graph Representation Learning. *International Conference On Computer Vision,* 07 August 2019
- Inductive Representation Learning On Large Graphs. *31st Conference On Neural Information Processing Systems,* 07 June 2017
- **THOMAS N. KIPF et al.** Variational Graph Auto-Encoders. *30th Conference On Neural Information Processing Systems,* 21 November 2016
- **S.V.N. VISHWANATHAN et al.** Graph Kernels. *Journal of Machine Learning Research,* 2010, vol. 11, 1201-1242
- **NILS M. KRIEGE et al.** A Survey On Graph Kernels. *arXiv:1903.11835,* 2019
- **JOAN BRUNA et al.** Spectral Networks And Locally Connected Networks On Graphs. *International Conference on Learning Representations,* 2014
- **MICHAEL DEFFERRARD et al.** Convolutional Neural Networks On Graphs With Fast Localized Spectral Filtering. *Proceedings of Neural Information Processing Systems,* 2016, 3844-3852
- **THOMAS N. KIPF et al.** Semi-Supervised Classification With Graph Convolutional Networks. *International Conference on Learning Representations,* 2017
- **WILL HAMILTON et al.** Inductive Representation Learning On Large Graphs. *Proceedings of Neural Information Processing Systems,* 2017, vol. 2017, 1024-1034
- **P. VELICKOVIC et al.** Graph Attention Networks. *International Conference on Learning Representations,* 2018
- **JIANI ZHANG et al.** GaAN: Gated Attention Networks For Learning On Large And Spatiotemporal Graphs. *Proceedings of Uncertainty in Artificial Intelligence,* 2018